# EUROPÄISCHE PATENTANMELDUNG

(11) **EP 4 636 510 A1**
(43) Veröffentlichungstag der Anmeldung: **22.10.2025**
(21) Anmeldenummer: 24171067.2
(22) Anmeldetag: 18.04.2024
(51) Int. Cl.: G05B 13/02, G05B 19/408, G05B 19/418, G06N 3/08, H05K 3/00

(54) **VERFAHREN ZUM EINRICHTEN EINER PRODUKTIONSEINRICHTUNG UND PRODUKTIONSSYSTEM**

(71) Anmelder: Siemens Aktiengesellschaft, 80333 München (DE)
(72) Erfinder: Die Erfindernennung liegt noch nicht vor
(74) Vertreter: Siemens Patent Attorneys

(57) **Zusammenfassung**

Die vorliegende Erfindung betrifft ein Verfahren zum Einrichten einer Produktionseinrichtung (110, 120), wobei ein Einstellparametersatz (620) für die Herstellung eines Produkts durch die Produktionseinrichtung (110, 120) und ein Messparametersatz (610) bezüglich des durch die Produktionseinrichtung (110, 120) unter Verwendung des Einstellparametersatzes (620) hergestellten Produkts und/oder bezüglich der Herstellung dieses Produkts vorliegt,
dadurch gekennzeichnet,
dass das Verfahren die nachfolgenden Prozessschritte umfasst:
a.) Trainieren eines ML-Modells (220, 320) unter Verwendung von Trainingsdaten umfassend den Einstellparametersatz (620) und/oder den Messparametersatz (610),
b.) Automatisiertes oder teilautomatisiertes Ermitteln eines weiteren Einstellparametersatzes (620) für die Produktionseinrichtung (110, 120) unter Verwendung des ML-Modells (220, 320).

## Beschreibung

Verfahren zum Einrichten einer Produktionseinrichtung, wobei ein Einstellparametersatz für die Herstellung eines Produkts durch die Produktionseinrichtung und ein Messparametersatz bezüglich des durch die Produktionseinrichtung unter Verwendung des Einstellparametersatzes hergestellten Produkts und/oder bezüglich der Herstellung dieses Produkts vorliegt.

Derartige Systeme sind aus dem Stand der Technik bekannt.

So offenbart beispielsweise das US-Patent US 7,171,897 B2 ein System und Verfahren zur Implementierung einer hybriden Regelung. Das beschriebene Regelungssystem wird auf einen Schablonendruckprozess zum Auftragen von Lotpaste auf ein elektronisches Medium wie eine Leiterplatte oder einen Halbleiterwafer angewendet. Dabei wird ein erster, grober Algorithmus verwendet, um schnell den Wert eines Schablonendrucker-Steuerungswertes zu erzeugen, der zu einer Lotpastendeposition mit einem Volumen innerhalb vorbestimmter akzeptabler Grenzen führt. Danach wird ein zweiter, feinerer Schätzer zur Feinabstimmung des Prozesses verwendet.

Es ist ein Nachteil des genannten Standes der Technik, dass die bekannten Verfahren komplex in der Implementierung sind und einen hohen Bedarf an genauen und zuverlässigen Messdaten benötigen. Weiterhin können die bekannten Verfahren durchaus eine hohe Empfindlichkeit des Regelalgorithmus gegenüber Schwankungen der Prozessbedingungen haben. Darüber hinaus können durchaus hohe Rechenanforderungen vorliegen, die eine Anwendung im Rahmen einer vorgegebenen Produktionsumgebung nicht unbedingt erfüllt sind.

Daher ist es eine Aufgabe der vorliegenden Erfindung, ein Verfahren und/oder System zur Verfügung zu stellen, mit welchem eine Produktionseinrichtung für die Herstellung eines Produkts einfacher, zuverlässiger, schneller und/oder leichter einzurichten ist.

Diese Aufgabe wird gelöst durch ein System mit den Merkmalen des Patentanspruchs 1.

Ein solches Verfahren ist zum Einrichten einer Produktionseinrichtung ausgebildet und eingerichtet, wobei ein Einstellparametersatz für die Herstellung eines Produkts durch die Produktionseinrichtung und ein Messparametersatz bezüglich des durch die Produktionseinrichtung unter Verwendung des Einstellparametersatzes hergestellten Produkts und/oder bezüglich der Herstellung dieses Produkts vorliegt.

Dabei umfasst das Verfahren die nachfolgenden Prozessschritte:
a.) Trainieren eines ML-Modells unter Verwendung von Trainingsdaten umfassend den Einstellparametersatz und/oder den Messparametersatz,
b.) Automatisiertes oder teilautomatisieres Ermitteln eines weiteren Einstellparametersatzes für die Produktionseinrichtung unter Verwendung des ML-Modells.

Die vorliegende Erfindung betrifft ein Verfahren zur Optimierung der Herstellung eines Produkts mittels einer Produktionseinrichtung durch die Anwendung von maschinellem Lernen. Das Verfahren umfasst das Trainieren eines maschinellen Lernmodells (ML-Modell) unter Verwendung von Trainingsdaten, die Einstell- und/oder Messparametersätze umfassen, und die automatisierte oder teilautomatisierte Ermittlung von weiteren Einstellparametersätzen für die Produktionseinrichtung basierend auf dem ML-Modell.

Dabei betrifft die Erfindung insbesondere einen zielgerichteten Aufbau von Trainingsdaten, um einen bestimmten Herstellungsprozess einzurichten und/oder zu verbessern oder optimieren.

Dabei ist es beispielsweise ein mögliches weiteres Ziel, einen für die Herstellung vorgegebenen oder vorgebbaren Optimierungsparameter, wie z.B. eine Produktionszeit, eine Produktqualität, einen Materialverbrauch und/oder einen Energieverbrauch, zu optimieren, indem das ML-Modell kontinuierlich mit realen Prozessdaten trainiert wird, um verbesserte - im besten Fall optimale - Prozessparameter zu finden.

Innovative Aspekte dieser Erfindung liegen beispielsweise in der Anwendung von maschinellem Lernen, beispielsweise einem Trainings- und/oder Inferenz-Verfahren für sogenannte "Self-Organizing Maps" (SOM), oder auch der Verwendung von sogenannten "modifizierten Self-Organizing Maps" (mod-SOM), um den Produkt-Herstellungsprozess zu optimieren.

Dabei ermöglicht die vorliegende Erfindung beispielsweise eine schnellere und präzisere Einstellung der Einstellparameter, reduziert den manuellen Aufwand, und verkürzt die Testphase, was beispielsweise unter anderem zu geringeren Ausschussraten, schnelleren Einricht-Zeiten der Produktionseinrichtung und/oder einer höheren Produktionskapazität führt oder führen kann.

So bietet beispielsweise eine Anwendung dieser Erfindung auf den Lotpastendruck und/oder im Rahmen von Lötprozessen in der Elektronikfertigung oder auch in Spritzguss- oder Druckguss-Verfahren deutliche Vorteile, da sie die Effizienz des Herstellungsprozesses verbessert und die Produktqualität erhöht.

Darüber hinaus kann das Verfahren sowohl on-premise als auch cloudbasiert betrieben werden, was Flexibilität und Skalierbarkeit in verschiedenen Fertigungsumgebungen ermöglicht.

Das Verfahren zum Einrichten einer Produktionseinrichtung kann dabei beispielsweise als ein computerimplementiertes Verfahren ausgebildet und eingerichtet sein. Dabei können insbesondere die Verfahrensschritte a.) und b.) als computerimplementierte Verfahrensschritte ausgebildet und eingerichtet sein. Verfahrensschritt b.) kann beispielsweise auch teilweise computerimplementiert sein - beispielsweise im Rahmen eines teilautomatisierten Ermittelns eines weiteren Einstellparametersatzes.

Dabei kann beispielsweise das Trainieren des ML-Modells, beispielsweise gemäß Verfahrensschritt a.), auf einer Steuereinrichtung für die Produktionseinrichtung erfolgen, einem mit einer solchen Steuereinrichtung verbundenen EDGE-Device oder einer sonstigen mit der Produktionseinrichtung oder der Steuereinrichtung für die Produktionseinrichtung verbundenen Recheneinrichtung oder Cloud.

Das automatisierte oder teilautomatisierte Ermitteln des weiteren Einstellparametersatzes, beispielsweise gemäß Verfahrensschritt b.), kann dabei beispielsweise auf denselben Computereinrichtungen erfolgen, wie sie vorstehend in Bezug auf das Trainieren des ML-Modells genannt wurden. Dabei kann das automatisierte oder teilautomatisierte Ermitteln des weiteren Einstellparametersatzes beispielsweise auf derselben Recheneinrichtung erfolgen wie das Trainieren des ML-Modells oder auch auf einer weiteren Recheneinrichtung.

Es kann beispielsweise vorgesehen sein, dass nach dem automatisierten oder teilautomatisierten Ermitteln des weiteren Einstellparametersatzes gemäß Verfahrensschritt b.) der weitere Einstellparametersatz zum Einrichten der Produktionseinrichtung vorgesehen ist oder gespeichert wird - oder auch, dass die Produktionseinrichtung unter Verwendung des weiteren Einstellparametersatzes eingerichtet wird.

Weiterhin kann vorgesehen sein, dass nach dem automatisierten oder teilautomatisierten Ermitteln des weiteren Einstellparametersatzes gemäß Verfahrensschritt b.) ein Übertragen des weiteren Einstellparametersatzes an eine Recheneinrichtung oder Speichereinrichtung erfolgt, beispielsweise an eine Steuereinrichtung für die Produktionseinrichtung.

Es kann auch vorgesehen sein, dass nach dem automatisierten oder teilautomatisierten Ermitteln des weiteren Einstellparametersatzes, dieser in einer entsprechenden Recheneinrichtung gemäß der vorliegenden Beschreibung, beispielsweise eine Steuereinrichtung für die Produktionseinrichtung, gespeichert wird.

Zudem kann auch vorgesehen sein, dass nach dem automatisierten oder teilautomatisierten Ermitteln des weiteren Einstellparametersatzes ein Herstellen eines weiteren Produkts mit der Produktionseinrichtung unter Verwendung des weiteren Einstellparametersatzes erfolgt. Dieses Herstellen eines weiteren Produkts mit der Produktionseinrichtung unter Verwendung des weiteren Einstellparametersatzes kann dabei beispielsweise gemäß oder im Rahmen eines Verfahrensschritts c.) gemäß der vorliegenden Beschreibung erfolgen.

Weiterhin kann vorgesehen sein, dass das Verfahren vor dem Verfahrensschritt a.) den nachfolgend beschriebenen Verfahrensschritt umfasst:
a0.) Prüfen, ob der Messparametersatz das vorgegebene oder vorgebbare Qualitätskriterium erfüllt, und, wenn der Messparametersatz das vorgegebene oder vorgebbare Qualitätskriterium nicht erfüllt, Weiterführen des Verfahrens mit Verfahrensschritt a.).

In einer weiteren vorteilhaften Ausgestaltung kann zudem vorgesehen sein, dass, wenn in Verfahrensschritt a0.) die Prüfung ergibt, dass der Messparametersatz das vorgegebene oder vorgebbare Qualitätskriterium erfüllt, unmittelbar ein weiteres Produkt mit der Produktionseinrichtung unter Verwendung des Einstellparametersatzes hergestellt wird. Dies kann beispielsweise im Rahmen eines Verfahrens gemäß der vorliegenden Beschreibung erfolgen, z.B. im Rahmen von Verfahrensschritt c.) gemäß der vorliegenden Beschreibung.

Weiterhin kann vorgesehen sein, dass, z.B. im Rahmen des Verfahrensschritts a0.), eine Anzahl von letzten erfassten Messparametersätzen bzw. entsprechenden Testschritten (z.B. 5 Messparametersätze oder Testschritte) hinsichtlich einer Verbesserung bezogen auf das zu optimierende Ziel (z.B. eine Produktqualität und/oder eine zu reduzierende Prozesszeit) zusätzlich untersucht, ausgewertet und/oder betrachtet werden, um z.B. eine bevorzugte weitere Vorgehensweise zu ermitteln. Dabei kann beispielsweise untersucht werden, ob sich im Rahmen der letzten erfassten Messparametersätze eine Verbesserung in Bezug auf eine Erfüllung des Qualitätskriteriums, einer Produktqualität und/oder eines Optimierungsparameters gemäß der vorliegenden Beschreibung ergeben hat.

Dabei dann beispielsweise vorgesehen sein, dass im Falle, dass keine (wesentliche) Verbesserung stattgefunden hat, die Methode, z.B. im Rahmen eines Verfahrens gemäß der vorliegenden Beschreibung, terminiert wird, und/oder eine Herstellung eines oder mehrerer weiterer Produkte, z.B. mit dem letzten ermittelten Einstellparametersatz, oder einem sich aus den letzten verwendeten Einstellparametersätzen ergebender Einstellparametersatz, gestartet wird.

Weiterhin kann vorgesehen sein, dass im Falle, in welchem eine Verbesserung festgestellt wurde, die Methode, beispielsweise im Rahmen eines Verfahrens gemäß der vorliegenden Beschreibung - z.B. weiter ab Verfahrensschritt a.) - weiterhin angewendet wird. Dies kann auch dann vorgesehen sein, wenn bereit ein akzeptierter Mess- und/oder Einststellparametersatz, beispielsweise ein dem Qualitätskriterium entsprechender Messparametersatz und zugehöriger Einstellparametersatz, gefunden wurde.

Alternativ kann, wenn die Prüfung ergibt, dass der Messparametersatz das vorgegebene oder vorgebbare Qualitätskriterium erfüllt, die Herstellung von weiteren Produkten mit der Produktionseinrichtung erfolgen und zu einem späteren Zeitpunkt - z.B. nach der Herstellung mehrerer weiterer Produkte mit dem Einstellparametersatz - erneut eine Prüfung erfolgen.

Im Rahmen dieser Ausgestaltungen kann beispielsweise die Produktion von Produkten ohne eine weitere Optimierung der Einstellparameter fortgesetzt werden, wobei dann z.B. weiterhin regelmäßig überprüft wird, ob das Qualitätskriterium immer noch erfüllt ist. Auf diese Weise ist es beispielsweise möglich, nach einem erstmaligen Einrichten eines Herstellungsverfahrens auf eventuelle Veränderungen im Verfahren, z.B. durch eine Drift oder Ähnliches, zu reagieren.

Weiterhin kann auch, wenn die Prüfung ergibt, dass der Messparametersatz das vorgegebene oder vorgebbare Qualitätskriterium erfüllt, das Verfahren trotzdem mit Verfahrensschritt b.) fortgesetzt werden. Dies kann z.B. dann durchgeführt werden, wenn trotz Erfüllen des Qualitätskriteriums eine weitere Optimierung des Messparametersatzes erfolgen soll bzw. versucht werden soll.

Die Produktionseinrichtung kann beispielsweise als eine Komponente, Vorrichtung und/oder Anlage ausgebildet und eingerichtet sein, die zur Herstellung eines Produkts ausgebildet und eingerichtet ist

Eine solche Vorrichtung oder Anlage kann beispielsweise als eine Maschine, ein Gerät, ein Roboter, eine Produktionsanlage oder vergleichbares ausgebildet und eingerichtet sein oder auch derartige Teile als Komponenten umfassen. Solch eine Vorrichtung oder Anlage kann z.B. ein oder mehrere Komponenten, Antriebe, Sensoren, Maschinen, Geräte, Kommunikationseinrichtungen oder Ähnliches umfassen.

Dabei kann ein Produkt jede beliebige Art von Produkt darstellen, z.B. eine ProduktKomponente, ein Endprodukt, ein Zwischenprodukt, ein Vor-Produkt oder ähnliches.

Die Produktionseinrichtung kann beispielsweise als eine Spritzgussmaschine oder -anlage, eine Druckgussmaschine oder -anlage, ein Lotpasten-Drucker (beispielsweise mit einem integrierten und/oder gesonderten Lotpasten-Inspektionssystem (SPI: "solder paste inspection")), eine Elektronikproduktionsstraße und/oder vergleichbare Produktionseinrichtungen ausgebildet und eingerichtet sein.

Dabei kann die Produktionseinrichtung beispielsweise Komponenten und/oder Einrichtungen zur Erfassung des Messparametersatzes, oder Teilen davon, umfassen. Weiterhin können auch von der Produktionseinrichtung gesonderte Erfassungseinrichtungen zur Erfassung des Messparametersatzes, oder Teilen davon, vorgesehen sein. Eine solche Komponente zur Erfassung eines Messparametersatzes, oder Teilen davon, kann in dem Fall, in welchem die Produktionseinrichtung als ein Lotpastendrucker ausgebildet und eingerichtet ist, beispielsweise als ein Lotpasten-Inspektionssystem (SPI) ausgebildet und eingerichtet sein.

Solche Komponenten zur Erfassung von Messparametern können beispielsweise jede Art von Sensoren sein oder umfassen, z.B. optische Sensoren, Kameras, optische Vermessungssysteme, Temperatursensoren, Drucksensoren, Strömungssensoren, und/oder beliebige andere Sensoren oder Messsysteme sein oder umfassen. Dabei können solche Sensoren oder Messsysteme beispielsweise entsprechende Auswerteeinrichtungen zur Auswertung entsprechender Sensorsignale umfassen. Weiterhin können auch gesonderte Auswerteeinrichtungen zu derartigen Sensoren vorgesehen sein.

Weiterhin kann die Produktionseinrichtung, und/oder entsprechende Messsysteme zur Erfassung von Messparametern, eine Steuereinrichtung - oder auch jeweils eine Steuereinrichtung - umfassen. Weiterhin kann auch eine gesonderte Steuereinrichtung zur Steuerung der Produktionseinrichtung - und gegebenenfalls weiterer Komponenten, Einrichtungen, Anlagen oder Vorrichtungen - vorgesehen sein.

Die Steuereinrichtung kann jede Art von Computer oder Computersystem sein, welcher zur Steuerung Vorrichtung oder Anlage, insbesondere einer Produktionseinrichtung gemäß der vorliegenden Beschreibung, ausgebildet und eingerichtet ist. Bei der Steuerung kann es sich auch um einen Computer, ein Computersystem oder eine sogenannte Cloud handeln, auf der eine Steuerungssoftware oder eine Steuerungssoftware-Anwendung, zum Beispiel eine Steuerungsanwendung, implementiert bzw. installiert ist. Eine solche in der Cloud oder auf einem Computer implementierte Steuerungsanwendung kann z.B. als eine Applikation mit der Funktionalität einer speicherprogrammierbaren Steuerung ausgebildet und eingerichtet sein.

Die Steuereinrichtung kann weiterhin auch als ein sogenanntes EDGE-Device ausgebildet und eingerichtet sein, wobei ein solches EDGE Device beispielsweise eine Applikation zur Steuerung von Vorrichtungen oder Anlagen umfassen kann. Beispielsweise kann eine solche Applikation als eine Applikation mit der Funktionalität einer speicherprogrammierbaren Steuerung ausgebildet und eingerichtet sein. Das EDGE Device kann dabei beispielsweise mit einer weiteren Steuereinrichtung einer Vorrichtung oder Anlage verbunden sein oder auch unmittelbar mit einer zu steuernden Vorrichtung oder Anlage. Weiterhin kann das EDGE Device derart ausgebildet und eingerichtet sein, dass es zusätzlich noch mit einem Datennetzwerk oder einer Cloud verbunden ist bzw. zur Verbindung mit einem entsprechenden Datennetzwerk oder einer entsprechenden Cloud ausgebildet und eingerichtet ist.

Die Steuereinrichtung kann beispielsweise auch als eine sogenannte speicherprogrammierbare Steuerung (SPS) ausgebildet und eingerichtet sein. Weiterhin kann die Steuerungseinrichtung auch als eine sogenannte modulare speicherprogrammierbare Steuerung (modulare SPS) eingerichtet und ausgestaltet sein.

Bei einer speicherprogrammierbaren Steuerung, kurz SPS, handelt es sich um eine Komponente, die programmiert und eingesetzt wird, um eine Anlage oder Maschine zu regeln bzw. zu steuern. In SPSen können spezifische Funktionen wie beispielsweise eine Ablaufsteuerung implementiert werden, so dass auf diese Weise sowohl die Eingangs- als auch die Ausgangssignale von Prozessen oder Maschinen gesteuert werden können. Definiert wird die speicherprogrammierbare Steuerung beispielsweise im Standard EN 61131.

Um eine speicherprogrammierbare Steuerung an die Anlage bzw. Maschine anzubinden, kommen sowohl Aktoren, die im Allgemeinen an den Ausgängen der speicherprogrammierbaren Steuerung angeschlossen sind, als auch Sensoren zum Einsatz. Des Weiteren werden Statusanzeigen verwendet. Grundsätzlich befinden sich die Sensoren an den SPS-Eingängen, wobei durch sie die speicherprogrammierbare Steuerung Informationen darüber erhält, was in der Anlage bzw. Maschine vonstattengeht. Als Sensoren gelten beispielsweise: Lichtschranken, Endschalter, Taster, Inkrementalgeber, Füllstandsensoren, Temperaturfühler. Als Aktoren gelten z.B: Schütze zum Einschalten elektrischer Motoren, elektrische Ventile für Druckluft oder Hydraulik, Antriebssteuerungsmodule, Motoren, Antriebe.

Die Realisierung eine SPS kann auf verschiedene Art und Weise erfolgen. Das heißt, sie kann als elektronisches Einzelgerät, als Softwareemulation, als ein oder mehrere Software-Applikationen, als PC-Einsteckkarte usw. verwirklicht werden. Häufig finden sich auch modulare Lösungen, im Rahmen derer die SPS aus mehreren Steckmodulen zusammengebaut wird.

Eine Datenverarbeitungseinrichtung und/oder Recheneinrichtung kann beispielsweise mobil oder auch stationär ausgebildet und eingerichtet sein. Die Datenverarbeitungseinrichtung kann beispielsweise als ein Computer, ein Personalcomputer, eine Workstation, ein Smartphone, ein Tablet-Computer, ein Computernetzwerk, eine Cloud, eine Steuerungseinrichtung, ein Controller, eine speicherprogrammierbare Steuerung, ein Edge-Device oder vergleichbare Geräte oder Einrichtungen ausgebildet und eingerichtet sein.

Weiterhin kann die Datenverarbeitungseinrichtung auch als eine logische und/oder funktionale Einheit innerhalb eines größeren Gesamtsystems ausgebildet und eingerichtet sein (z.B. als eine "Datentverarbeitungseinrichtungs-App" in einer Cloud oder einer virtuellen Steuereinrichtung (z.B. einer sogenannten vPLC oder Soft-PLC)).

Als Edge-Device oder Edge-Gerät wird im Zusammenhang mit der vorliegenden Beschreibung eine Kommunikationseinrichtung, Computereinrichtung und/oder Steuereinrichtung verstanden, welche kommunikativ sowohl mit einem Automatisierungssystem (z.B. einer Steuereinrichtung, einem Steuerungssystem und/oder einem Bearbeitungssystem gemäß der vorliegenden Beschreibung) als auch mit einem weiteren, nicht zum Automatisierungssystem gehörenden Kommunikationsnetz verbunden ist. Solch ein weiteres, nicht zum Automatisierungssystem gehörendes Kommunikationsnetz kann z.B. eine Cloud, ein Firmen-Kommunikationssystem oder-netz (z.B. einem Firmen-Intranet) oder ein öffentliches Kommunikationsnetz (z.B. ein Internet, ein WLAN, ein Ethernet, ein Mobilfunknetz, ein Festnetz (z.B. ein DSL-Netz) oder ähnliches sein. Das Edge-Device oder Edge-Gerät kann dabei z.B. auch Teil des Automatisierungssystems sein und z.B. als eine Art Gateway eine Verbindung zu Kommunikationssystemen außerhalb des Automatisierungssystems herstellen.

Ein Edge-Device kann beispielsweise eine Applikation zur Steuerung von Vorrichtungen oder Anlagen umfassen. Beispielsweise kann eine solche Applikation als eine Applikation mit der Funktionalität einer speicherprogrammierbaren Steuerung ausgebildet und eingerichtet sein. Das EDGE Device kann dabei beispielsweise mit einer weiteren Steuereinrichtung einer Vorrichtung oder Anlage verbunden sein oder auch unmittelbar mit einer zu steuernden Vorrichtung oder Anlage. Weiterhin kann das EDGE Device derart ausgebildet und eingerichtet sein, dass es zusätzlich noch mit einem Datennetzwerk oder einer Cloud verbunden ist bzw. zur Verbindung mit einem entsprechenden Datennetzwerk oder einer entsprechenden Cloud ausgebildet und eingerichtet ist.

Ein Edge-Device kann weiterhin zur Realisierung zusätzlicher Funktionalitäten im Zusammenhang mit der Steuerung beispielsweise einer Maschine, Anlage oder Komponente - oder Teilen davon - ausgebildet und eingerichtet sein. Solche Funktionalitäten können beispielsweise sein:
- Daten sammeln und Übertragen in die Cloud und/oder eine entsprechende Vorverarbeitung, Kompression und/oder Analyse solcher Daten;
- eine Analyse von Daten, z.B. mit AI-Verfahren, z.B. mit neuronalen Netzen oder entsprechenden ML-Modellen. Auf dem Edge-Device kann dafür z.B. ein ML-Modell installiert oder implementiert sein.
- Management oder Durchführung eines Trainings eines neuronalen Netzes oder ML-Modells. Das Training selbst kann dabei zumindest teilweise im Edge Device selbst, oder aber zumindest u.a. auch in einer Cloud erfolgen. Erfolgt ein Training in einer Cloud, kann das Edge-Device z.B. dazu ausgebildet sein, das trainierte neuronale Netz oder ML-Modell herunterzuladen und nachfolgend zu verwenden.

Einstellparameter können alle Parameter, Vorgaben und/oder Werte sein, mit welchen die Produktionseinrichtung zur Herstellung des Produkts eingerichtet werden kann und/oder eingerichtet wird. Derartige Einstellparameter können beispielsweise vermittels einer Steuereinrichtung oder an einer Steuerungseinrichtung für die Produktionseinrichtung, unmittelbar an der Produktionseinrichtung selbst und/oder auch über eine Kommunikationsverbindung an der Produktionseinrichtung eingestellt werden.

Der Einstellparametersatz kann beispielsweise einen, mehrere oder auch alle der einstellbaren Einstellparameter für die Produktionseinrichtung umfassen. Weiterhin kann der Einstellparametersatz beispielsweise diejenigen Einstellparameter der Produktionseinrichtung umfassen, welche typischerweise in einem regelmäßigen Betrieb eingestellt und/oder verändert werden.

Bei einer als Lotpastendrucker ausgebildeten Produktionseinrichtung kann ein Einstellparametersatz beispielsweise die Einstellparameter Rakelgeschwindigkeit, Trenngeschwindigkeit und Trennabstand umfassen oder aus diesen Einstellparametern bestehen.

Ganz allgemein können Messparameter im Rahmen der vorliegenden Beschreibung beispielsweise alle Arten von nulldimensionalen, eindimensionalen, und/oder mehrdimensionalen Datenstrukturen sein.

Beispielsweise können die Messparameter als zweidimensionale Bild-Daten ausgebildet und eingerichtet sein und/oder als aus derartigen Bild-Daten abgeleitete Daten, Werte und/oder Parameter. Dabei können die Bilddaten beispielsweise von einer optischen Erfassungseinrichtung, zum Beispiel einer Kamera, erfasst werden oder erfasst worden sein. Dabei kann die optische Erfassungseinrichtung zum Erfassen von Messparametern in unterschiedlichen Spektralbereichen, z.B. vom ferninfraroten bis zum ultravioletten Spektralbereich, oder auch in Teilbereichen davon, ausgebildet und eingerichtet sein.

Weiterhin können entsprechende ein- oder mehrdimensionale Bild-Daten auch von einer Thermalkamera erfasste Temperaturdaten enthalten, oder auch von entsprechenden Messgeräten erfasste elektrische Daten (beispielsweise Ladungen, Ströme oder elektrische Felder oder Feldstärken) oder auch magnetische Daten (magnetische Felder oder Feldstärken) enthalten oder umfassen.

Messparameter können alle Werte, Messwerte, null-, ein- oder mehrdimensionalen Daten und/oder Parameter sein, welche im Rahmen der Herstellung des Produkts und/oder des hergestellten Produkts erfasst werden oder erfassbar sind. Dabei können Messparameter beispielsweise unmittelbar erfasste Werte, Daten, Bilder und/oder Parameter sein. Weiterhin können Messparameter auch alle aus derartigen unmittelbar erfassten Daten abgeleiteten Daten, Werte, Bilder und/oder Parameter sein.

Ein Messparametersatz kann beispielsweise sowohl die vorstehend genannten unmittelbar erfasste Werte, Messwerte, Daten/oder Parameter umfassen, als auch aus diesen abgeleitete oder berechnete Daten, Werte, Bilder und/oder Parameter.

Die Erfassung der Messparameter kann beispielsweise unmittelbar im Rahmen der Produktionseinrichtung erfolgen, beispielsweise vermittels dort implementierter Sensoren. Weiterhin können Messparameter auch als sogenannte Soft-Sensoren ausgebildet und eingerichtet sein, welche beispielsweise im Rahmen einer Simulation der Produktionseinrichtung und/oder eines Herstellungsvorgangs des Produkts unter Verwendung beispielsweise von Einstellparametern oder Sensorparametern ermittelt werden bzw. ermittelt werden können.

Weiterhin können Messparameter auch von verschiedensten weiteren Messeinrichtungen und/oder Sensoren im Rahmen des Herstellungsvorgangs des Produkts oder auch am oder mit dem hergestellten Produkt bestimmt, gemessen und/oder ermittelt werden.

Insbesondere können Messparameter verschiedene Messwerte zu einer Messung und/oder aus einem oder mehreren Messwerten abgeleitete und/oder berechnete weitere Wert, Parameter, Daten oder ähnliches (z.B. sogenannte "Soft-Sensoren") sein. Die Messung kann z.B. das gesamte Produkt betreffen, einen Teil des Produktes oder einen bestimmten Bereich des Produktes (z.B. den Bereich eines oder mehrere Bauelemente auf einem PCB). Weiterhin können Messparameter auch Produkteigenschaften sein, solche umfassen und/oder auch aus solchen Produkteigenschaften abgeleitet sein.

In einem Beispiel, in welchem die Produktionseinrichtung beispielsweise als ein Lotpastendrucker für eine Schaltungsplatine (Printed Circuit Board, PCB) ausgebildet und eingerichtet ist, kann ein Messparameter beispielsweise ein aufgetragenes Lotpastenvolumen, eine aufgetragene Lotpastenfläche oder eine vergleichbare Größe eines bestimmten Lotpastendepots (kurz "Pad") auf der Platine sein. Ein Messparametersatz kann beispielsweise aus einem solchen Lotpastenvolumen bestehen oder ein solches umfassen. Weiterhin kann ein entsprechender Messparametersatz auch Lotpastenvolumina mehrerer an verschiedenen Orten auf der Platine befindlicher Lotpasten-Depots umfassen oder aus diesen bestehen.

Diese Werte können beispielsweise mit einem sogenannten Lotpasten-Inspektionssystem (Solder Paste Inspektion, SPI) ermittelt werden.

In einem weiteren Beispiel, in welchem die Produktionseinrichtung als Spritzguss- oder Druckguss-Vorrichtung ausgebildet und eingerichtet ist, kann ein Messparameter beispielsweise ein Gewicht eines hergestellten Produkts und/oder eine Oberflächenqualität eines hergestellten Produkts und/oder einer Oberflächenstruktur eines hergestellten Produkts darstellen oder umfassen.

Diese Werte bzw. Daten können beispielsweise durch Wiegen eines hergestellten Produkts oder eine Oberflächenanalyse eines hergestellten Produkts ermittelt werden.

Dabei wird unter einem maschinellen Lernverfahren beispielsweise ein automatisiertes ("maschinelles") Verfahren verstanden, welches Ergebnisse nicht durch im Vorhinein festgelegte Regeln generiert, sondern bei welchem vermittels eines maschinellen Lernalgorithmus oder Lernverfahrens aus vielen Beispielen (automatisch) datenbasierte Regelmäßigkeiten identifiziert werden, auf deren Basis dann Aussagen über zu analysierende Daten erzeugt werden.

Solche maschinellen Lernverfahren können beispielsweise als ein überwachtes Lernverfahren, ein teilüberwachtes Lernverfahren, ein unüberwachtes Lernverfahren oder auch ein bestärkendes Lernverfahren ("Reinforcement Learning") ausgebildet und eingerichtet sein.

Beispiele für maschinelle Lernverfahren sind z.B. Regressions-Algorithmen (z.B. lineare Regressionsalgorithmen), eine Erzeugung oder Optimierung von Entscheidungsbäumen (sogenannte "Decision Trees"), Lernverfahren für neuronale Netze, Clustering-Verfahren (z.B. ein sogenanntes "k-means-Clustering"), Lernverfahren für oder Erzeugung von Stützvektormaschinen ("Support Vector Machines" (SVM)), Lernverfahren für oder Erzeugung von sequentiellen Entscheidungsmodellen oder Lernverfahren für oder Erzeugung von Bayessche Modellen oder Netzen.

So ist ein Beispiel für ein maschinelles Lernverfahren die "Lineare Regression". Die lineare Regression ist eine Parametrische Methode, bei der die Labels durch die Gewichtung aller Features angenähert werden. Bei einer Standardvariante des linearen Modells wird bei der Optimierung der mittlere quadratische Fehler (engl. Mean Squared Error, MSE) minimiert. Es gibt andere Varianten des linearen Modells, die sich nach der Form der Fehlerfunktion unterscheiden. Eine Variante ist z.B. der Huber-Schätzer, bei dem z.B. ein Parameter *ε* eingeführt wird, um Ausreißer in den Inputs zu beseitigen.

Ein weiteres Beispiel für ein maschinelles Lernverfahren ist das k-Nächste-Nachbarn-Verfahren. Das Prinzip des k-Nächste-Nachbar (k-NN) Modells ist, für jeden Input die k nächsten Inputs zu ermitteln. Es ist eine nicht-parametrische Methode, bei der das Ähnlichkeitskriterium eine definierte Metrik ist. Diese Metrik kann eine Norm oder eine Distanz sein, die für alle Inputs bestimmbar ist. Aus der Nachbarschaft bzw. Ähnlichkeit der Inputs wird das Label der jeweiligen betrachteten Instanz hergeleitet.

Entscheidungsbäume sind ein weiteres Beispiel für ein ML-Modell, dem ein maschinelles Lernverfahren zugrunde liegt. Ein Entscheidungsbaum (engl. Decision Tree, DT) ist eine hierarchische Struktur, mit der eine nicht-parametrische Schätzung implementiert werden kann. Bei der Datenverarbeitung mit Entscheidungsbäumen werden die Inputs in lokalen Regionen aufgeteilt, deren Distanz zueinander durch eine bestimmte Metrik definiert wird. Diese lokalen Regionen sind die Entscheidungsbäume.

Ein Entscheidungsbaum ist eine Sequenz von rekursiven Aufteilungen, die aus Entscheidungsknoten und Endknoten bzw. Blättern besteht. Bei jedem Entscheidungsknoten wird über eine definierte Funktion, die sogenannte Diskriminanzfunktion, eine diskrete Entscheidung getroffen, deren Ergebnis (ja oder nein) zu den nachfolgenden Knoten führt. Wird ein Blattknoten erreicht, dann endet der Prozess, bei dem von Blattknoten zu Blattknoten die betrachtete Instant differenziert wird und ein Ausgabewert wird geliefert.

Das Ergebnis einer solchen Anwendung eines solchen maschinellen Lernalgorithmus oder Lernverfahrens auf bestimmte Daten wird, insbesondere in der vorliegenden Beschreibung, als "Machine-Learning"-Modell oder ML-Modell bezeichnet.

Allgemein wird unter einem ML-Modell oder "Machine-Learning"-Modell, insbesondere im Rahmen der vorliegenden Beschreibung, das Ergebnis einer Anwendung eines maschinellen Lernalgorithmus oder Lernverfahrens auf bestimmte Daten verstanden. Ein ML-Modell stellt dabei das digital gespeicherte oder speicherbare Ergebnis der Anwendung des maschinellen Lernalgorithmus oder Lernverfahrens auf die analysierten Daten dar.

Ein solches digital gespeichertes oder speicherbares ML-Modell kann beispielsweise als eine Datensammlung (z.B. bezüglich das ML-Modell beschreibenden Parametern) und/oder eine entsprechende Datenbank ausgebildet und eingerichtet sein. Weiterhin kann das ML-Modell beispielsweise auch als ausführbarer Programmcode ausgebildet und eingerichtet sein, wobei z.B. das ML-Modell beschreibende Parameter im Rahmen dieses Programmcodes gespeichert sind oder speicherbar sein können. Ein solcher Programmcode kann beispielsweise zum Training und/oder zur Inferenz des ML-Modells ausgebildet und eingerichtet sein.

Dabei kann die Erzeugung des ML-Modells derart ausgebildet und eingerichtet sein, dass das ML-Modell durch die Anwendung des maschinellen Lernverfahrens neu gebildet wird oder ein bereits bestehendes ML-Modell durch die Anwendung des maschinellen Lernverfahrens verändert oder angepasst wird.

Beispiele für solche ML-Modelle sind Ergebnisse von Regressions-Algorithmen (z.B. eines linearen Regressions-Algorithmus), Neuronale Netze ("Neural Networks"), Entscheidungsbäume ("Decision Tree"), die Ergebnisse von Clustering-Verfahren (inklusive z.B. die erhaltenen Cluster oder Cluster-Kategorien, -Definitionen und/oder -Parameter), Stützvektormaschinen ("Support Vector Machines" (SVM)), Sequentielle Entscheidungsmodelle, Selbstorganisierte Karten ("self organizing maps", SOM) oder Bayessche Modelle oder Netze.

Weiterhin können auch verschiedene Kategorien von ML-Modellen zu einem Gesamt-ML-Modell kombiniert werden. Eine solche Modelkombination (engl. Ensemble Learning) ist die Verknüpfung von verschiedenen ML-Modellen, um eine bessere Inferenz zu erreichen. Die kombinierten ML-Modelle bilden ein sogenanntes Ensemble. Es gibt verschiedene Methoden, wie Modelle zusammengeführt werden können, und zwar können sie per Voting, Bagging oder Boosting kombiniert werden.

Zudem gibt es auch noch das sogenannte Automatisierte Maschinelle Lernen. Das Automatisierte Maschinelle Lernen (AutoML) ist ein Verfahren, nach dem für gegebene Aufgaben oder Datensätze ein Algorithmus versucht, die beste Lernstrategie aus einer bestimmten Anzahl von maschinellen Lernverfahren bzw. ML-Modellen zu bestimmen. Beim AutoML sucht der Algorithmus nach den besten Vorverarbeitungsschritten und den besten maschinellen Lernverfahren bzw. dem besten Ensemble. AutoML kann mit Meta-Learning kombiniert werden. Meta-Learning, auch "Learning to Learn" genannt, ist die Wissenschaft, bei der systematisch beobachtet wird, wie verschiedene Ansätze von ML bei einer Vielzahl von Lernaufgaben abschneiden, und dann aus diesen Erfahrungen (Metadaten) gelernt wird, um neue Aufgaben viel schneller zu lernen, als es sonst möglich wäre.

Eine gute Implementierung vom AutoML bietet die Software-Bibliothek AUTO-SKLEARN (https://www.automl.org/automl/auto-sklearn/). Dieses System kann ein Ensemble von bis zu 15 Schätzern bilden. Außerdem können dazu noch bis zu 14 Vorverarbeitungsmethoden für Features und vier Vorverarbeitungsmethoden für Datensätze genutzt werden.

Neuronale Netze können dabei z.B. sogenannte "Deep Neural Networks", "Feed Forward Neural Networks", "Recurrent Neural Networks"; "Convolutional Neural Networks" oder "Autoencoder-Neural-Networks" sein. Dabei wird die Anwendung entsprechender maschineller Lernverfahren und/oder Optimierungsalgorithmen auf neuronale Netze häufig auch als "Training" des entsprechenden Neuronalen Netzes bezeichnet.

Entscheidungsbäume können beispielsweise als sogenannte "iterative Dichotomizer 3" (ID3), Klassifikations- oder Regressionsbäume (CART) oder auch sogenannte "Random Forests" ausgebildet und eingerichtet sein.

Dabei kann das ML-Modell beispielsweise in einer Form vorliegen, gespeichert sein oder speicherbar sein, welche die Anwendung des ML-Modells auf neue Daten zur Erzeugung eines Ergebnisses erlaubt. Eine solche Anwendung eines ML-Modells auf Daten wird auch als "Inferenz" oder "Inference" bezeichnet. Weiterhin kann vorgesehen sein, dass das ML-Modell in der vorliegenden, gespeicherten oder speicherbaren Form, neben der Inferenz auch zum Training des ML-Modells ausgebildet und eingerichtet ist. Es kann aber auch vorgesehen sein, dass das ML-Modell in der vorliegenden, gespeicherten oder speicherbaren Form nicht mehr zum Training des ML-Modells ausgebildet und eingerichtet ist, insbesondere kann das ML-Modell in diesem Fall nur noch zur Anwendung auf Daten zur Erzeugung eines Ergebnisses, der vorstehend genannten "Inferenz", ausgebildet und eingerichtet ist.

Daten zum Erstellen und/oder Trainieren eines ML-Modells gemäß der vorliegenden Erfindung können beispielsweise historische Daten der ersten und/oder zweiten Erfassungseinrichtung sein oder solche Daten umfassen. Weiterhin können Daten zum Erstellen und/oder Trainieren des ML-Modells historische Daten von zur ersten und/oder zweiten Erfassungskomponente baugleichen, ähnlichen oder vergleichbaren Erfassungskomponenten umfassen, oder auch historische Daten von Komponenten der gleichen Kategorie oder des gleichen Typs wie die erste und/oder zweite Erfassungskomponente.

Bei einer Verwendung eines ML-Modells bzw. des ML-Modells mit Messdaten weiterer Erfassungskomponenten, oder auch der Verwendung weiterer ML-Modelle mit Messdaten weiterer Erfassungskomponenten, kann ein Erstellen und/oder ein Trainieren eines solchen ML-Modells ebenfalls mit historischen Daten dieser Erfassungskomponenten, vergleichbarer Erfassungskomponenten oder Erfassungskomponenten eines ähnlichen oder vergleichbaren Komponenten-Typs erfolgen.

Das ML-Modell kann auch als eine sogenannte "selbstorganisierte Karte" (Englisch: self-organizing map, abgekürzt SOM) ausgebildet und eingerichtet sein. Eine solche "selbstorganisierte Karte" bzw. "Self-Organizing Map" (SOM) ist eine mögliche Ausgestaltung eines neuronalen Netzes. Dabei ist eine SOM eine Art künstliches neuronales Netz, das mit Hilfe kompetitiver Lernenverfahren trainiert wird. Die SOM wurde in den 1980er Jahren von dem finnischen Professor Teuvo Kohonen eingeführt und wird daher manchmal auch als Kohonen-Map oder Kohonen-Netz bezeichnet

Derartige Self-Organizing Maps sind aus dem Stand der Technik bekannt, z.B. aus KOHONEN, Teuvo; Self-organized formation of topologically correct feature maps; Biological cybernetics, 1982, 43. Jg., Nr. 1, S.59-69 und/oder KOHONEN, Teuvo; Essentials of the self-organizing map; Neural Networks, Volume 37, January 2013, Pages 52-65.

Eine selbstorganisierende Karte bzw. "Self-Organizing Map" (SOM) ist ein Algorithmus des maschinellen Lernens bzw. für neuronale Netze, der in die Kategorie des unüberwachten Lernens fällt. Er wird zur Dimensionsreduzierung unter Beibehaltung der Datentopologie und Visualisierung hochdimensionaler Daten verwendet.

Der SOM-Algorithmus funktioniert, indem er Eingabedaten auf ein Gitter von Knoten oder Neuronen abbildet. Dabei besteht die SOM aus diesem Gitter von Knoten bzw. Neuronen und/oder einer Gewichtsmatrix. Dabei entsteht dann eine entsprechende Gewichtsmatrix aus Gewichtsvektoren, die jeweils den Neuronen in der SOM zugeordnet sind. Dabei umfassen die Eingabedaten in der Regel eine Anzahl von Parametern und/oder Datenpunkten, und die Gewichtsvektoren typischerweise dieselbe Anzahl an Gewichtswerten. Dabei ist in der Regel jedem Parameter der Eingabedaten ein bestimmter Gewichtswert in den Gewichtsvektoren zugeordnet.

In der vorliegenden Beschreibung wird als SOM sowohl das Gitter von Knoten oder Neuronen bezeichnet als auch die genannte Gewichtsmatrix aus den Gewichtsvektoren. Die Gewichtsmatrix stellt gewissermaßen eine Ausgestaltung der SOM dar. Dabei kann die Gewichtsmatrix beispielsweise in einer Speichereinrichtung einer Recheneinrichtung, eines Computers, eines Edge-Devices oder einer Steuereinrichtung gespeichert sein - beispielsweise als Datenbank. Weiterhin kann die Gewichtsmatrix auch als eine z.B. in einer Speichereinrichtung einer Recheneinrichtung, eines Computers, eines Edge-Devices oder einer Steuereinrichtung gespeicherte Software-Applikation ausgebildet sein, die zum Training und/oder der Verwendung der Gewichtsmatrix (die sogenannte "Inferenz") ausgebildet und eingerichtet ist. Dabei umfasst die Software-Applikation insbesondere auch die Daten der Gewichtsmatrix. Die Gewichtsmatrix sowie alle vorstehend genannten Ausgestaltungen oder Implementierungen der Gewichtsmatrix stellen dabei eine mögliche Ausgestaltung eines ML-Modells gemäß der vorliegenden Beschreibung dar - insbesondere auch eine mögliche Ausgestaltung einer SOM oder mod-SOM gemäß der vorliegenden Beschreibung.

Während des Trainingsprozesses passt die SOM die Gewichtsvektoren der Neuronen auf der Grundlage der Ähnlichkeit zwischen den Eingabedaten und den Gewichtsvektoren an. Dies führt zu einer topologischen Abbildung der Eingabedaten auf das Gitter, wobei ähnliche Eingabedatenpunkte nahe gelegenen Neuronen zugeordnet werden.

Ein als Self-Organizing-Map (SOM) ausgebildetes ML-Modell kann dabei derart ausgebildet und eingerichtet sein, dass dieses SOM-ML-Modell als eine Software-Applikation ausgebildet und eingerichtet ist, die eine entsprechend trainierte (oder auch untrainierte) SOM realisiert. Dabei kann die Softwareapplikation beispielsweise derart ausgebildet und eingerichtet sein, dass sowohl ein Training der SOM als auch eine Nutzung ("Inferenz") der SOM damit möglich ist. Eine Nutzung der SOM kann dabei daraus bestehen, die unterschiedlichen Parameterwerte der SOM auszulesen und zu analysieren. Eine derartige Analyse kann beispielsweise aus einem Clustering Verfahren bestehen oder auch eine Analyse bestimmter Parameter der einzelnen Neuronen bzw. Knoten der SOM. Eine derartige Analyse kann beispielsweise eine Interpolation eines oder mehrerer Parameter der jeweiligen Neuronen bzw. Knoten umfassen oder daraus bestehen.

Der Schlüsselgedanke hinter SOM ist, dass es die Eingabedaten so organisiert sind, dass ähnliche Eingabemuster auf nahegelegene Stellen des Gitters abgebildet werden, wobei die topologischen Beziehungen in den Eingabedaten erhalten bleiben. Dies ermöglicht die Visualisierung und das Verständnis der zugrunde liegenden Struktur der Eingabedaten.

SOMs wurden in verschiedenen Anwendungen wie Datenvisualisierung, Clustering und Mustererkennung eingesetzt. Sie sind besonders nützlich für die explorative Datenanalyse und das Verständnis komplexer hochdimensionaler Datensätze.

Das Trainingsverfahren einer "Self-Organizing Map" (SOM) besteht aus mehreren Schritten, die dazu dienen, das künstliche neuronale Netzwerk an die Eingangsdaten anzupassen, um die Topologie der Daten zu erfassen. Im Folgenden sind die grundlegenden Schritte des Trainingsverfahrens einer SOM beschrieben:
1.) Initialisierung der Gewichtsmatrix: Zu Beginn des Trainingsverfahrens werden die Gewichtsmatrix und die Topologie der SOM festgelegt. Die Gewichtsmatrix besteht aus Gewichtsvektoren, die jedem Neuron in der SOM zugeordnet sind. Diese Gewichtsvektoren sind in der Regel aus mehreren Gewichtswerten aufgebaut. Sie werden dann in der Regel mit Zufallswerten oder mit einer Methode wie der PCA (Principal Component Analysis) initialisiert.
2.) Präsentation der Eingangsdaten: Die Trainingsdaten werden nacheinander und/oder in Gruppen der SOM als Vektoren präsentiert. Dabei werden die Eingangsdatenvektoren nacheinander einzeln mit den Gewichtsvektoren jedes Neurons verglichen, um das am besten passende Neuron zum jeweiligen Eingangsdatenvektor zu identifizieren.
3.) Bestimmung des besten Anpassungsmusters: Das Neuron mit dem Gewichtsvektor, der dem Eingangsdatenvektor am besten entspricht, wird als das "Gewinner-Neuron" oder "Best Matching Unit" (BMU) bezeichnet. Dieses Neuron wird als dasjenige markiert, das am stärksten auf die präsentierten Eingangsdaten reagiert.
4.) Aktualisierung der Gewichtsvektoren: Das Gewinner-Neuron (also die "Best Matching Unit" (BMU)) und seine benachbarten Neuronen in der SOM werden aktualisiert, um sich den präsentierten Eingangsdaten anzupassen. Dieser Schritt beinhaltet die Anpassung der Gewichtsvektoren basierend auf einer Lernregel, die darauf abzielt, die Gewichtsvektoren näher an die präsentierten Eingangsdaten heranzuführen. Dabei kann eine Aktualisierung der Gewichtsvektoren üblicherweise so erfolgen, dass ein Neuron bzw. Knoten umso stärker an das jeweils präsentierte Eingangsdatum und/oder die BMU heranrückt, je geringer ein Abstand oder eine Distanz dazu ist beziehungsweise, je ähnlicher es dem jeweils präsentierte Eingangsdatum und/oder der BMU ist.
5.) Anpassung der Nachbarschaftsfunktion: Im Laufe des Trainingsverfahrens wird üblicherweise die Nachbarschaftsfunktion der SOM verändert, um die Anpassung der Gewichtsvektoren zu steuern. Dies ermöglicht eine topologische Organisation der Gewichtsvektoren, bei der benachbarte Neuronen ähnliche Gewichtsvektoren aufweisen. So kann die Anpassung der Gewichtsvektoren beispielsweise zu Beginn eines Trainings relativ groß sein und im weiteren Verlauf des Trainings immer kleiner werden.

Iterativer Prozess: Die Schritte 2 bis 5 werden iterativ für alle Trainingsdaten durchgeführt. Durch die Wiederholung dieses Prozesses passt sich die SOM allmählich an die Verteilung der Eingangsdaten an und bildet eine topologische Karte, die die Struktur der Daten repräsentiert.

Der Trainingsprozess der SOM zielt darauf ab, eine topologische Abbildung der Eingangsdaten zu erstellen, die es ermöglicht, Muster und Strukturen in den Daten zu erkennen und zu visualisieren.

Insgesamt umfasst der Trainingsprozess einer SOM die iterative Übermittlung von Eingabedatenpunkten an die SOM, die Anpassung der Gewichte der Neuronen auf der Grundlage der Ähnlichkeit zwischen den Eingabedaten und den Gewichten und die schrittweise Organisation des SOM-Gitters zur Darstellung der topologischen Beziehungen in den Eingabedaten.

Das Training des ML-Modells kann dabei derart ausgebildet und eingerichtet sein, dass ein untrainiertes ML-Modell unter Verwendung der Trainingsdaten trainiert wird. Weiterhin kann das Training des ML-Modells auch derart ausgebildet und eingerichtet sein, dass ein bereits trainiertes ML-Modell unter Verwendung der Trainingsdaten weiter trainiert wird.

In einer vorteilhaften Ausgestaltung kann vorgesehen sein, dass das ML-Modell als eine Self-Organizing Map (SOM) ausgebildet und eingerichtet ist und weiterhin vorgesehen ist, dass die SOM mit den Trainingsdaten neu trainiert wird, insbesondere mit den Trainingsdaten vollständig neu trainiert wird. Weiterhin kann auch vorgesehen sein, dass die SOM bereits trainiert ist und unter Verwendung der Trainingsdaten weiter trainiert wird.

Da bei Verwendung einer SOM als ML-Modell eine bereits trainierte SOM mit zusätzlichen Trainingsdaten weitertrainiert bzw. nachtrainiert wird. Dabei kann vorgesehen sein, dass die entsprechenden Trainingsmechanismen für eine SOM mit den neuen Trainingsdaten auf die bestehende, trainierte SOM angewendet werden.

In einer besonders vorteilhaften Ausgestaltung kann auch vorgesehen sein, dass die SOM ausgehend vom vollständig untrainierten Zustand mit sämtlichen Trainingsdaten, also sowohl den ursprünglich verwendeten als auch neu hinzugekommenen zusätzlichen Trainingsdaten neu trainiert wird, insbesondere mit diesen sämtlichen Trainingsdaten vollständig neu trainiert wird. Diese Ausgestaltung hat den Vorteil, dass beispielsweise unvorteilhafte Entwicklungen in der SOM im Rahmen des Trainings mit den ursprünglich verwendeten Trainingsdaten, beim Weitertrainieren nicht fortgeschrieben werden. Da insbesondere bei einem als SOM ausgestalteten ML-Modell das Trainieren vergleichsweise wenig Ressourcen benötigt, stellt ein solches Neutrainieren mit den erweiterten Daten gegenüber einem Weitertrainieren nur mit den neuen Daten einen nicht besonders erheblichen Zusatzaufwand dar.

Weiterhin kann vorgesehen sein, dass die Trainingsdaten neben dem Einstellparametersatz und/oder den Messparametersatz bezüglich dem in der Produktionseinrichtung hergestellten Produkt weiterhin auch Einstellparametersätze und/oder Messparametersätze bezüglich weiterer durch die Produktionseinrichtung hergestellter Produkte umfasst. Insbesondere kann vorgesehen sein, dass die Trainingsdaten neben dem Einstellparametersatz und/oder dem Messparametersatz bezüglich dem in der Produktionseinrichtung hergestellten Produkt weiterhin auch Einstellparametersätze und/Ober Messparametersätze bezüglich weiterer, dem Produkt entsprechenden oder zum Produkt gleichartigen Produkten umfasst.

Wie vorstehend dargestellt, umfasst das Training einer "Self-Organizing Map" (SOM) im Wesentlichen die nachfolgend genannten Schritte:
1.) Initialisierung der Gewichtsmatrix gemäß der vorstehenden Beschreibung.
2.) Präsentation der Eingangsdaten gemäß der vorstehenden Beschreibung.
3.) Bestimmung des besten Anpassungsmusters gemäß der vorstehenden Beschreibung.
4.) Aktualisierung der Gewichtsvektoren gemäß der vorstehenden Beschreibung.
5.) Anpassung der Nachbarschaftsfunktion gemäß der vorstehenden Beschreibung.

In einer vorteilhaften Ausgestaltung der Erfindung kann auch eine sogenannte "modifizierte Self-Organizing Map" (mod-SOM) verwendet werden. Diese unterscheidet von einer "Self-Organizing Map" gemäß dem Stand der Technik (s. z.B. KOHONEN, Teuvo; Self-organized formation of topologically correct feature maps; Biological cybernetics, 1982, 43. Jg., Nr. 1, S.59-69 und/oder KOHONEN, Teuvo; Essentials of the self-organizing map; Neural Networks, Volume 37, January 2013, Pages 52-65) beispielsweise durch die nachfolgend erläutertet Abweichung.

Wie bereits beschrieben umfassen die Eingabedaten einer SOM in der Regel eine Anzahl von Parametern, und die Gewichtsvektoren der SOM typischerweise dieselbe Anzahl an Gewichtswerten. Dabei ist in der Regel jedem Parameter der Eingabedaten ein bestimmter Gewichtswert in den Gewichtsvektoren der SOM zugeordnet.

In einer mod-SOM ist mindesten einer der Gewichtswerte jedes Gewichtsvektors als ein Sonder-Gewichtswert ausgebildet und eingerichtet der jeweils mindestens einem entsprechenden Sonder-Parameter der Eingangsdaten zugeordnet ist. Die übrigen der Gewichtswerte werden nachfolgend als "normale Gewichtswerte" bezeichnet und die übrigen der Parameter der Eingangsdaten als "normale Parameter" bezeichnet.

Dabei läuft das Training einer mod-SOM dann derart ab, dass zur Ermittlung der "Best-Matching-Unit" (BMU) (s. z.B. Schritt 2.) und/oder 3.) gemäß der vorstehenden Erläuterung) nur die Gewichtswerte der Gewichtsvektoren herangezogen werden, die nicht Sonder-Gewichtswerte sind (also nur die normalen Gewichtswerte). Und genauso werden bei dieser Ermittlung der BMU nur die Parameter des zum Training verwendeten Eingangsdaten-Werts verwendet, die nicht Sonder-Parameter sind (also nur die normalen Parameter).

Für die nachfolgende Aktualisierung der Gewichtsvektoren der mod-SOM (s. z.B. Schritt 4.) gemäß der vorstehenden Erläuterung) werden hingegen alle Gewichtswerte der Gewichtsvektoren und alle zum Training verwendeten Parameterwerte der Eingangsdaten verwendet. Das bedeutet, dass sowohl die Sonder-Gewichtswerte als auch die normalen Gewichtswerte sowie die Sonder-Parameter und die normalen Parameter zur Aktualisierung der Gewichtsvektoren der mod-SOM herangezogen werden.

Diese mod-SOM genannte Ausgestaltung einer SOM hat beispielsweise den Vorteil, dass sich auf diese Weise z.B. funktionale Zusammenhänge der betrachteten Daten, insbesondere bei den Eingangsdaten, in einer entsprechenden Topologie darstellen lassen. So kann beispielsweise ein funktionaler Zusammenhang zwischen den oben genannten normalen Parametern eines Eingangsdaten-Werts und dem mindestens einen Sonder-Parameter als entsprechender Funktionswert bestehen. Dabei wird die beim Training des mod-SOM entstehende Topologie nur durch die normalen Parameter bestimmt. Nachfolgend werden dann die Sonder-Gewichtswerte der Gewichtsvektoren durch die Einbeziehung Sonder-Parameter an die entstehende Topologie angepasst.

Dies ermöglicht eine besonders vorteilhafte Ausgestaltung eines Verfahrens gemäß der vorliegenden Beschreibung, da bei Verwendung einer mod-SOM als ML-Modell und Verwendung von sowohl Einstellparametern als auch Messparametern als Eingangsdaten für die mod-SOM beispielsweise eine besonders realitätsnahe Vorhersage von Messparametern erreichen lässt. Auf diese Weise lässt sich erreichen, dass sich im Rahmen des Einrichtens einer Produktionseinrichtung gemäß der vorliegenden Beschreibung ein vorgegebenes oder vorgebbares Qualitätskriterium besonders schnell, einfach und/oder gut erfüllen lässt.

Anhand einer beispielhaften Ausgestaltung der Herstellung des Produkts als Bedrucken von Leiterplatten mit Lotpaste für die Herstellung von elektronischen Baugruppen, werden Aufbau, Training und Verwendung einer modifizierten Self-Organizing-Map beispielhaft mit Bezug auf die beigefügten Figuren näher erläutert.

In einer vorteilhaften Ausgestaltung eines Verfahrens gemäß der vorliegenden Beschreibung kann vorgesehen sein, dass das ML-Modell als modifizierte Self-Organizing Map (mod-SOM), insbesondere gemäß der vorliegenden Beschreibung, ausgebildet und eingerichtet ist. Dabei kann vorgesehen sein, dass zum Trainieren diese mod-SOM bzw. dieses ML-Modells sowohl der Einstellparametersatz als auch der Messparametersatz herangezogen wird.

Dabei kann beispielsweise vorgesehen sein, dass zum Trainieren dieser mod-SOM, zumindest im Rahmen von Teilen des Trainings, sowohl der Einstellparametersatz als auch der Messparametersatz herangezogen wird. So kann in einer weiterhin vorteilhaften Ausgestaltung beispielsweise vorgesehen sein, dass im Rahmen des Trainings der mod-SOM im Rahmen eines Ermittelns einer Best Matching Unit (BMU) der Einstellparametersatz herangezogen wird, insbesondere nur der Einstellparametersatz herangezogen wird. Weiterhin kann vorgesehen sein, dass dann im Rahmen einer nachfolgenden Anpassung der mod-SOM sowohl der Einstellparametersatz als auch der Messparametersatz verwendet wird.

Dabei kann der Einstellparametersatz ein oder mehrere Einstellparameter und der Messparametersatz ein oder mehrere Messparameter umfassen.

In einer weiteren vorteilhaften Ausgestaltung umfasst ein als mod-SOM ausgestaltetes ML-Modell Gewichtsvektoren, wobei jeder Gewichtsvektor mindestens einen Sonder-Gewichtswert und ansonsten normale Gewichtswerte umfasst. Dabei erfolgt das Trainieren des als mod-SOM ausgestalteten ML-Modells unter Verwendung der Trainingsdaten gemäß Verfahrensschritt a.) gemäß der vorliegenden Beschreibung dann derart, dass ein Ermitteln einer Best-Matching-Unit des als mod-SOM ausgestalteten ML-Modells unter Verwendung des Einstellparametersatzes und der normalen Gewichtswerte der Gewichtsvektoren des mod-SOM erfolgt - insbesondere nur unter Verwendung des Einstellparametersatzes, also z.B. der "normalen Einstellparameter", und der normalen Gewichtswerte der Gewichtsvektoren. Das Anpassen des als mod-SOM ausgestalteten ML-Modells im Rahmen dieses Trainings erfolgt unter Verwendung des Einstellparametersatzes und des Messparametersatzes sowie den normalen Gewichtswerten und den Sonder-Gewichtswerten der Gewichtsvektoren der mod-SOM.

In einer weiteren vorteilhaften Ausgestaltung kann vorgesehen sein, dass ein als mod-SOM ausgestaltetes ML-Modell Gewichtsvektoren umfasst, wobei jeder Gewichtsvektor mindestens einen Sonder-Gewichtswert und ansonsten normale Gewichtswerte umfasst. Dabei kann vorgesehen sein, dass die normalen Gewichtswerte der Gewichtsvektoren jeweils Einstellparametern des Einstellparametersatzes zugeordnet sind. Weiterhin kann vorgesehen sein, dass dem mindestens ein Sonder-Gewichtswert der Gewichtsvektoren jeweils Messparameter des Messparametersatzes zugeordnet sind.

Weiterhin kann vorgesehen sein, dass das ML-Modell als eine mod-SOM ausgebildet und eingerichtet ist. Dabei kann dann weiterhin vorgesehen sein, dass im Rahmen eines Trainings der mod-SOM gemäß Verfahrensschritt a.) ein Ermitteln einer Best Matching Unit (BMU) mit einem ersten Parametersatz erfolgt, welcher einen Einstellparametersatz und/oder einen Messparametersatz umfasst. Weiterhin kann das Training dann derart ausgebildet und eingerichtet sein, dass eine Anpassung der mod-SOM mit einem erweiterten Parametersatz erfolgt, welcher den ersten Parametersatz sowie mindestens einen weiteren Einstellparameter und/oder mindestens einen weiteren Messparameter umfasst.

In einer weiteren Ausgestaltung kann vorgesehen sein, dass das ML-Modell als mod-SOM ausgebildet und eingerichtet ist. Dabei kann dann weiterhin vorgesehen sein, dass im Rahmen eines Trainings der mod-SOM gemäß Verfahrensschritt a.) ein Ermitteln einer Best Matching Unit (BMU) mit einem Einstellparametersatz erfolgt und weiterhin eine Anpassung der mod-SOM mit dem Einstellparametersatz sowie einem Messparametersatz erfolgt. Dabei kann der Einstellparametersatz einen oder mehrere Einstellparameter umfassen und der Messparametersatz einen oder mehrere Messparameter.

Dabei können die Trainingsdaten gemäß Verfahrensschritt a.) eines Verfahrens gemäß der vorliegenden Beschreibung dann derart ausgebildet sein, dass sie als Einstellparametersatz den vorstehend genannten Einstellparametersatz sowie gegebenenfalls den mindestens einen weiteren Einstellparameter umfassen, und als Messparametersatz den vorstehend genannten Messparametersatz und gegebenenfalls den mindestens einen weiteren Messparameter umfassen.

Weiterhin können auch beliebige Kombinationen der vorstehend genannten vorteilhaften Ausgestaltungen vorgesehen sein.

Unter einem neuronalen Netz wird, zumindest im Zusammenhang mit der vorliegenden Beschreibung, z.B. eine elektronische Einrichtung mit einem Computerprogramm, einem Computerprogramm-Produkt oder auch einer Software verstanden - oder auch das Computerprogramm, das Computerprogramm-Produkt oder auch die Software selbst oder in einer Speichereinrichtung gespeichert - welche ein Netzwerk sogenannter Knoten umfasst, wobei in der Regel jeder Knoten mit mehreren anderen Knoten verbunden ist. Weiterhin wird unter einem neuronalen Netz im Zusammenhang mit der vorliegenden Beschreibung beispielsweise weiterhin ein in einer Speichereinrichtung gespeichertes Computer-Programmprodukt, bzw. eine Software, verstanden, welches beim Ablauf auf einem Computer ein solches Netzwerk gemäß der vorliegenden Beschreibung erzeugt. Die Knoten werden beispielsweise auch als Neuronen, Units oder Einheiten bezeichnet. Dabei hat jeder Knoten mindestens eine Eingangs- und eine Ausgangsverbindung. Als Eingangs-Knoten für ein neuronales Netz, werden solche Knoten verstanden, welche von der Außenwelt Signale (Daten, Reize, Muster oder ähnliches) empfangen können. Unter Ausgabe-Knoten eines neuronalen Netzes werden solche Knoten verstanden, welche Signale, Daten oder ähnliches an die Außenwelt weitergeben können. Unter sogenannten "versteckten Knoten" ("hidden nodes") werden solche Knoten eines neuronalen Netzes verstanden, welche weder als Eingangs- noch als Ausgangs-Knoten ausgebildet sind.

Dabei kann das neuronale Netz beispielsweise als ein sogenanntes tiefes neuronales Netz ("deep neural network" (DNN)) ausgebildet sein. Ein solches "deep neural network" ist ein neuronales Netz, in welchem die Netzknoten in Schichten angeordnet sind (wobei die Schichten selbst ein-, zwei- oder auch höher-dimensional sein können). Ein tiefes neuronales Netz umfasst dabei mindestens eine sogenannte verdeckte Schicht, welche nur Knoten umfassen, die nicht Eingangsknoten oder Ausgangsknoten sind. Das heißt, die verdeckten Schichten haben keine direkten Verbindungen zu Eingangssignalen oder Ausgangssignalen.

Unter dem sogenannten "Deep Learning" wird dabei beispielsweise eine Klasse von maschinellen Lerntechniken verstanden, welche viele Schichten der nichtlinearen Informationsverarbeitung für die überwachte oder nicht-überwachte Merkmalsextraktion und - transformation sowie zur Musteranalyse und -klassifizierung ausnutzt.

Das Neuronales Netz kann beispielsweise auch eine so genannte Auto-Encoder-Struktur aufweisen. Eine derartige Auto-Encoder-Struktur kann beispielsweise geeignet sein, um eine Dimensionalität von Daten zu reduzieren und beispielsweise so Ähnlichkeiten und Gemeinsamkeiten zu erkennen.

Ein Neuronales Netz kann beispielsweise auch als ein so genanntes Klassifizierungs-Netz ausgebildet sein, welches besonders dazu geeignet ist, Daten in Kategorien einzuteilen. Derartige Klassifizierungs-Netze werden beispielsweise in Zusammenhang mit Handschrift-Erkennung eingesetzt.

Eine weitere mögliche Struktur eines neuronalen Netzes kann beispielsweise die Ausgestaltung als so genanntes "Deep-Believe-Network" sein.

Weiterhin kann ein neuronales Netz auch als eine "self organizing map" (SOM) oder eine "modifizierte self organizing map" (mod-SOM) gemäß der vorliegenden Beschreibung ausgebildet und eingerichtet sein.

Ein neuronales Netz kann beispielsweise auch eine Kombination von mehreren der vorstehend genannten Strukturen aufweisen. So kann beispielsweise die Architektur des neuronalen Netzes eine Auto-Encoder-Struktur umfassen, um die Dimensionalität der Eingangsdaten zu reduzieren, welche dann weiterhin mit einer anderen Netzstruktur kombiniert werden kann, um beispielsweise Besonderheiten und/oder Anomalien innerhalb der datenreduzierten Dimensionalität zu erkennen bzw. die datenreduzierte Dimensionalität zu klassifizieren.

Die einzelnen Knoten und deren Verbindungen beschreibenden Werte inklusive weiterer ein bestimmtes neuronale Netz beschreibende Werte können beispielsweise in einem das neuronale Netz beschreibenden Wertesatz gespeichert werden. Ein solcher Wertesatz stellt dann beispielsweise eine Ausgestaltung des neuronalen Netzes dar. Wird ein solcher Wertesatz nach einem Training des neuronalen Netzes gespeichert, so wird damit beispielsweise eine Ausgestaltung eines trainierten neuronalen Netzes gespeichert. So ist es beispielsweise möglich, in einem ersten Computersystem das neuronale Netz mit entsprechenden Trainingsdaten zu trainieren, den entsprechenden Wertesatz, welcher diesem neuronalen Netz zugeordnet ist, dann zu speichern und als Ausgestaltung des trainierten neuronalen Netzes in ein zweites System zu transferieren.

Weiterhin kann auch eine Software bzw. ein Computerprogramm, welches ein neuronales Netz realisiert, eine Ausgestaltung des neuronalen Netzes darstellen. Und sowohl eine Variante eines solchen Computerprogramms, welche sowohl zur Inferenz als auch dem Training dieses neuronalen Netzes ausgebildet ist, stellt eine mögliche Ausgestaltung dieses neuronalen Netzes dar, als auch eine Variante eines solchen Computerprogramms, welches nur für eine Inferenz des neuronalen Netzes ausgebildet und eingerichtet und/oder optimiert ist.

Ein neuronales Netz kann beispielsweise trainiert werden, indem über verschiedenste bekannte Lernmethoden durch Eingabe von Eingangsdaten in das neuronale Netz und Analyse der dann entsprechenden Ausgangsdaten aus dem neuronalen Netz Parameterwerte für die einzelnen Knoten oder für deren Verbindungen ermittelt werden. Auf diese Weise kann ein neuronales Netz mit bekannten Daten, Mustern, Reizen oder Signalen auf an sich heute bekannte Weise trainiert werden, um das so trainierte Netz dann nachfolgend beispielsweise zur Analyse weiterer, z.B. nicht zum Training genutzter, Daten verwenden zu können.

Allgemein wird unter dem Training des neuronalen Netzes verstanden, dass die Daten, mit welchen das neuronale Netz trainiert wird, im neuronalen Netz mithilfe eines oder mehrerer Trainings-Algorithmen verarbeitet werden, um so genannte Vorspannungswerte ("Bias"), Gewichtungswerte ("weights") und/oder Transferfunktionen ("Transfer Functions") der einzelnen Knoten des neuronalen Netzes bzw. der Verbindungen zwischen jeweils zwei Knoten innerhalb des neuronalen Netzes zu berechnen bzw. zu verändern.

Zum Training eines neuronalen Netzes, z.B. gemäß der vorliegenden Beschreibung, kann beispielsweise eine der Methoden des so genannten "überwachten Lernens" ("supervised learning") verwendet werden. Hierbei werden einem Netz durch Training mit entsprechenden Trainingsdaten diesen Daten jeweils zugeordnete Ergebnisse oder Fähigkeiten antrainiert. Weiterhin kann zum Training des neuronalen Netzes auch eine Methode des so genannten unüberwachten Trainings ("unsupervised learning") verwendet werden. Ein solcher Algorithmus erzeugt für eine gegebene Menge von Eingaben beispielsweise ein Modell, welches die Eingaben beschreibt und daraus Vorhersagen ermöglicht. Dabei gibt es beispielsweise Clustering-Verfahren, mit welchen sich die Daten in verschiedene Kategorien einteilen lassen, wenn sie sich beispielsweise durch charakteristische Muster voneinander unterscheiden.

Beim Trainieren eines neuronalen Netzes können auch überwachte und unüberwachte Lernmethoden kombiniert werden, beispielsweise wenn Teilen der Daten antrainierbare Eigenschaften oder Fähigkeiten zugeordnet sind, während dies bei einem anderen Teil der Daten nicht der Fall ist.

Weiterhin können auch noch Methoden des so genannten bestärkenden Lernens ("reinforcement learning") für das Training des neuronalen Netzes, zumindest unter anderem, verwendet werden.

Beispielsweise kann ein Training, welches eine relativ hohe Rechenleistung eines entsprechenden Computers erfordert, auf einem hochperformanten System geschehen, während weitere Arbeiten oder Datenanalysen mit dem bereits trainierten neuronalen Netz dann durchaus auf einem niedriger-performanten System durchgeführt werden können. Solche weiteren Arbeiten und/oder Datenanalysen mit dem trainierten neuronalen Netz können zum Beispiel auf einem Edge-Device und/oder auf einer Steuereinrichtung, einer Speicherprogrammierbaren Steuerung oder einer modularen Speicherprogrammierbaren Steuerung oder weiteren entsprechenden Einrichtungen gemäß der vorliegenden Beschreibung erfolgen.

Maschinelles Lernen und/oder die Überwachung eines maschinellen Lernsystems arbeiten in zwei Hauptphasen: Training und Inferenz.

Inferenz ist der Prozess der Generierung eines Ergebnisses des ML-modells durch Eingabe neuer Daten in diese Artefakte/Modelle, um ein Ergebnis zu erzeugen, während die neuen Daten in der Regel nicht für das Training und/oder die Einrichtung des ML-modells verwendet wurden. Z.B. Machine Learning Inferenz ist die Fähigkeit eines maschinellen Lernsystems, Vorhersagen aus neuartigen Daten zu treffen. Es gibt drei Schlüsselkomponenten, die für maschinelles Lernen oder Überwachungsinferenz benötigt werden: eine Datenquelle, ein maschinelles Lern- oder Überwachungssystem zur Verarbeitung der Daten und ein Datenziel.

Training bezieht sich auf den Prozess der Verwendung eines maschinellen Lernalgorithmus zum Erstellen eines Modells. Das Training beinhaltet die Verwendung eines Deep-Learning-Frameworks (z. B. TensorFlow) und eines Trainingsdatensatzes. loT-Daten bieten eine Quelle für Trainingsdaten, die Datenwissenschaftler und Ingenieure verwenden können, um Machine Learning-Modelle für eine Vielzahl von Anwendungsfällen zu trainieren, von der Fehlererkennung bis hin zu Consumer Intelligence.

Inferenz bezieht sich auf den Prozess der Verwendung eines trainierten maschinellen Lernalgorithmus, um eine Vorhersage zu treffen. IoT-Daten können als Eingabe für ein trainiertes Machine Learning-Modell verwendet werden und ermöglichen Vorhersagen, die die Entscheidungslogik auf dem Gerät, am Edge-Gateway oder an anderer Stelle im loT-System steuern können.

Das automatisierte Ermitteln eines weiteren Einstellparametersatzes für die Produktionseinrichtung unter Verwendung des ML-Modells kann dabei derart erfolgen, dass eine automatische Auswertung des trainierten ML-Modells zumindest unter anderem den weiteren Einstellparametersatzes und/oder auch einzelne Daten des weiteren Einstellparametersatzes ergibt.

Dabei kann das automatisierte Ermitteln des weiteren Einstellparametersatzes derart erfolgen, dass vermittels des ML-Modell ein Einstellparametersatz ermittelt wird, welcher zu einem Messparameter führt, welcher ein vorgegebenes oder vorgebbares Qualitätskriterium für die Herstellung des Produkts und/oder das hergestellte Produkt erfüllt. Dabei kann das ML-Modell beispielsweise derart ausgebildet und eingerichtet sein, dass nach dem Eingeben eines Einstellparametersatzes in das ML-Modell durch das ML Modell ein sich daraus ergebender Messparametersatz ausgegeben wird. Das automatisierte Ermitteln des weiteren Einstellparametersatzes kann dann beispielsweise derart erfolgen, dass eine Zahl von Eingabeparametersätzen in das ML-Modell eingegeben wird, und dann jeweils die daraus vorhergesagten Messparametersätze gespeichert, einem Benutzer ausgegeben und/oder an ein Produktionssystem oder ein Produktionseinrichtung übermittelt werden.

Diese Daten können dann automatisiert derart weiter ausgewertet werden, dass dann weitere Einstellparameter derart ausgewählt werden, dass sie zu Messparametern führen, welche ein vorgegebenes oder vorgebbares Qualitätskriterium erfüllen.

Dies kann beispielsweise durch eine entsprechende Interpolation der ermittelten vorhergesagten Messparameter auf Basis der zugrundeliegenden Eingabeparameter erfolgen. Die Ermittlung des weiteren Einstellparametersatzes kann dann durch Vergleich dieser entsprechend durch Interpolation entstandenen Messparameter-Funktion bzw. -Kurve mit dem vorgegebenen oder vorgebbaren Qualitätskriterium für die Messparameter automatisch ermittelt werden.

Ein teilautomatisieres Ermitteln des weiteren Einstellparametersatzes kann beispielsweise derart erfolgen, dass vermittels eines wie vorstehend ausgebildet und eingerichteten Verfahrens mehrere mögliche weitere Einstellparametersätzen ermittelt werden. Dann kann beispielsweise durch einen Bediener daraus ein letztendlich verwendeter weiterer Einstellparametersatz ausgewählt werden.

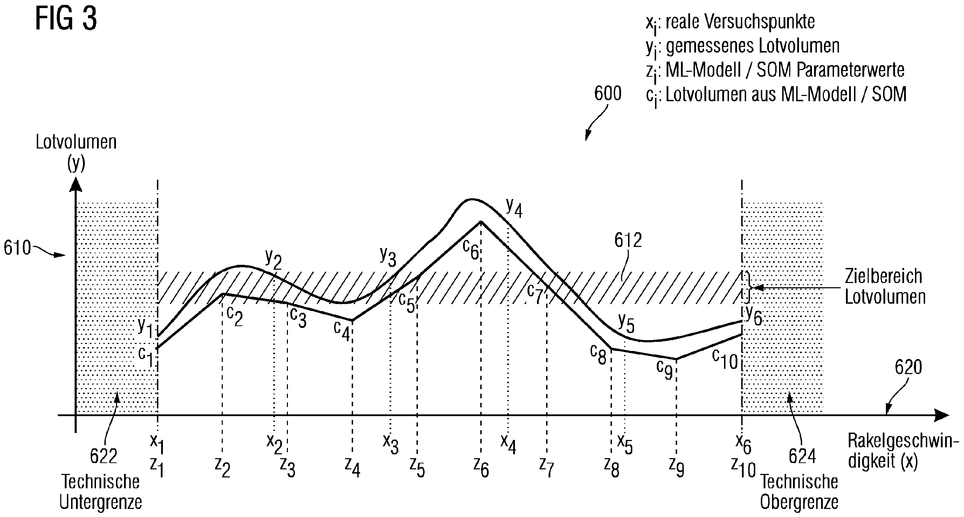

Beispielhafte Ausgestaltungen für eine solche automatisierte und/oder teilautomatisierte Ermittlung des weiteren Einstellparametersatzes werden an andere Stelle der vorliegenden Beschreibung, unter anderem im Zusammenhang mit Fig. 3, noch näher erläutert.

Beispielhaft soll nachfolgend ein automatisiertes oder teilautomatisiertes Ermitteln des weiteren Einstellparametersatzes am Beispiel einer als Self-Organizing Map (SOM) oder als einer sogenannten "modifizierte Self-Organizing Map" (mod-SOM) ausgebildeten ML-Modells beschrieben werden.

Beispielhaft wird hierbei eine als Lotpastendrucker ausgebildet und eingerichtete Produktionseinrichtung betrachtet, wobei die Herstellung eines Produkts als das Bedrucken einer Schaltungsplatine mit Lotpaste ausgebildet und eingerichtet ist.

Als Einstellparameter werden dabei eine Trenngeschwindigkeit, eine Rakelgeschwindigkeit sowie ein Trennabstand gewählt, welche mittelbar oder unmittelbar für jeden Druckvorgang mit dem Lotpastendrucker vorgegeben sind bzw. vorgebbar sind. Diese drei Werte bilden ein Beispiel für einen Einstellparametersatz im Lichte der vorliegenden Beschreibung.

Als ein Messparameter wird im vorliegenden Beispiel ein Lotvolumen eines bestimmten Lot-Pads bzw. eines Lot-Reservoirs oder Lotpasten-Depots auf der Leiterplatte verwendet. Dieser Messparameter ist ein Beispiel für einen Messparametersatz im Lichte der vorliegenden Beschreibung.

Es ist ein Ziel des Einrichtens der Produktionseinrichtung, bzw. des Lotpastendruckers im vorliegenden Beispiel, dass dieses ausgewählte Lot-Pad eine prozentuale Ziel-Lotpastenvolumenfüllung von 100% aufweisen sollte, wobei ein prozentualer Volumen-Bereich zwischen 90% und 110% toleriert wird. Diese vorgegebene oder vorgebbare gewünschte prozentuale Lotpastenvolumenfüllung und/oder auch der vorgegebene gewünschte Lotpasten-Volumenbereich sind jeweils Beispiele für ein Qualitätskriterium gemäß der vorliegenden Beschreibung.

Entsprechende Ziel-Lotpastenvolumina können beispielsweise in einem Bereich von wenigen µm³ bis zu vielen hundert µm³ liegen. Ein Ziel-Lotpastenvolumen kann beispielsweise 100µm³ betragten, und dann beispielsweise ein tolerierter Lotpasten-Volumenbereich zwischen 90µm³ und 110µm³ liegen.

Im ersten der Beispiele ist das ML-Modell als eine Self-Organizing Map (SOM) ausgebildet und eingerichtet.

Dabei bestehen die Gewichtsvektoren der SOM aus dem Einstellparametersatz, umfassend die Trenngeschwindigkeit, die Rakelgeschwindigkeit und den Trennabstand. Weiterhin umfassen die Gewichtsvektoren der SOM jeweils auch noch den Messparametersatz, umfassend die prozentuale Lotpastenvolumenfüllung bzw. das Lotpastenvolumen des ausgewählten Lot-Pads.

Weiterhin liegen aus praktischen Versuchen mit dem Lotpastendrucker Trainingsdaten vor, wobei jeweils zu einem Wertetripel aus Trenngeschwindigkeit, Rakelgeschwindigkeit und Trennabstand eine prozentuale Lotpastenvolumenfüllung bzw. ein Lotpastenvolumen des betreffenden Lot-Pads gemessen wurde. Dazu wurde beispielsweise ein sogenanntes Lotpasten-Inspektionssystem (SPI: solder paste inspection) verwendet.

Vor dem Beginn des Trainings werden die Gewichtsvektoren der SOM mit entsprechenden Zufallswerten vorbelegt.

Die SOM wird nun unter Verwendung der genannten Trainingsdaten gemäß der vorstehenden Beschreibung trainiert, wobei sämtliche der Trainingsdaten, also der Einstellparametersatz sowie der Messparametersatz sowohl zur Ermittlung der Best Matching Unit (BMU) als auch zur Anpassung der Gewichtsvektoren der SOM verwendet werden.

Es ergibt sich damit eine trainierte SOM, welche prozentuale Lotpastenvolumenfüllungen bzw. Lotpad-Volumina jeweils einem Einstellparametersatz in den einzelnen Gewichtsvektoren der SOM zugeordnet. Diese Zuordnung kann nun als eine Funktion gesehen werden, bei der jeweils einem Einstellparametersatz ein Lotpastenvolumen bzw. eine prozentuale Lotpastenvolumenfüllung zugeordnet ist.

Es kann dann beispielsweise vorgesehen sein, dass nachfolgend geprüft wird, welche der Lotpad-Volumina der einzelnen Gewichtsvektoren der trainierten SOM 100µm³ betragen und/oder im Größenbereich zwischen 90 und 110µm³ liegen.

In einer weiteren Ausgestaltung kann vorgesehen sein, dass durch Interpolation gemäß einem der gängigen Interpolationsverfahren eine stetige Funktion des Lotpastenvolumens als Funktion der Einstellparameter gebildet.

Nachfolgend werden aus dieser Funktion automatisiert ein oder mehrere Werte und/oder Wertebereiche für die Einstellparameter identifiziert, in welchen das Lotpastenvolumen bzw. die prozentuale Lotpastenvolumenfüllung 100µm³ bzw. 100% ist und/oder in dem Größenbereich zwischen 90 und 110µm³ bzw. 90 und 110% ist.

In einem automatisierten Verfahren kann beispielsweise vorgesehen sein, dass alle diese Werte bzw. Wertebereiche für die Einstellparameter ausgegeben werden und in einem weiteren automatisierten Schritt daraus ein weiterer Einstellparametersatz ermittelt wird. Dieser kann beispielsweise automatisiert derart geschehen, dass der weitere Einstellparametersatz sich möglichst mittig in einem möglichst breiten Wertebereich befindet, in welchem die prozentuale Lotpastenvolumenfüllung bzw. das Lotpastenvolumen im oben genannten Toleranzbereich zwischen 100% +/- x% bzw. auch zwischen 90 und 110µm³ liegt.

In einer weiteren vorteilhaften Ausgestaltung kann der weitere Einstellparametersatz beispielsweise derart ermittelt werden, dass die Zeit zum Bedrucken einer entsprechenden Schaltungsplatine mit Lotpaste möglichst gering ist, beispielsweise durch das Einstellen einer möglichst hohen Rakelgeschwindigkeit.

In diesem Fall sind die Rakelgeschwindigkeit oder die Zeit zum Bedrucken einer Schaltungsplatine Beispiele für Optimierungsparameter gemäß der vorliegenden Beschreibung. Weiterhin sind eine möglichst große Rakelgeschwindigkeit oder eine möglichst geringe Zeit zum Bedrucken einer Schaltungsplatine Beispiele für Optimierungsziele gemäß der vorliegenden Beschreibung.

In einem teilautomatisierten Verfahren kann beispielsweise vorgesehen sein, dass die vorstehend genannten Werte bzw. Wertebereiche ausgegeben werden und durch einen Bediener des Lotpastendruckers ein weiterer Einstellparametersatz daraus ausgewählt wird.

Im zweiten Beispiel wird wieder der oben genannte Beispielfall einer als Lotpastendrucker ausgebildeten Produktionseinrichtung verwendet, wobei wiederum als Einstellparametersatz dessen Trenngeschwindigkeit, Rakelgeschwindigkeit sowie der Trennabstand verwendet wird, und als Messparametersatz die prozentuale Lotpastenvolumenfüllung bzw. das Lotvolumen eines ausgewählten Lot-Pads.

In diesem zweiten Beispiel ist jetzt das ML-Modell als eine modifizierte Self-Organizing Map (mod-SOM) ausgebildet und eingerichtet.

Dabei bestehen die Gewichtsvektoren der mod-SOM auch wieder aus dem Einstellparametersatz, umfassend die Trenngeschwindigkeit, die Rakelgeschwindigkeit und den Trennabstand. Weiterhin umfassen die Gewichtsvektoren der mod-SOM jeweils auch noch den Messparametersatz, umfassend die prozentuale Lotpastenvolumenfüllung bzw. das Lotpastenvolumen des ausgewählten Lot-Pads.

Auch hier liegen aus praktischen Versuchen mit dem Lotpastendrucker Trainingsdaten vor, wobei jeweils zu einem Wertetripel aus Trenngeschwindigkeit, Rakelgeschwindigkeit und Trennabstand eine prozentuale Lotpastenvolumenfüllung bzw. ein Lotpastenvolumen des betreffenden Lot-Pads gemessen wurde. Dazu wurde beispielsweise ein sogenanntes Lotpasten-Inspektionssystem (SPI: solder paste inspection) verwendet.

Vor dem Beginn des Trainings werden die Gewichtsvektoren der mod-SOM mit entsprechenden Zufallswerten vorbelegt.

Die mod-SOM wird nun unter Verwendung der genannten Trainingsdaten gemäß der vorstehenden Beschreibung trainiert, wobei nur der Einstellparametersatz zur Ermittlung der Best Matching Unit (BMU) verwendet wird. Zur Anpassung der Gewichtsvektoren der mod-SOM werden dann die vollständigen Trainingsdaten umfassend den Einstellparametersatz und den Messparametersatz verwendet.

Es ergibt sich damit eine trainierte mod-SOM, welche Lot-Pad Volumina jeweils einem Einstellparametersatz in den einzelnen Gewichtsvektoren der mod-SOM zugeordnet. Diese Zuordnung kann nun als eine Funktion gesehen werden, bei der jeweils einem Einstellparametersatz ein Lotpastenvolumen zugeordnet ist.

Auch hier kann dann beispielsweise vorgesehen sein, dass nachfolgend geprüft wird, welche der Lotpad-Volumina der einzelnen Gewichtsvektoren der trainierten SOM 100µm³ betragen und/oder im Größenbereich zwischen 90 und 110 µm³ liegen.

In einer weiteren Ausgestaltung kann auch hier vorgesehen sein, dass durch Interpolation gemäß einem der gängigen Interpolationsverfahren eine stetige Funktion des Lotpastenvolumens als Funktion der Einstellparameter gebildet.

Wie vorstehend bereits beschrieben wird entsprechend auch hier in einem automatisierten oder teilautomatisierten Verfahren ein weiterer Einstellparametersatz aus den identifizierten passenden Lotpad-Volumina bzw. der gemäß der o.g. Beschreibung gebildeten Funktion ermittelt.

Entsprechend kann beispielsweise auch ein Verfahren zum Einrichten eines Lötprozesses für Bauelemente auf eine Schaltungsplatine eingerichtet werden. Hier kann eine vorgegebene oder vorgebbare Lötstellen-Qualität (z.B. optisch und/oder elektrisch ermittelt) ein Zielwert eines entsprechenden Verfahrens gemäß der vorliegenden Beschreibung sein. Diese vorgegebene oder vorgebbare Lötstellenqualität ist ein Beispiel für ein Qualitätskriterium gemäß der vorliegenden Beschreibung.

Auch hier kann das ML-Modell beispielsweise als eine SOM oder mod-SOM ausgebildet und eingerichtet sein.

Einstellparameter für einen solchen Lötprozess können beispielweise verschiedene Ofenprofile, bzw. Parameter im Rahmen derartiger Ofenprofile, für einen entsprechenden Lötofen sein.

Entsprechend kann beispielsweise auch ein Verfahren zum Einrichten einer als Spritzguss-Anlage oder Druckguss-Anlage ausgebildeten Produktionseinrichtung eingerichtet werden. Hier kann ein vorgegebenes oder vorgebbares Gewicht eines herzustellenden Produkts beispielsweise ein Zielwert eines entsprechenden Verfahrens gemäß der vorliegenden Beschreibung sein. Dieses vorgegebene oder vorgebbare Produktgewicht ist ein Beispiel für ein Qualitätskriterium gemäß der vorliegenden Beschreibung.

Auch hier kann das ML-Modell beispielsweise als eine SOM oder mod-SOM ausgebildet und eingerichtet sein.

Einstellparameter für eine solche Spritzguß-Anlage oder Druckguss-Anlage können beispielsweise sein:
- Temperatur Werkzeug,
- Temperatur Schmelze,
- Temperatur der Heizzonen,
- Druck an der Düse,
- Motorgeschwindigkeit und -moment beim Dosieren,
- Motorgeschwindigkeit und -moment beim Einspritzen,
- Position beim Umschaltpunkt,
- Kraft beim Umschaltpunkt,
- Einspritzdruck,
- Einspritzgeschwindigkeit,
- Nachdruckzeit,
- Lineare Schneckenkraft - Sollwert (kN),
- Lineare Schneckenkraft beim Umschaltpunkt - Sollwert (kN),
- Motordrehmoment beim Dosieren - Sollwert (Nm),
- Motordrehmoment beim Füllvorgang - Sollwert (Nm),
- Motordrehzahl beim Dosieren - Sollwert (U/min),
- Motordrehzahl beim Füllvorgang - Sollwert (U/min).

Als Messparameter kann in diesem Fall beispielsweise das Produktgewicht, eine Oberflächenstruktur, eine Oberflächenqualität, ein Materialverbrauch, eine Herstellungszeit und/oder eine Produktqualität eines hergestellten Produkts verwendet werden.

Die Gewichtsvektoren der SOM bzw. mod-SOM können dann einen Einstellparametersatz umfassen, welcher einen, mehrere oder alle der vorstehend genannten Einstellparameter umfasst. Weiterhin können die Gewichtsvektoren dann zusätzlich einen Messparametersatz umfassen, der im vorliegenden Beispiel z.B. aus einem Produktgewicht besteht oder dieses umfasst.

Das Ermitteln des weiteren Einstellparametersatzes unter Verwendung einer solchen SOM bzw. mod-SOM erfolgt dann gemäß der vorstehend bereits im Detail erläuterten Vorgehensweise.

In einer vorteilhaften Ausgestaltung kann vorgesehen sein, dass das Verfahren im Anschluss an die Verfahrensschritte a.) und b.) die nachfolgenden Verfahrensschritte umfasst:
c.) Herstellen eines weiteren Produkts mit der Produktionseinrichtung unter Verwendung des weiteren Einstellparametersatzes und Erfassen eines weiteren Messparametersatzes bezüglich des weiteren Produkts,
d.) im Falle, dass der weitere Messparametersatz ein vorgegebenes oder vorgebbares Qualitätskriterium nicht erfüllt: Hinzufügen des weiteren Einstellparametersatzes und/oder des weiteren Messparametersatzes zu den Trainingsdaten und Weiterführen des Verfahrens mit Verfahrensschritt a.).

Weiterhin kann vorgesehen sein, dass das Verfahren nach dem Verfahrensschritt c.) den nachfolgend beschriebenen Verfahrensschritt umfasst:
d1.) im Falle, dass der neue Messparametersatz das vorgegebene oder vorgebbare Qualitätskriterium erfüllt: Herstellung mindestens eines Produkts unter Verwendung des weiteren Einstellparametersatzes.

In einer weiteren vorteilhaften Ausgestaltung kann dieser Verfahrensschritt d1.) weiterhin umfassen: Erfassen eines Messparametersatzes nach der Herstellung von einem oder mehreren des mindestens einen Produkts und dann Fortsetzen des Verfahrens mit Verfahrensschritt d.) und/oder d1.).

Auf diese Weise kann regelmäßig, beispielsweise nach der Herstellung jedes Produkts, oder auch nach der Herstellung mehrerer Produkte, überprüft werden, ob das Qualitätskriterium immer noch eingehalten wird. Wenn sich dabei herausstellt, dass das Qualitätskriterium nicht (mehr) eingehalten wird, können z.B. die Einstellparameter nachjustiert werden - beispielsweise mit einem Verfahren gemäß der vorliegenden Beschreibung.

In einer weiteren vorteilhaften Ausgestaltung kann auch vorgesehen sein, dass im Rahmen des Verfahrensschritts d.) und/oder d1.), oder auch danach, nach der Herstellung jedes hergestellten Produktes ein Messparametersatz erfasst wird und dann das ML-Modell unter Verwendung dieses Messparametersatzes und des zur Herstellung des entsprechenden Produktes verwendeten Einstellparametersatzes weitertrainiert wird.

Dabei kann dann beispielsweise vorgesehen sein, dass nur dann ein neuer Einstellparametersatz mit dem ML-Modell unter Verwendung eines Verfahrens gemäß der vorliegenden Beschreibung ermittelt wird, wenn zu einem entsprechenden Messparametersatz das Qualitätskriterium nicht mehr erfüllt wird. Ansonsten wird der ursprüngliche verwendete weitere Einstellparametersatz weiterverwendet.

Auf diese Weise kann das ML-Modell mit jedem hergestellten Produkt weitertrainiert werden, wobei aber kein neuer Einstellparametersatz ermittelt wird, solange das Qualitätskriterium erfüllt ist. Auf diese Weise kann das ML-Modells beispielsweise im Hintergrund weiter verbessert werden - beispielsweise auch auf einer separaten Recheneinrichtung oder in einer Cloud - während die Ermittlung neuer Einstellparameter nur erfolgt, wenn dies notwendig ist - beispielsweise, weil ein Qualitätskriterium nicht mehr erfüllt ist.

Weiterhin kann vorgesehen sein, dass, z.B. im Rahmen oder nachfolgend Verfahrensschritts c.) oder danach, eine Anzahl von letzten erfassten Messparametersätzen bzw. entsprechenden Testschritten (z.B. 5 Messparametersätze oder Testschritte) hinsichtlich einer Verbesserung bezogen auf das zu optimierende Ziel (z.B. eine Produktqualität und/oder eine zu reduzierende Prozesszeit) zusätzlich untersucht, ausgewertet und/oder betrachtet werden, um z.B. eine bevorzugte weitere Vorgehensweise zu ermitteln. Dabei kann beispielsweise untersucht werden, ob sich im Rahmen der letzten erfassten Messparametersätze eine Verbesserung in Bezug auf eine Erfüllung des Qualitätskriteriums, einer Produktqualität und/oder eines Optimierungsparameters gemäß der vorliegenden Beschreibung ergeben hat.

Dabei dann beispielsweise vorgesehen sein, dass im Falle, dass keine (wesentliche) Verbesserung stattgefunden hat, die Methode, z.B. im Rahmen eines Verfahrens gemäß der vorliegenden Beschreibung, terminiert wird, und/oder eine Herstellung eines oder mehrerer weiterer Produkte, z.B. mit dem letzten ermittelten Einstellparametersatz, oder einem sich aus den letzten verwendeten Einstellparametersätzen ergebender Einstellparametersatz, gestartet wird.

Weiterhin kann vorgesehen sein, dass im Falle, in welchem eine Verbesserung festgestellt wurde, die Methode, beispielsweise im Rahmen eines Verfahrens gemäß der vorliegenden Beschreibung - z.B. weiter ab Verfahrensschritt a.) - weiterhin angewendet wird. Dies kann auch dann vorgesehen sein, wenn bereit ein akzeptierter Mess- und/oder Einststellparametersatz, beispielsweise ein dem Qualitätskriterium entsprechender Messparametersatz und zugehöriger Einstellparametersatz, gefunden wurde.

Weiterhin kann vorgesehen sein, dass das Training des ML-Modells auf einer leistungsfähigeren Recheneinrichtung (z.B. einer höher-performant Recheneinrichtung) erfolgt, während die Bestimmung von Einstellparametern mit dem trainierten ML-Modell dann auf einer weniger leistungsfähigen Recheneinrichtung erfolgt (z.B. einer niedriger-performanten Recheneinrichtung). So kann die Ermittlung neuer Einstellparameter daher im Rahmen eines Steuerungssystems - z.B. durch eine Steuereinrichtung, einen Industrie-PC oder auch ein Edge-Device, erfolgen, während das Training des ML-Modells im Hintergrund in einem leistungsfähigeren Rechner bzw. einer Cloud erfolgen kann, bzw. in einer Cloud erfolgt. Das trainierte ML-Modell kann dann z.B. in das Steuerungssystem heruntergeladen werden bzw. Wird in das Steuerungssystem heruntergeladen.

Das Qualitätskriterium kann ein oder mehrere Kriterien und/oder Werte umfassen, die für eine Qualität des hergestellten Produktes charakteristisch ist. Dabei kann das Qualitätskriterium beispielsweise zulässige Größen und/oder Größenbereiche für einen, mehrere oder alle Messparameter des Messparametersatzes umfassen. Weiterhin kann das Qualitätskriterium einen beliebigen aus Daten des Messparametersatzes generierten Wert bzw. ein beliebiges daraus gewonnenes Kriterium umfassen. Neben einem oder mehreren numerischen Werten kann ein Qualitätskriterium beispielsweise auch das Erzielen einer Farbe, einer Oberflächenstruktur, einer Porosität, eines Produkt-Kriteriums (z.B. einer Produkt-Vollständigkeit oder Produkt-Fehlerlosigkeit) oder vergleichbare Kriterien umfassen

Beispiele für Qualitätskriterien können beispielsweise eine Einhaltung eines vorgegebenen oder vorgebbaren Produktgewichts und/oder einer Oberflächenstruktur bei der Herstellung von Produkten vermittels Spritzguss- oder Druckguss-Anlagen sein - oder beispielsweise auch entsprechende Gewichts-Bereiche eines hergestellten Produkts oder ein oder mehrere Strukturtypen. Weiterhin kann beispielsweise beim Lotpastendruck im Rahmen der Herstellung von Schaltungsplatinen ein einzuhaltendes vorgegebenes oder vorgebbares Lostpastenvolumen (bzw. Volumen) oder eine prozentale Lotpastenvolumenfüllung eines sogenannten Lotpasten-Depots in Bezug auf ein oder mehrere Kontaktpads auf der Platine ein Qualitätskriterium sein. Weiterhin kann auch die Einhaltung entsprechender vorgegebener Volumenbereiche für derartige Lotpasten-Depots ein Qualitätskriterium sein.

Eine Ermittlung, ob das Qualitätskriterium auf Basis des erfassten Messparametersatzes erfüllt ist, kann z.B. durch eine Datenverarbeitungseinrichtung, insbesondere eine Steuereinrichtung, ein Edge-Device, einen Computer, einen Industrie-PC, eine Cloud oder eine vergleichbare Recheneinrichtung erfolgen. Beispielsweise kann die Ermittlung, ob des Qualitätskriterium erfüllt ist, durch eine Steuereinrichtung der Produktionseinrichtung und/oder einer Erfassungs- oder Auswerteeinrichtung für den Messparametersatz erfolgen. Weiterhin kann die Ermittlung auch in einer gesonderten Recheneinrichtung, einem Edge-Device, einem Industrie-PC, einer Cloud oder einer vergleichbaren Recheneinrichtung erfolgen.

Weiterhin kann vorgesehen sein, dass jedem Einstellparametersatz ein Optimierungsparameter zugeordnet oder zuordenbar ist, und dass das automatisierte oder teilautomatisierte Ermitteln des weiteren Einstellparametersatzes derart ausgebildet und eingerichtet ist, dass bei mehreren geeigneten Einstellparametersätzen derjenige als der weitere Einstellparametersatz ausgewählt wird, bei welchem der zugeordnete Optimierungsparameter einem vorgegebenen oder vorgebbaren Optimierungsziel am nächsten kommt. Dabei können die mehreren geeigneten Einstellparametersätze beispielsweise derart ausgebildet und eingerichtet sein, dass die jeweils zugehörigen Messparametersätze alle das vorgegebene oder vorgebbare Qualitätskriterium erfüllen.

Es kann beispielsweise ein Ziel eines in der vorliegenden Beschreibung dargestellten Verfahrens sein, ein Verfahren zum Einrichten einer Produktionseinrichtung zur Verfügung zu stellen, welches es ermöglicht, die Produktionseinrichtung derart einzurichten, dass ein vorgegebenes oder vorgebbares Qualitätskriterium erfüllt wird, bzw. erfüllbar ist.

Die vorstehend erläuterte vorteilhafte Ausgestaltung eines solchen Verfahrens ermöglicht es weiterhin besonders bevorzugte Einstellparameter zum Einrichten der Produktionseinrichtung auszuwählen, wenn es mehrere Möglichkeiten gibt, die Produktionseinrichtung derart einzurichten, dass das vorstehend genannte vorgegebene oder vorgebbare Qualitätskriterium erfüllt ist.

Dies wird im Rahmen der oben genannten Ausgestaltung beispielsweise derart implementiert, dass weiterhin ein Optimierungsziel für das Einrichten der Produktionseinrichtung vorgegeben oder vorgebbar ist, und weiterhin dann diejenigen der infrage kommenden Einstellparameter, bzw. derjenige der in Frage kommenden Einstellparametersätze, ausgewählt werden, welche zu einer Einstellung der Produktionseinrichtung führen, die dem vorgegebenen oder vorgebbaren Optimierungsziel am nächsten kommt.

Hierzu kann beispielsweise jedem Einstellparametersatz ein Optimierungsparameter zugeordnet werden, wobei dann derjenige der Einstellparametersätze ausgewählt wird, für welchen der zugeordnete Optimierungsparameter dem vorgegebenen bzw. vorgebbaren Optimierungsziel am nächsten kommt.

In einer weiterhin vorteilhaften Ausgestaltung kann dann wiederum vorgesehen sein, dass in einem Fall, in welchem mehrere Einstellparametersätze dem Optimierungsziel am nächsten kommen, den Einstellparametersätzen ein weiterer Optimierungsparameter zugeordnet wird oder zuordenbar ist, wobei dann aus diesen Einstellparametersätzen wiederum derjenige ausgewählt wird, welcher einem weiteren vorgegebenen oder vorgebbaren Optimierungsziel am nächsten kommt.

Dieses Prinzip kann dann auch für eine weitere Mehrzahl von Optimierungszielen umgesetzt werden.

Dabei kann ein Optimierungsparameter, welcher einem Einstellparametersatz zugeordnet ist, beispielsweise einer der Einstellparameter des Einstellparametersatzes sein und/oder sich aus einem oder mehreren, oder auch allen, der Einstellparameter des Einstellparametersatzes ergeben. Dies kann beispielsweise derart realisiert sein, dass der Optimierungsparameter aus einem oder mehreren, oder auch allen der Einstellparameter des Einstellparametersatzes besteht, berechnet wird oder auch daraus abgeleitet wird. Ein derartiges Ableiten kann beispielsweise durch entsprechende logische Kombinationen derartiger Werte, eine entsprechende Bildauswertung, ein Entscheidungsbaum, eine Knowledge-Graphen, ein neuronales Netz, eine SOM oder mod-SOM und/oder ein ML-Modell gemäß der vorliegenden Beschreibung realisiert sein, oder zumindest unter Zuhilfenahme derartiger Methoden realisiert werden.

Beispielsweise kann ein Optimierungsparameter einer Herstellungszeit zugeordnet sein. Dies kann beispielsweise derart implementiert sein, dass der Optimierungsparameter unmittelbar einem Geschwindigkeit-entsprechenden Einstellparameter zugeordnet ist. Dies kann, beispielsweise im Fall einer als Lotpastendrucker ausgestalteten Produktionseinrichtung, derart ausgestaltet und eingerichtet sein, dass beispielsweise eine Rakelgeschwindigkeit als Optimierungsparameter herangezogen werden kann. Diesem Optimierungsparameter kann mittelbar eine Herstellungszeit zugeordnet werden, da eine höhere Rakelgeschwindigkeit automatisch eine geringere Herstellungszeit zur Folge hat.

Weiterhin kann auch aus einem oder mehreren der Einstellparameter eine Herstellungszeit und/oder eine einer Herstellungszeit zugeordnete Größe beispielsweise auf eine der vorstehend genannten Arten ermittelt werden.

Dass ein Optimierungsparameter einem Einstellparametersatz zugeordnet ist, kann weiterhin derart ausgebildet und eingerichtet sein, dass der Optimierungsparameter beispielsweise im Rahmen der Herstellung eines Produkts unter Verwendung des genannten Einstellparametersatzes ermittelt wurde, bzw. ermittelt wird. Eine derartige Ermittlung kann beispielsweise derart ausgebildet und eingerichtet sein, dass der Optimierungsparameter beispielsweise unmittelbar gemessen wird, beispielsweise durch einen entsprechenden Sensor oder Soft-Sensor, oder auch eine entsprechende Kamera. Weiterhin kann sich der Optimierungsparameter auch aus einer Auswertung derartiger gemessener Sensordaten ergeben, beispielsweise durch eine Berechnung oder eine der oben genannten Verfahren (Z.B. Ein Entscheidungsbaum, ein Knowledge-Graph, ein ML-Modell gemäß der vorliegenden Beschreibung oder Ähnliches).

Dass ein Optimierungsparameter einem Einstellparametersatz zugeordnet ist, kann auch derart ausgebildet und eingerichtet sein, dass eine Simulation der Produktionseinrichtung, beispielsweise eine Simulation der Herstellung eines Produkts, unter Verwendung des Einstellparametersatzes erfolgt, und der Optimierungsparameter im Rahmen dieser Simulation ermittelt wird. Dies kann beispielsweise derart realisiert sein, dass im Rahmen der Simulation der Produktionseinrichtung ein sogenannter Soft-Sensor definiert ist, und der Optimierungsparameter einem Ausgabewert dieses Soft-Sensors entspricht, oder aus einem oder mehreren derartiger Softsensor-Werte ermittelt oder abgeleitet wird.

Ein Optimierungsziel kann beispielsweise ein bestimmter Zielbereich für einen Optimierungsparameter, ein bestimmter Zielwert eines Optimierungsparameters, eine bestimmte Ziel-Eigenschaft und/oder ein bestimmtes Ziel-Aussehen eines Optimierungsparameters sein oder umfassen.

So kann beispielsweise ein Optimierungsziel eine möglichst geringe Herstellungszeit sein. Weiterhin kann ein Optimierungsziel auch ein möglichst geringer Energieverbrauch oder eine möglichst geringe CO2-Erzeugung für die Herstellung eines Produkts sein. Weiterhin kann ein Optimierungsziel auch eine Kombination aus einer möglichst geringen Herstellungszeit kombiniert mit einem möglichst geringen Energieverbrauch und/oder einer möglichst geringen CO2-Erzeugung sein.

Dabei kann sich das Optimierungsziel beispielsweise auf das Produkt und/oder auf die Herstellung des Produkts mit der Produktionseinrichtung beziehen. Weiterhin kann sich das Optimierungsziel auch auf einen oder mehrere Teilprozesse der Herstellung des Produkts beziehen. Ein Optimierungsziel kann sich beispielsweise auch auf das hergestellte Produkt selbst beziehen. Weiterhin kann sich das Optimierungsziel auch auf ein Endprodukt eines Gesamtverfahrens beziehen, oder auch auf das Gesamtverfahren selbst, wobei die genannte Herstellung des Produkts mit der Produktionseinrichtung nur einen Teil des Gesamtverfahrens darstellen kann.

Zudem kann vorgesehen sein, dass der Optimierungsparameter einen der Herstellung des Produkts zugeordnete Produktionszeitparameter umfasst, und das Optimierungsziel eine vorgegebene oder vorgebbare Produktionszeit ist oder dieses Kriterium umfasst, insbesondere eine möglichst geringe Produktionszeit ist oder dieses Kriterium umfasst,
und/oder,
dass der Optimierungsparameter einen der Herstellung des Produkts zugeordnete Energieverbrauchsparameter umfasst, und das Optimierungsziel ein vorgegebener oder vorgebbarer Energieverbrauch ist oder dieses Kriterium umfasst, insbesondere ein möglichst geringer Energieverbrauch ist oder dieses Kriterium umfasst.

Der Produktionszeit-Parameter kann dabei entweder eine Produktionszeit, bzw. ein einer Produktionszeit zugeordneter Parameter (z.B. eine Geschwindigkeit, beispielsweise eine Rakelgeschwindigkeit bei einem Lotpastendrucker) sein, oder auch eine Kombination einer Produktionszeit mit einem oder mehreren weitern Parametern. Solche weiteren Parameter können beispielsweise ein Energieverbrauch, ein CO2-Ausstoß, ein Materialverbrauch, Produktionskosten, oder weitere beispielsweise derartigen Werten jeweils zugeordneter Parameter sein.

Eine Energieverbrauchs-Parameter kann beispielsweise ein Energieverbrauchswert und/oder ein einem Energieverbrauch zugeordneter Parameter sein, oder auch eine Kombination eines Energieverbrauchs mit einem oder mehreren weiteren Parametern, Z. B. Einer Produktionszeit, einem CO2-Ausstoß, eine Materialverbrauch, Produktionskosten, und/oder einem derartigen Werten jeweils zugeordneter Parameter sein.

Eine Kombination aus einem Produktionszeit- und Energieverbrauchs-Parameter kann zum Beispiel als eine Summe oder ein Produkt eines einer Produktionszeit zugeordneten Parameters und eines einem Energieverbrauch zugeordneten Parameters ausgebildet und eingerichtet sein bzw. einer solchen Summe bzw. einem solchen Produkt entsprechen. Dabei kann ein Optimierungsziel sein, dass eine solche Summe bzw. Ein solches Produkt einen möglichst geringen Wert aufweisen soll. Weiterhin kann eine Kombination aus Produktionszeit- und Energieverbrauchs-Parametern sich aus einer beliebigen mathematischen Operation eines entsprechenden einer Produktionszeit zugeordneten Parameters und eines einem Energieverbrauch zugeordneten Parameters ergeben. Weiterhin kann eine Kombination aus einem Produktionszeit- und Energieverbrauchs-Parameter auch beispielsweise unter Verwendung eines ML-Modells gemäß der vorliegenden Beschreibung ermittelt werden.

Es kann auch vorgesehen sein, dass dem Produkt ein zweiter Messparametersatz zugeordnet ist,
dass in Verfahrensschritt a.) weiterhin ein zweites ML-Modell unter Verwendung von zweiten Trainingsdaten, umfassend den Einstellparametersatz und/oder den zweiten Messparametersatz, trainiert wird,
dass in Verfahrensschritt b.) der weitere Einstellparametersatz unter Verwendung des ML-Modells und des zweiten ML-Modells ermittelt wird,
dass in Verfahrensschritt c.) ein weiterer zweiten Messparametersatz bezüglich des weiteren Produkts ermittelt wird, und
dass in Verfahrensschritt d.) das Verfahren dann mit Verfahrensschritt a.) weitergeführt wird, wenn der weitere Messparametersatz das Qualitätskriterium nicht erfüllt oder der weitere zweite Messparametersatz das zweite Qualitätskriterium nicht erfüllt.

Dass in Verfahrensschritt d.) das Verfahren dann mit Verfahrensschritt a.) weitergeführt wird, wenn der weitere Messparametersatz das Qualitätskriterium nicht erfüllt oder der weitere zweite Messparametersatz das zweite Qualitätskriterium nicht erfüllt, kann derart ausgestaltet und eingerichtet sein, dass in Verfahrensschritt d.) das Verfahren dann mit Verfahrensschritt a.) weitergeführt wird, wenn der weitere Messparametersatz das Qualitätskriterium nicht erfüllt, der weitere zweite Messparametersatz das zweite Qualitätskriterium nicht erfüllt, oder sowohl der weitere Messparametersatz das Qualitätskriterium nicht erfüllt als auch der weitere zweite Messparametersatz das zweite Qualitätskriterium nicht erfüllt.

Diese Ausgestaltung des Verfahrens ermöglicht es, dass mit einem zweiten ML-Modell ein zweiter Messparametersatz in die Auswahl eines weiteren Einstellparametersatzes eingebunden ist oder einbindbar wird. Auf diese Weise wird das Verfahren zum Einrichten einer Produktionseinrichtung weiter verbessert, da so eine größere Zahl von relevanten Parametern für das produzierte Produkt und/oder dessen Herstellungsprozess berücksichtigt werden kann.

In einer vorteilhaften Ausgestaltung kann dabei das zweite ML-Modell als eine Self Organizing Map (SOM) gemäß der vorliegenden Beschreibung oder eine modifizierte Self-Organizing Map (Mod-SOM) gemäß der vorliegenden Beschreibung ausgebildet und eingerichtet sein.

In einer weiterhin vorteilhaften Ausgestaltung kann weiterhin sowohl das ML-Modell als auch das zweite ML-Modell als eine SOM ausgebildet und eingerichtet sein. Weiterhin kann auch vorgesehen sein, dass sowohl das ML-Modell als auch das zweite ML-Modell als Mod-SOM ausgebildet und eingerichtet ist.

Da das Training einer SOM oder Mod-SOM im Vergleich zu manchen anderen ML-Modellen (z.B. "deep neural networks" mit vielen Schichten und Knoten/Schicht) in der Regel weniger Rechenleistung erfordert, können auf diese Weise vergleichsweise ressourcenschonend weitere Messparametersätze beim Einrichten der Produktionseinrichtung berücksichtigt werden.

Im Falle beispielsweise einer als Lotpastendrucker ausgebildeten Produktionseinrichtung kann beispielsweise vorgesehen sein, dass ein erster Messparametersatz ein erstes Lot-Depot an einer ersten Stelle der Leiterplatte betrifft und ein zweiter Messparametersatz ein zweites Lot-Depot an einer zweiten Stelle der Leiterplatte. Auf diese Weise kann durch das beschriebene Verfahren erreicht werden, dass Einstellparameter gefunden werden, welche ein korrektes Lot-Depot sowohl an der ersten als auch in der zweiten Stelle der Leiterplatte erzeugt.

Dieses Prinzip kann auch für weitere Messparametersätze und entsprechend weitere ML-Modelle erweitert werden, sodass auf diese Weise unter Verwendung einer Vielzahl von ML-Modellen und einer entsprechenden Vielzahl von Messparametersätzen ein qualitativ sehr hochwertiger Herstellungsprozess für die Produktionseinrichtung einrichtbar ist.

Wiederum am Beispiel einer als Lotpastendrucker ausgebildeten Produktionseinrichtung kann dies beispielsweise derart ausgebildet und eingerichtet sein, dass Messparametersätze für eine Vielzahl von auf der Leiterplatte verteilten Lot-Depots verwendet werden und auf die vorstehend erläuterte Weise dann ein Einstellparametersatz für den Lotpastendrucker gefunden werden kann, welcher an allen diesen Stellen korrekt ausgebildete Lot-Depots erzeugt.

In einer weiteren vorteilhaften Modifikation der vorstehend genannten Ausgestaltung kann vorgesehen sein, dass wiederum zwei ML-Modelle vorgesehen sind. Dabei werden dann beide ML-Modelle unter Verwendung eines Verfahrens gemäß der vorliegenden Beschreibung so lange jedes für sich trainiert, bis der weitere Messparametersatz das Qualitätskriterium erfüllt und der weitere zweite Messparametersatz das zweite Qualitätskriterium erfüllt. Dann wird aus den dann gefundenen Einstellparametersätzen ein gemeinsamer Parametersatz ermittelt.

Dadurch, dass jeweils für jeden der neuen Messparametersätze auch ein neues ML-Modell herangezogen wird, kann der Aufwand durch Berücksichtigung neuer Messparametersätze dadurch reduziert werden, dass beispielsweise eine Softwareapplikation für die Berücksichtigung eines Messparametersatzes unter Verwendung eines ML-Modells erstellt wird, und dann diese Softwareapplikation für jeden weiteren Messparametersatz entsprechend repliziert wird.

Der zweite Messparametersatz kann dabei beispielsweise für einen weiteren und/oder anderen Bereich des Produkts relevant sein (z.B. einen weiteren Bereich einer mit Lotpaste zu bedruckenden Leiterplatte oder einen weiteren Bereich eines mit Spritzguss- oder Druckguss hergestellten Produkts). Weiterhin kann der zweite Messparametersatz auch bezüglich einer anderen Messmethode, einer anderen Eigenschaft, einer anderen Sensorik, einer anderen Produktkomponente, einer anderen Produkt-Baugruppe oder eines vergleichbaren anderen Unterschieds ermittelt werden.

In einer weiteren vorteilhaften Ausgestaltung kann vorgesehen sein, dass ein Auswahlschritt vorgesehen ist oder erfolgt, ob anstatt Verfahrensschritt b.) der nachfolgend genannte Verfahrensschritt b1.) ausgeführt werden soll:
b1.) Randomisierte oder Teil-Randomisierte Auswahl eines weiteren Einstellparametersatzes.

Ein Einführen eines derartigen Auswahlschritt ermöglicht es, ein verbessertes Training für das ML-Modell, das weitere ML-Modell, ein zweites ML-Modell oder sonstige beteiligte ML-Modelle zu implementieren. So kann bei Auswahl der Option der Verwendung eines randomisierten oder teil-randomisierten Auswählens eines weiteren Einstellparametersatzes, beispielsweise ein möglicher Zahlenbereich für die Einstellparameter bzw. gewisse Einstellparameter konsequenter abgedeckt werden.

Dabei kann vorgesehen sein, dass nach Ausführen des Verfahrensschritts b1.) das Verfahren beispielsweise mit einem Verfahrensschritt c.) weitergeführt. Weiterhin kann vorgesehen sein, dass danach auch noch ein Verfahrensschritt d.) gemäß der vorliegenden Beschreibung ausgeführt wird. Alternativ kann auch vorgesehen sein, dass unmittelbar nach Verfahrensschritt c.) wiederum Verfahrensschritt a.) gemäß der vorliegenden Beschreibung ausgeführt wird.

Alternativ kann beispielsweise auch vorgesehen sein, dass nach Ausführen des Verfahrensschritts b1.) das Verfahren mit Verfahrensschritt a.) weitergeführt wird. Für ein im Verfahrensschritt a.) durchgeführtes Training eines entsprechenden ML-Modells kann dann, beispielsweise bei Verwendung eines Messparametersatzes, ein aus den bereits bekannten Messparametern über eine Interpolation oder Regression ermittelter Messparametersatz verwendet werden.

Der Auswahlschritt kann beispielsweise derart ausgebildet und eingerichtet sein, dass ein Rhythmus, nach welchen ausgewählt wird, ob anstatt Verfahrensschritt b.) Verfahrensschritt b1.) durchgeführt wird, festgelegt ist. Weiterhin kann der Auswahlschritt durch eine Zufallsauswahl realisiert sein, zum Beispiel abhängig von der Anzahl der vorhandenen Trainingsdaten. Dies kann beispielsweise derart ausgestaltet sein, dass bei wenigen Trainingsdaten eine hohe Wahrscheinlichkeit für die Auswahl des Schritts b1.) besteht, während bei vielen Trainingsdaten eine geringere Wahrscheinlichkeit für eine Auswahl des Verfahrensschritts b1.) anstatt des Verfahrensschritt b.) verwendet wird.

Eine "randomisierte Auswahl" kann als eine zufällige Auswahl von Einstellparametern ausgebildet und eingerichtet sein. Eine solche Auswahl kann beispielsweise verwendet werden, um sicherzustellen, dass keine systematischen Muster oder Voreingenommenheiten bei der Auswahl von Einstellparametern auftreten, oder dass beispielsweise tatsächlich ein globales Optimum gefunden wird und nicht nur ein oder mehrere lokale Optima.

Beispielsweise kann im Zusammenhang mit der Ermittlung von Einstellparametern für eine Produktionseinrichtung die randomisierte Auswahl bedeuten, dass die Zahlenwerte auf eine Weise ausgewählt werden, die keine vorhersehbare Reihenfolge oder Muster aufweist. In diesem Zusammenhang ist es wichtig, dass die randomisierte Auswahl von Zahlenwerten die Möglichkeit bietet, verschiedene Einstellparameter auf eine breite und repräsentative Weise zu testen, um eine Prozessstabilität und -genauigkeit zu optimieren. Durch die Verwendung von randomisierten Auswahlmethoden wie z.B. der "Latin Hypercube"-Methode oder Monte-Carlo-Simulation können potenzielle systematische Fehler vermieden werden, die auftreten könnten, wenn die Auswahl nicht zufällig erfolgt.

Der Begriff "teil-randomisierte Auswahl" bedeutet in diesem Zusammenhang, dass nicht alle Auswahlprozesse für Einstellparameter vollständig zufällig sind, sondern dass bestimmte Einschränkungen oder Muster bei der Auswahl bestehen. Dies kann z.B. bedeuten, dass während des Auswahlprozesses bestimmte Regeln, Kriterien oder Vorgaben berücksichtigt werden, die die vollständige Zufälligkeit einschränken.

Weiterhin kann die Teil-Randomisierte Auswahl von Einstellparametern auch derart ausgebildet und eingerichtet sein, dass ein Teil der Einstellparameter randomisiert ausgewählt wird und dann die verbleibenden verwendeten Einstellparametern derart ausgewählt werden, dass sich ein sinnvoller und/oder stimmiger Herstellungsprozess ergibt.

Im Kontext der Ermittlung von Einstellparametern für eine Produktionseinrichtung kann eine teil-randomisierte Auswahl beispielsweise bedeuten, dass bestimmte Parameter oder Variablen gezielt ausgewählt oder eingeschränkt werden, um spezifische Aspekte des Herstellprozesses zu berücksichtigen. Dies kann dazu dienen, die Auswahl auf relevante Bereiche zu fokussieren oder bestimmte Szenarien gezielt zu erforschen, anstatt eine vollständig zufällige und ungewichtete Auswahl vorzunehmen.

Die randomisierte bzw. teil-randomisierte Auswahl von Einstellparametern kann beispielsweise unter Verwendung eine Latin-Hypercube-Sampling-Struktur bzw. einer Latin-Hypercube-Methode erfolgen.

Die "Latin Hypercube"-Methode ist dabei eine Technik zur randomisierten Auswahl von

Zahlenwerten, die häufig in der statistischen Versuchsplanung und der Modellierung verwendet wird. Bei dieser Methode werden die Eingangsvariablen in gleich große Intervalle aufgeteilt, und dann wird eine zufällige Auswahl von Werten aus jedem Intervall getroffen, wobei sichergestellt wird, dass jeder Wert nur einmal ausgewählt wird. Dadurch entsteht eine Matrix von zufälligen Zahlenwerten, die eine gleichmäßige Abdeckung des gesamten Wertebereichs ermöglicht.

Eine weitere, durchaus vergleichbare Auswahlmethode ist die Monte-Carlo-Simulation, bei der Zufallszahlen generiert werden, um verschiedene Szenarien zu modellieren und zu analysieren. Eine weitere Methode ist die Quasi-Monte-Carlo-Methode, die spezielle Sequenzen von Zahlenwerten verwendet, um eine gleichmäßige Verteilung zu erzielen. Andere Beispiele für derartige Auswahlmethoden sind Sobol-Sequenzen und/oder Halton-Sequenzen, die ebenfalls zur randomisierten Auswahl von Zahlenwerten verwendet werden, insbesondere in der numerischen Integration und der Optimierung.

Es kann auch vorgesehen sein, dass, insbesondere wenn der neue Messparametersatz das Qualitätskriterium erfüllt, nach Verfahrensschritt d.) ein weiterer Auswahlschritt erfolgt, ob nach dem Auswahlschritt:
Verfahrensschritt e1.): eine Herstellung eines Produkts unter Verwendung des weiteren Einstellparametersatzes,
   und/oder
Verfahrensschritt e2.): ein Hinzufügen des weiteren Einstellparametersatzes und/oder des weiteren Messparametersatzes zu den Trainingsdaten und Weiterführen des Verfahrens mit Verfahrensschritt a.), erfolgt.

Die Verfahrensschritte e1.) und/oder e2.) stellen Optionen dar, wie verfahren werden kann, wenn der weitere Messparametersatz das Qualitätskriterium erfüllt. In diesem Fall können beispielsweise, wie in Verfahrensschritt e1.) dargestellt, ein oder mehrere weitere Produkte unter Verwendung des weiteren Einstellparametersatzes hergestellt werden.

Weiterhin kann, wie in Verfahrensschritt e2.) spezifiziert, das Verfahren trotzdem mit Verfahrensschritt a.) fortgeführt werden, obwohl das Qualitätskriterium eigentlich bereits erfüllt ist. Dies kann beispielsweise erfolgen, wenn eine weitere Verbesserung oder Optimierung des Einstellparametersatzes gewünscht ist oder versucht werden soll.

Dabei kann die Auswahl, ob nach Verfahrensschritt d.) Verfahrensschritt e1.) und/oder Verfahrensschritt e2.) ausgeführt wird, beispielsweise zufällig erfolgen, in einem bestimmten Rhythmus erfolgen, oder auch abhängig von weiteren Qualitätskriterien oder Einschätzungen erfolgen.

Weiterhin kann vorgesehen sein, dass das ML-Modell und/oder das zweite ML-Modell jeweils als eine "Self-Organizing Map" (SOM) oder eine "modifizierte Self-Organizing Map" (mod-SOM) ausgebildet und eingerichtet ist.

Dabei wird in Bezug auf Erläuterungen, Anwendungen und/oder Ausgestaltungen einer SOM oder Mod-SOM auf die Erläuterungen zu diesen "Self Organizing Maps" bzw. "Modifizierten Self Organizing Maps" an anderer Stelle der vorliegenden Beschreibung verwiesen.

Dabei kann beispielsweise vorgesehen sein, dass ein ML-Modell, ein zweites ML-Modell, eine SOM und/oder eine Mod-SOM auf einer Recheneinrichtung, einer Cloud, einer Steuereinrichtung, einem Steuerungsmodul, einer speicherprogrammierbaren Steuerung oder einem sogenannten EDGE-Device abläuft bzw. installiert oder implementiert ist.

Dabei kann vorgesehen sein, dass sowohl das Training eines solchen ML-Modells, eines zweiten ML-Modells, einer SOM und/oder einer Mod-SOM als auch die entsprechende Inferenz auf einer der genannten Einrichtungen bzw. Devices abläuft. Es kann auch vorgesehen sein, dass insbesondere das Training eines ML-Modells, eines zweiten ML-Modells, einer SOM und/oder einer Mod-SOM gemäß der vorliegenden Beschreibung auch in einer Cloud erfolgt. Weiterhin kann vorgesehen sein, dass die Inferenz und das Training eines ML-Modells, eines zweiten ML-Modells, einer SOM und/oder einer Mod-SOM auf verschiedenen der genannten Einrichtungen oder Devices erfolgt.

Die Recheneinrichtung kann beispielsweise als ein Computer, ein EDGE-Device, eine PLC, eine virtuelle PLC, ein- oder mehrere Module einer PLC oder virtuellen PLC, eine Steuereinrichtung, eine Cloud, ein Automatisierungs-Server, eine Steuer Applikation in einer Cloud oder als eine vergleichbare Recheneinrichtung ausgebildet und eingerichtet sein oder derartigen Komponenten umfassen. Die Recheneinrichtung kann auch als ein System aus mehreren der vorstehend genannten Komponenten ausgebildet und eingerichtet sein, die kommunikativ gekoppelt sind bzw. sein können.

Die Steuereinrichtung kann jede Art von Computer oder Computersystem sein, welcher zur Steuerung einer Vorrichtung, einer Maschine, einer Anlage, eines Apparats, einer Komponente oder eines Geräts ausgebildet und eingerichtet ist. Bei der Steuerung kann es sich auch um einen Computer, ein Computersystem oder eine sogenannte Cloud handeln, auf der eine Steuerungssoftware oder eine Steuerungssoftware-Anwendung, zum Beispiel eine Steuerungsanwendung, implementiert, instanziiert oder installiert ist. Eine solche auf einem Computer oder in einer Cloud implementierte Steuerungsanwendung kann z.B. als eine oder mehrere Applikationen mit der Funktionalität einer speicherprogrammierbaren Steuerung ausgebildet und eingerichtet sein.

Die Steuereinrichtung kann weiterhin auch als ein sogenanntes Edge-Device ausgebildet und eingerichtet sein, wobei ein solches Edge-Device beispielsweise eine Applikation zur Steuerung von Vorrichtungen oder Anlagen umfassen kann. Beispielsweise kann eine solche Applikation als eine Applikation mit der Funktionalität einer speicherprogrammierbaren Steuerung ausgebildet und eingerichtet sein. Das Edge-Device kann dabei beispielsweise mit einer weiteren Steuereinrichtung einer Vorrichtung oder Anlage verbunden sein oder auch unmittelbar mit einer zu steuernden Vorrichtung oder Anlage. Weiterhin kann das Edge-Device derart ausgebildet und eingerichtet sein, dass es zusätzlich noch mit einem Datennetzwerk oder einer Cloud verbunden ist bzw. zur Verbindung mit einem entsprechenden Datennetzwerk oder einer entsprechenden Cloud ausgebildet und eingerichtet ist.

Die Steuereinrichtung kann beispielsweise auch als eine sogenannte speicherprogrammierbare Steuerung (SPS) ausgebildet und eingerichtet sein (im Englischen "programmable logic controller" bzw. PLC). Weiterhin kann die Steuereinrichtung auch als eine sogenannte modulare speicherprogrammierbare Steuerung (modulare SPS) eingerichtet und ausgestaltet sein.

Die Steuereinrichtung kann dabei ein Steuerungsmodul oder Zentralmodul umfassen, welche zum Ablauf eines Steuerprogramms ausgebildet und eingerichtet ist. Dabei kann das Steuerungsmodul beispielsweise die durch den Standard IEC 61131 definierte Funktionalität umfassen.

Dabei kann das Steuerungsmodul beispielsweise auch als eine Software-Applikation ausgebildet und eingerichtet sein, welche zum Echtzeit-Ablauf eines Steuerprogramms zur Steuerung der Bearbeitungskomponente ausgebildet und eingerichtet ist. Dabei kann die Software-Applikation beispielsweise die im Standard IEC 61131 und/oder IEC 61499 definierte Funktionalität umfassen.

Das Steuerungsmodul kann weiterhin auch als ein separates mechanisches Modul oder eine separate Baugruppe ausgebildet und eingerichtet sein, welche zum Echtzeitablauf eines Steuerprogramms ausgebildet und eingerichtet ist. Auch ein solches mechanisches Modul bzw. eine derartige Baugruppe kann beispielsweise die durch den Standard IEC 61131 und/oder IEC 61499 definierte Funktionalität umfassen. Beispielsweise kann das Steuerungsmodul als speicherprogrammierbare Steuerung selbst oder beispielsweise als ein Zentralmodul einer modularen speicherprogrammierbaren Steuerung ausgebildet und eingerichtet sein. Dabei kann das Steuerungsmodul beispielsweise die Funktionalität einer Eingabe-Ausgabe-Baugruppe umfassen oder auch keine Funktionalität einer Eingabe-Ausgabe-Baugruppe umfassen.

Bei einer speicherprogrammierbaren Steuerung, kurz SPS, handelt es sich um eine Komponente, die programmiert und eingesetzt wird, um eine Anlage oder Maschine zu regeln bzw. zu steuern. In SPSen können spezifische Funktionen wie beispielsweise eine Ablaufsteuerung implementiert werden, so dass auf diese Weise sowohl die Eingangs- als auch die Ausgangssignale von Prozessen oder Maschinen gesteuert werden können. Definiert wird die speicherprogrammierbare Steuerung beispielsweise im Standard IEC 61131 und/oder IEC 61499.

Um eine speicherprogrammierbare Steuerung an die Anlage bzw. Maschine anzubinden, kommen sowohl Aktoren, die im Allgemeinen an den Ausgängen der speicherprogrammierbaren Steuerung angeschlossen sind, als auch Sensoren zum Einsatz. Des Weiteren werden Statusanzeigen verwendet. Grundsätzlich befinden sich die Sensoren an den SPS-Eingängen, wobei durch sie die speicherprogrammierbare Steuerung Informationen über den aktuellen Ist-Zustand der Anlage erhält. Als Sensoren gelten beispielsweise: Lichtschranken, Endschalter, Taster, Inkrementalgeber, Füllstandsensoren, Temperaturfühler. Als Aktoren gelten z.B.: Schütze zum Einschalten elektrischer Motoren, elektrische Ventile für Druckluft oder Hydraulik, Antriebssteuerungsmodule, Motoren, Antriebe.

Die Realisierung einer SPS kann auf verschiedene Art und Weise erfolgen. Das heißt, sie kann als elektronisches Einzelgerät, als Softwareemulation, als sogenannte "virtuelle PLC" oder "Soft-PLC", als PC-Einsteckkarte usw. verwirklicht werden. Zudem sind auch modulare Lösungen möglich, im Rahmen derer die SPS aus mehreren Modulen zusammengebaut wird. Solche Module können beispielsweise ein zentrales Steuerungsmodul, ein Eingabe-AusgabeModul, ein Kommunikationsmodul, ein Umrichter Modul, ein Applikationsmodul oder vergleichbare Module sein.

Unter einer virtuellen PLC oder einer sogenannten Soft-PLC wird eine speicherprogrammierbare Steuerung verstanden, welche als Softwareapplikation realisiert ist und auf einer Computereinrichtung, einem Industrie-PC oder sonstigen PC, einer Recheneinrichtung, oder z.B. auch einem EDGE Device, ablaufen kann oder abläuft. Auch in diesem Fall gibt es die Möglichkeit eine virtuelle PLC oder Soft-PLC modular auszuführen. Dabei werden dann einzelne Funktionalitäten einer speicherprogrammierbaren Steuerung bzw. PLC als einzelne Software-Module ausgestaltet, welche über eine sogenannte Middleware verbindbar oder verbunden sind. Solche Module können beispielsweise ein zentrales Steuerung-Software Modul (Z.B. Welche zumindest unter anderem die vom Standard IEC 61131 vorgegebenen Eigenschaften umfasst), ein Kommunikationsmodul zur Ankopplung an einen Feldbus, an bestimmte Geräte oder Vorrichtungen, an ein Ethernet, einen OPC-UA oder vergleichbare Kommunikationsstandards, ein Webserver-Modul, ein HMI-Modul (HMI: human machine interface) und/oder ein Applikationsmodul gemäß der vorliegenden Beschreibung sein.

Eine modulare speicherprogrammierbare Steuerung kann dabei derart ausgebildet und eingerichtet sein, dass mehrere Module vorgesehen sein können oder sind, wobei in der Regel neben einem sogenannten Zentralmodul (das auch als Steuerungs-Zentralmodul oder CPU bezeichnet wird) das zum Ablauf eines Steuerprogramms z.B. zur Steuerung einer Komponente, Maschine oder Anlage (bzw. eines Teils davon) ausgebildet und eingerichtet ist, ein oder mehrere Erweiterungsmodule vorgesehen sein können. Solche Erweiterungsmodule können beispielsweise als eine Strom-/Spannungsversorgung ausgebildet und eingerichtet sein oder auch zur Ein- und/oder Ausgabe von Signalen oder weiterhin auch als ein Funktionsmodul oder Applikationsmodul zur Übernahme spezieller Aufgaben (z.B. ein Zähler, ein Umrichter, Datenverarbeitung mit künstliche-Intelligenz-Methoden (umfasst z.B. ein Neuronales Netz oder ein anderes ML-Modell) ...). Im vorliegenden Fall kann beispielsweise vorgesehen sein, dass ein Prozess-ML-Modell in einem solchen Modul für eine speicherprogrammierbare Steuerung implementiert ist.

Beispielsweise kann ein Funktionsmodul oder Applikationsmodul auch als ein Al-Modul zur Ausführung von Aktionen unter Verwendung künstlicher Intelligenz-Verfahren ausgebildet und eingerichtet sein. Ein solches Funktionsmodul kann beispielsweise ein Neuronales Netz oder ein ML-Modell gemäß der vorliegenden Beschreibung oder ein weiteres ML-Modell gemäß der vorliegenden Beschreibung umfassen.

Ein Edge-Device oder Edge-Gerät kann beispielsweise eine Applikation zur Steuerung von Vorrichtungen oder Anlagen umfassen kann. Beispielsweise kann eine solche Applikation als eine Applikation mit der Funktionalität einer speicherprogrammierbaren Steuerung ausgebildet und eingerichtet sein. Das Edge-Device kann dabei beispielsweise mit einer weiteren Steuereinrichtung einer Vorrichtung oder Anlage verbunden sein oder auch unmittelbar mit einer zu steuernden Vorrichtung oder Anlage. Weiterhin kann das Edge-Device derart ausgebildet und eingerichtet sein, dass es zusätzlich noch mit einem Datennetzwerk oder einer Cloud verbunden ist bzw. zur Verbindung mit einem entsprechenden Datennetzwerk oder einer entsprechenden Cloud ausgebildet und eingerichtet ist.

Ein Edge-Device kann weiterhin zur Realisierung zusätzlicher Funktionalitäten im Zusammenhang mit beispielsweise der Steuerung einer Maschine, Anlage oder Komponente - oder Teilen davon - ausgebildet und eingerichtet sein. Solche Funktionalitäten können beispielsweise sein:
- Daten sammeln und Übertragen in die Cloud und/oder eine entsprechende Vorverarbeitung, Kompression und/oder Analyse solcher Daten;
- eine Analyse von Daten z.B. mit AI-Verfahren, z.B. mit neuronalen Netzen oder entsprechenden ML-Modellen. Das Edge-Device kann dafür z.B. ein ML-Modell umfassen;
- Management oder Durchführung eines Trainings eines neuronalen Netzes oder ML-Modells. Das Training selbst kann dabei zumindest teilweise im Edge-Device selbst, oder aber zumindest u.a. auch in einer Cloud erfolgen. Erfolgt ein Training in einer Cloud, kann das Edge-Device z.B. dazu ausgebildet sein, das trainierte neuronale Netz oder ML-Modell herunterzuladen und nachfolgend zu verwenden.

Es kann weiterhin vorgesehen sein, dass im Rahmen des Trainings in Verfahrensschritt a.) eine Auswahl einer "Best Matching Unit" des ML-Modells und/oder einer zweiten "Best Matching Unit" des zweiten ML-Modells erfolgt und bei dieser Auswahl (nur) der Einstellparametersatz und/oder der weitere Einstellparametersatz Anwendung findet.

Hierbei kann das ML-Modell und/oder das zweite ML-Modell bevorzugt als eine SOM gemäß der vorliegenden Beschreibung oder auch Mod-SOM gemäß der vorliegenden Beschreibung ausgebildet und eingerichtet sein.

Insbesondere kann vorgesehen sein, das im Rahmen der vorstehend genannten Ausgestaltung das ML-Modell und/oder das zweite ML-Modell als eine Mod-SOM gemäß der vorliegenden Beschreibung ausgebildet und eingerichtet sind.

Die Bedeutung einer "Best Matching Unit" (BMU) im Rahmen einer derartigen SOM oder mod-SOM wird an anderer Stelle der vorliegenden Beschreibung erläutert. Insbesondere wird die Ausgestaltung des vorstehend genannten Verfahrensablaufs im Rahmen des Trainings einer SOM oder mod-SOM an weiterer Stelle der vorliegenden Beschreibung erläutert. In einer bevorzugten Ausgestaltung ist bei Anwendung dieses Verfahrens die SOM als eine Mod-SOM ausgebildet und eingerichtet.

Weitere Details zu dieser Ausgestaltung der Erfindung sind in der vorliegenden Beschreibung an anderer Stelle in Bezug auf Erläuterungen zur Mod-SOM dargestellt.

Es kann weiterhin vorgesehen sein, dass bei einer neuen Initialisierung eines ML-Modells, einer SOM oder einer Mod-SOM im Rahmen des Einstellparametersatzes Zufallswerte herangezogen werden, während entsprechende Werte des Messparametersatzes auf null gesetzt werden. In einer weiteren Ausgestaltung der Erfindung können bei einer Neuinitialisierung eines ML-Modells, einer SOM oder einer Mod-SOM Zufallswerten sowohl für Einstellparameter als auch Messparameter herangezogen werden. Weiterhin können anstatt der vorstehend genannten Zufallswerte auch fest vorgegebene ein oder mehrere Werte bei der Initialisierung eines ML-Modells, einer SOM oder einer Mod-SOM verwendet werden.

In einer weiteren Ausgestaltung kann vorgesehen sein, dass im Rahmen des Trainings in Verfahrensschritt a.) eine Anpassung von Parameterwerten des ML-Modells und/oder einer zweiten Parameterwerten des zweiten ML-Modells erfolgt, und bei dieser Anpassung der Messparametersatz, der weitere Messparametersatz, der zweite Messparametersatz und/oder der weitere zweite Messparametersatz Anwendung findet.

Insbesondere kann vorgesehen sein, dass bei einer solchen Anpassung nur der Messparametersatz Anwendung findet.

Auch in dieser Ausgestaltung kann das ML-Modell und/oder das zweite ML-Modell bevorzugt als eine SOM oder auch Mod-SOM ausgebildet und eingerichtet sein. Weiterhin kann das ML-Modell und/oder das zweite ML-Modell auch als ein neuronales Netz, ein Entscheidungsbaum (Decision Tree) oder ein vergleichbares ML-Modell ausgebildet und eingerichtet sein.

Insbesondere kann vorgesehen sein, das im Rahmen der vorstehend genannten Ausgestaltung das ML-Modell und/oder das zweite ML-Modell als eine Mod-SOM gemäß der vorliegenden Beschreibung ausgebildet und eingerichtet sind.

Weitere Details zu dieser Ausgestaltung der Erfindung sind in der vorliegenden Beschreibung an anderer Stelle in Bezug auf Erläuterungen zur Mod-SOM dargestellt.

Insbesondere kann vorgesehen sein, dass im Rahmen des Trainings eine Anpassung von Parameterwerten des ML-Modells erfolgt und im Rahmen dieser Anpassung entweder nur ein entsprechender Messparametersatz oder ein entsprechender Messparametersatz und zugehöriger Einstellparametersatz Anwendung findet.

Insbesondere kann vorgesehen sein, dass ein entsprechendes ML-Modell gemäß der vorliegenden Beschreibung als eine Mod-SOM ausgebildet ist, und im Rahmen des Trainings der Mod-SOM bei einer Ermittlung der BMU nur der Einstellparametersatz Anwendung findet, während bei der Anpassung der Parameterwerte der Mod-SOM sowohl der Messparametersatz als auch der Einstellparametersatz Anwendung findet.

Die vorstehend genannte Aufgabe wird auch gelöst von einem Produktionssystem, umfassend
- eine Produktionseinrichtung gemäß einem der vorstehend genannten Ansprüche zur Herstellung eines Produkts,
- eine Recheneinrichtung,
- sowie eine Trainings-Applikation,

wobei das Produktionssystem zur Durchführung eines Verfahrens gemäß einem der vorstehend genannten Ansprüche ausgebildet und eingerichtet ist,
und die Trainings-Applikation zum Trainieren des ML-Modells gemäß einem der vorstehend genannten Ansprüche,
und die Recheneinrichtung zum automatisierten und/oder teilautomatisierten Ermitteln eines Einstellparametersatzes gemäß einem der vorstehend genannten Ansprüche unter Verwendung des trainierten ML-Modells, ausgebildet und eingerichtet ist.

Dabei können die Produktionseinrichtung sowie die Recheneinrichtung gemäß der vorliegenden Beschreibung ausgebildet und eingerichtet sein.

Die Trainings-Applikation kann beispielsweise als eine Software-Applikation ausgebildet und eingerichtet sein. Dabei kann die Trainings-Applikation beispielsweise in einem sogenannten Sourcecode vorliegen und/oder gespeichert sein oder auch in einer kompilierten Version, beispielsweise als sogenannte Binaries, vorliegen und/oder gespeichert sein.

Die Trainings-Applikation kann beispielsweise derart ausgebildet und eingerichtet sein, dass ein Ausführen der Trainings-Applikation in einer Ausführungsumgebungen ein Trainieren eines ML-Modells gemäß der vorliegenden Beschreibung bewirkt.

Weiterhin kann vorgesehen sein, dass die Trainings-Applikation auch zum Übertragen des trainierten ML-Modells an die Recheneinrichtung ausgebildet und eingerichtet ist. Es kann auch vorgesehen sein, dass, beispielsweise durch das Ausführen der Trainings-Applikation oder das Ausführen einer weiteren Softwareapplikation, beispielsweise in einer Computereinrichtung und/oder Ausführungsumgebung, eine Übertragung des ML-Modells an die Recheneinrichtung erfolgt.

Die Recheneinrichtung kann beispielsweise weiterhin zum automatisierten und/oder teilautomatisierten Ermitteln eines Einstellparametersatzes gemäß der vorliegenden Beschreibung unter Verwendung des trainierten ML-Modells ausgebildet und eingerichtet sein.

Dabei kann das ML-Modell beispielsweise als eine ML-Modell-Softwareapplikation ausgebildet und eingerichtet sein, welche beispielsweise zumindest unter anderem zum Trainieren des ML-Modells und/oder zur Inferenz unter Verwendung des ML-Modells ausgebildet und eingerichtet sein kann. Beispielsweise kann eine solche ML-Modell-Softwareapplikationen, die, zumindest unter anderem, zum Trainieren des ML-Modells ausgebildet und eingerichtet ist, beispielsweise als die vorstehend genannte Trainings-Applikation ausgebildet und eingerichtet sein.

Auch das Ermitteln eines Einstellparametersatzes gemäß der vorliegenden Beschreibung durch die Recheneinrichtung kann beispielsweise unter Verwendung einer ML-Modell-Softwareapplikation erfolgen, wobei die ML-Modell-Softwareapplikation in diesem Beispiel zumindest zur Inferenz unter Verwendung des trainierten ML-Modells ausgebildet und eingerichtet ist.

Weiterhin kann das Produktionssystem derart ausgebildet und eingerichtet sein, dass beispielsweise das Trainieren des ML-Modells gemäß Verfahrensschritt a.) im Rahmen eines Verfahrens zum Einrichten einer Produktionseinrichtung gemäß der vorliegenden Beschreibung in der Recheneinrichtung des Produktionssystems erfolgt. Weiterhin kann ein solches Trainieren des ML-Modells auch in einer davon gesonderten Recheneinrichtung, beispielsweise einer Cloud, einem gesonderten EDGE-Device oder einer weiteren Computereinrichtung erfolgen. Dazu kann die Trainings-Applikation beispielsweise in der entsprechenden Recheneinrichtung implementiert, installiert und/oder instanziiert sein.

Das automatisierte oder teilautomatisierte Ermitteln des weiteren Einstellparametersatzes gemäß Merkmal b.) im Rahmen eines Verfahrens zum Einrichten einer Produktionseinrichtung gemäß der vorliegenden Beschreibung kann beispielsweise gemäß der vorliegenden Beschreibung ausgebildet und eingerichtet sein. Dabei kann das trainierte ML-Modell beispielsweise als eine ML-Modell-Softwareapplikation ausgebildet und eingerichtet sein, welche zumindest unter anderem zur Inferenz unter Verwendung des ML-Modells ausgebildet und eingerichtet ist. Diese ML-Modell-Software Applikation kann beispielsweise ebenfalls auf der Recheneinrichtung implementiert sein, installiert sein und/oder instanziiert sein.

Dabei kann beispielsweise das Produktionssystem derart ausgebildet und eingerichtet sein, dass die Recheneinrichtung derart ausgebildet und eingerichtet ist, dass der weitere Einstellparametersatz gemäß Merkmal b.) in der Recheneinrichtung unter Verwendung des ML-Modells, insbesondere unter Verwendung einer ML-Modell-Softwareapplikation, ermittelt wird oder ermittelbar ist.

Weiterhin kann das Produktionssystem derart ausgebildet und eingerichtet sein, dass nach dem Ermitteln eines weiteren Einstellparametersatzes für die Produktionseinrichtung im Rahmen des Verfahrensschritt b.) gemäß der vorliegenden Beschreibung, dieser ermittelte weitere Einstellparametersatz an eine Steuereinrichtung für die Produktionseinrichtung übermittelt wird. Dann kann das weitere Produkt durch die Produktionseinrichtung unter Verwendung des weiteren Einstellparametersatzes produziert werden bzw. das weitere Produkt wird dann unter Verwendung des weiteren Einstellparametersatzes produziert. Dabei kann die Steuereinrichtung Teil der Produktionseinrichtung, oder auch davon gesondert ausgebildet und eingerichtet sein.

In einer vorteilhaften Ausgestaltung ist die Steuereinrichtung für die Produktionseinrichtung Teil des Produktionssystems.

In einer weiteren Ausgestaltung der Erfindung kann der weitere Einstellparametersatz auch in einer gesonderten Speichereinrichtung, beispielsweise in der Recheneinrichtung des Produktionssystems oder einer weiteren Rechen- oder Speichereinrichtung, gespeichert werden. Dann kann der weitere Einstellparametersatz beispielsweise im Rahmen der Produktion des weiteren Produkts von einer Steuereinrichtung für die Produktionseinrichtung aus der entsprechenden Speichereinrichtung ausgelesen werden und unmittelbar dann im Rahmen der Produktion verwendet werden.

Das Produktionssystem kann weiterhin derart ausgebildet und eingerichtet sein, dass eine Überprüfung, ob der weitere Messparametersatz ein vorgegebenes oder vorgebbares Qualitätskriterium erfüllt, beispielsweise in der Recheneinrichtung des Produktionssystems erfolgt. Die Recheneinrichtung kann weiterhin zur Überprüfung, ob der weitere Messparametersatz das vorgegebene oder vorgebbare Qualitätskriterium erfüllt, ausgebildet und eingerichtet sein. Diese Prüfung kann alternativ auch in einer weiteren Recheneinrichtung, beispielsweise einem EDGE-Device, oder auch einer Steuereinrichtung für die Produktionseinrichtung oder auch einer gesonderten Recheneinrichtung, beispielsweise einer Cloud, erfolgen.

Beispielsweise kann diese Überprüfung, ob der weitere Messparametersatz ein vorgegebenes oder vorgebbares Qualitätskriterium erfüllt, in einer Recheneinrichtung ablaufen, welche zumindest unter anderem eine allgemeine Ablaufsteuerung des Produktionssystems umfasst bzw. übernimmt. Dies kann beispielsweise in der Recheneinrichtung des Produktionssystems implementiert sein.

Weiterhin kann das Produktionssystem derart ausgebildet und eingerichtet sein, dass es eine Vorrichtung umfasst, welche zur Entscheidung, ob das vorgegebene oder vorgebbare Qualitätskriterium erfüllt ist oder nicht, ausgebildet und eingerichtet ist. Eine solche Vorrichtung kann dann weiterhin zu weiteren, darauffolgenden Entscheidungen gemäß der vorliegenden Beschreibung ausgebildet und eingerichtet sein. Dies kann beispielsweise eine Entscheidung umfassen, ob in dem Fall, in welchem das vorgegebene oder vorgebbare Qualitätskriterium erfüllt ist, die Produktion eines weiteren nachfolgenden Produkts erfolgt, oder ob noch einmal ein weiterer Trainingsschritt gemäß Merkmal a.) im Rahmen eines Verfahrens gemäß der vorliegenden Beschreibung ablaufen soll.

Weiterhin kann das Produktionssystem ein Messsystem umfassen, welches zum Erfassen des Messparametersatzes und/oder des weiteren Messparametersatzes ausgebildet und eingerichtet ist. Dabei kann dieses Messsystem beispielsweise ein oder mehrere Sensoren umfassen und gemäß der vorliegenden Beschreibung ausgebildet und eingerichtet sein. Dabei können die Messparameter unmittelbar zumindest einzelnen Sensorwerten entsprechenden oder aus einer entsprechenden Verarbeitung von Sensorwerten ermittelt werden. Insbesondere kann das Messsystem beispielsweise ein oder mehrere Kameras umfassen, wobei Messparameter beispielsweise ein oder mehrere Werte darstellen können, welche aus derartigen Kameraaufnahmen abgeleitet wurden. Die Recheneinrichtung des Produktionssystems, oder zumindest Teile dieser Recheneinrichtung, können beispielsweise Teil des Messsystems sein.

Im Falle eines Produktionssystems, welches eine als Lotpastendrucker ausgebildete Produktionseinrichtung umfasst, oder welche als Lotpastendrucker ausgebildet ist, kann das Messsystem beispielsweise ein sogenanntes Lotpasten-Inspektionssystem (Solder paste Inspektion, SPI) sein oder ein solches umfassen. Ein solches SPI kann beispielsweise wiederum eine Recheneinheit zur Bildauswertung der entsprechenden Aufnahmen einer gedruckten Leiterplatte umfassen und wiederum zur Ausgabe von Werten bezüglich einzelnen auf der gedruckten Leiterplatte befindlichen Lotpasten-Depots. Solche Werte können beispielsweise ein entsprechendes Lotpastenvolumen sein oder umfassen.

In dem Falle, in welchem das Produktionssystem beispielsweise eine als Spritzguss-Anlage oder Druckguss-Anlage ausgebildet Produktionseinrichtung umfasst, kann beispielsweise ein Messsystem eine Waage und/oder eine Kameraeinrichtung zur Erfassung von verschiedenen Parameterwerten bezüglich eines hergestellten Produkts umfassen. Weiterhin kann ein solches Messsystem ebenfalls zur Auswertung entsprechender Kamerabilder bzw. Messwerte der Waage ausgebildet und eingerichtet sein, um entsprechende Messparameter bzw. weitere Messparameter im Rahmen eines Verfahrens gemäß der vorliegenden Beschreibung zu ermitteln.

Das Produktionssystem kann in einer ersten Variante beispielsweise als ein dezentraleres Produktionssystem ausgebildet und eingerichtet sein. Dabei kann das Produktionssystem beispielsweise derart ausgebildet und eingerichtet sein, dass ein Training des ML-Modells, beispielsweise gemäß Verfahrensschritt a.) in Bezug auf die vorliegende Beschreibung, in einer Cloud oder einer externen Recheneinrichtung, insbesondere einer externen leistungsfähigen Recheneinrichtung abläuft. Bevorzugt kann das Training des ML-Modells so lange in der Cloud bzw. der externen Recheneinrichtung ablaufen, bis Einstellparameter ermittelt wurden, welche ein vorgegebenes oder vorgebbares Qualitätskriterium erfüllen. Besonders bevorzugt kann das Training des ML-Modells so lange in der Cloud bzw. der externen Recheneinrichtung ablaufen, bis stabile Einstellparameter ermittelt wurden, von welchen erwartet wird, dass Produkte damit herstellbar sind, welche das vorgegebene bzw. vorgebbare Qualitätskriterium für einen längeren Zeitraum bzw. eine größere Menge hergestellter Produkte erfüllen.

Sind derartige Einstellparameter ermittelt, erfolgt eine Übertragung beispielsweise in ein EDGE Device oder eine Recheneinrichtung des Produktionssystems oder der Produktionseinrichtung oder einer Messeinrichtung selbst. Unter Zuhilfenahme des EDGE-Devices oder der Recheneinrichtung des Produktionssystems können dann beispielsweise weitere Detailanpassungen des ML-Modells erfolgen, wenn notwendig.

Stellt sich heraus, dass das vorgegebene bzw. vorgebbare Qualitätskriterium nicht mehr erfüllt wird, oder aus anderem Grund ein Nachtraining des ML-Modells erforderlich wird, wird das ML Modell wieder zurück in die Cloud oder an die externe Recheneinrichtung übertragen und das Nachtraining des ML-Modells erfolgt wie beim Einrichten des Produktionssystems dort.

In einer zweiten Variante kann das Produktionssystem beispielsweise als ein lokales Produktionssystem ausgebildet und eingerichtet sein. Ein solches lokales Produktionssystem kann beispielsweise ein EDGE-Device gemäß der vorliegenden Beschreibung und eine Produktionseinrichtung gemäß der vorliegenden Beschreibung umfassen, wobei die Produktionseinrichtung weiterhin eine Messeinrichtung zur Ermittlung eines Messparametersatzes umfasst. Eine solche Produktionseinrichtung kann beispielsweise als ein Lotpastendrucker mit zugehörigem Lotpasteninspektionssystem (SPI) ausgebildet und eingerichtet sein.

Es kann in dieser Variante für das Produktionssystem dann beispielsweise vorgesehen sein, dass ein Training des ML-Modells so lange im EDGE-Device erfolgt, bis das vorgegebene oder vorgebbare Qualitätskriterium für die Einstellparameter erreicht ist - vorteilhafterweise so lange, bis stabile Einstellparameter gemäß der vorstehenden Erläuterung ermittelt wurden.

Ab diesem Zeitpunkt erfolgt eine Übertragung des trainierten ML-Modells in einer Recheneinrichtung der Produktionseinrichtung, beispielsweise einen Steuerrechner, eine Steuereinrichtung und/oder einen Messrechner des SPI, wobei die nachfolgende Produktion sowie entsprechende Detailanpassungen des ML-Modells bzw. der Einstellparameter dort vorgenommen werden, bzw. von dort gesteuert werden.

Sollte ein Nachtrainieren des ML-Modells gemäß den vorstehenden Erläuterungen notwendig werden, so kann optional eine Rückübertragung des ML-Modells in das EDGE-Device erfolgen und das Nachtrainieren dann dort vorgenommen werden.

In einer alternativen Ausgestaltung dieses lokalen Produktionssystems kann das ML-Modell auch vollständig im EDGE-Device verbleiben. Es wird dann nach dem Trainieren nicht in eine andere Einrichtung übertragen, sondern verbleibt in allen Trainings- und/oder Produktionsphasen im Edge-Device.

Diese lokale Variante eines Produktionssystem eignet sich beispielsweise für die Ausgestaltung des ML-Modells als SOM oder Mod-SOM, da das Trainieren einer SOM bzw. Mod-SOM beispielsweise im Vergleich zum Training eines aufwändigeren neuronalen Netzes einen vergleichsweise geringeren Rechenaufwand benötigt, der von einem EDGE-Device gut erbracht werden kann.

In einer weiteren, dritten Variante des Produktionssystem kann dieses als streng lokales Produktionssystem ausgebildet und eingerichtet sein, in welchem das Produktionssystem eine Produktionseinrichtung umfasst, welche wiederum eine Messeinrichtung, wie vorstehend bereits im Rahmen der zweiten Variante erläutert, umfasst. Das ML-Modell ist auf einer Recheneinrichtung dieser Produktionseinrichtung, beispielsweise einer Steuereinrichtung, einem Steuerrechner und/oder einem Messrechner der Messeinrichtung installiert. Dann erfolgt das komplette Training in allen der vorstehend genannten Verfahrenszustände des Einrichtens, die Produktion mit den ermittelten Einstellparametern, ein eventuelles Nachjustieren mit dem trainierten ML-Modell sowie ein mögliches Nachtrainieren mit dem auf der genannten Recheneinrichtung implementierten ML-Modell.

Die vorstehend genannte Aufgabe wird auch gelöst von einem Computerprogrammprodukt, umfassend Befehle, die bei der Ausführung des Programms durch einen Computer diesen veranlassen, ein Verfahren gemäß der vorliegenden Beschreibung auszuführen.

Die vorstehend genannte Aufgabe wird auch gelöst von einem Computerprogrammprodukt, umfassend Befehle, die bei der Ausführung des Programms durch einen Computer diesen veranlassen, die Verfahrensschritte gemäß einem der Ansprüche 1 bis 10 und/oder einem Verfahren gemäß der vorliegenden Beschreibung im Zusammenwirken mit der Produktionseinrichtung auszuführen.

Weiterhin wird die vorstehend genannte Aufgabe gelöst von einem computerlesbaren Speichermedium, umfassend Befehle, die bei der Ausführung des Programms durch einen Computer diesen veranlassen, die Verfahrensschritte gemäß einem der Ansprüche 1 bis 10 und/oder einem Verfahren gemäß der vorliegenden Beschreibung insbesondere im Zusammenwirken mit der Produktionseinrichtung auszuführen.

Dabei bezieht sich die Zusammenwirkung mit der Produktionseinrichtung insbesondere zumindest unter anderem auf Verfahrensschritt c.) gemäß der vorliegenden Beschreibung.

Dabei kann das Computerprogrammprodukt beispielsweise als ein oder mehrere Softwareapplikationen ausgebildet und eingerichtet sein. Jede dieser genannten Softwareapplikationen kann beispielsweise mehrere Komponenten, Unterprogramme, Subroutinen und/oder Subkomponenten umfassen.

Beispielsweise kann eine solche Softwareapplikation, Komponente und/oder Subkomponente zum Trainieren des ML-Modells gemäß Verfahrensschritt a.) im Rahmen eines Verfahrens gemäß der vorliegenden Beschreibung ausgebildet und eingerichtet sein. Eine weitere dieser Softwareapplikationen, Komponenten und/oder Subkomponenten kann beispielsweise zum automatisierten oder teilautomatisierten Ermitteln des weiteren Einstellparametersatzes gemäß Verfahrensschritt b.) im Rahmen eines Verfahrens gemäß der vorliegenden Beschreibung ausgebildet und eingerichtet sein.

Eine weitere der genannten Softwareapplikationen, Komponenten und/oder Subkomponenten kann beispielsweise zur Steuerung und Regelung der Produktionseinrichtung zum Herstellen des weiteren Produkts mit der Produktionseinrichtung ausgebildet und eingerichtet sein.

Eine weitere der genannten Softwareapplikationen, Komponenten und/oder Subkomponenten kann weiterhin zum Erfassen und/oder Ermitteln des Messparametersatzes bezüglich des weiteren Produkts bzw. allgemein bezüglich hergestellter Produkte, gemäß Verfahrensschritt c.) im Rahmen eines Verfahrens gemäß der vorliegenden Beschreibung ausgebildet und eingerichtet sein.

Weiterhin kann das Computerprogrammprodukt zur Prüfung, ob ein Messparametersatz ein vorgegebenes oder vorgebbares Qualitätskriterium erfüllt, ausgebildet und eingerichtet sein. Das Computerprogrammprodukt kann auch zur weiteren Steuerung sich an diese Prüfung anschließender Entscheidungsvorgänge und Produktionsvorgänge bzw. Messabläufe ausgebildet und eingerichtet sein, oder eine Softwareapplikation umfassen, die dazu ausgebildet und eingerichtet ist.

Die vorstehend genannte Aufgabe wird auch gelöst von einem Computerprogrammprodukt, umfassend Befehle, die bei der Ausführung des Programms durch einen Computer diesen veranlassen, ein Verfahren gemäß den Merkmalen a.) und b.) gemäß der vorliegenden Beschreibung auszuführen,
und/oder ein Verfahren gemäß den Merkmalen a.), b.) und d.) gemäß einem der vorliegenden Beschreibung auszuführen.

Die vorstehend genannte Aufgabe wird auch gelöst von einem Computerprogrammprodukt, umfassend Befehle, die bei der Ausführung des Programms durch einen Computer diesen veranlassen, ein Verfahren gemäß Merkmal a.) gemäß der vorliegenden Beschreibung auszuführen,
und/oder ein Verfahren gemäß den Merkmalen a.) und d.) gemäß der vorliegenden Beschreibung auszuführen.

Nachfolgend wird ein Ausführungsbeispiel bzw. Anwendungsbeispiel für ein Verfahren zum Einrichten einer Produktionseinrichtung gemäß der vorliegenden Beschreibung gegeben. Dieses Beispiel betrifft das Einrichten eines Lotpastendruckers zum Bedrucken von Leiterplatten mit Lotpaste zum nachfolgenden Kontaktieren mittels Lötung von Bauelementen mit dieser Leiterplatte.

Im Rahmen der SMT-Montage (SMT: Surface Mount Technology) von Bauelementen auf Leiterplatten erfolgt eine stetige Wertschöpfung an Mehrfachnutzen.

Dabei beziehen sich die Begriffe "Nutzen" und "Mehrfachnutzen" im Kontext der Bestückung von Leiterplatten mit Bauelementen auf die Art und Weise, wie die Leiterplatten während des Herstellungsprozesses angeordnet und behandelt werden. Ein "Nutzen", auch "Einzelnutzen" genannt, bezeichnet dabei eine einzelne Leiterplatte bzw. Flachbaugruppe auf welcher während der Erstellung verschiedene Bauteile aufgebracht werden. Ein "Mehrfachnutzen" beschreibt mehrere Einzelnutzen, welche für eine simultane Bearbeitung in den einzelnen Produktionsschritten zusammengefasst sind. Mehrfachnutzen werden nach der Verlötung zur Vorbereitung der Endmontage mechanisch in Einzelnutzen getrennt. Die potenziellen Vorteile dieser Systematik in der Fertigung liegen in der Optimierung des Produktionsprozesses. Durch die Nutzung des Mehrfachnutzens kann die Produktivität gesteigert werden. Dies trägt insgesamt zu einer verbesserten Effizienz und Kostenersparnis in der Fertigung bei.

Die erreichte Produktqualität der Mehrfachnutzen kann jedoch erst mit Abschluss der Endprüfung bestimmt werden. Ein Großteil defekt geprüfter Mehrfachnutzen lässt sich jedoch auf das fehlerhafte Bedrucken der Mehrfachnutzen mittels Lotpaste zurückführen. Der korrekte Bedruckvorgang für das Erreichen einer hohen finalen Produktqualität hängt hingegen maßgeblich von der Wahl der Prozessparameter bzw. Einstellparameter des Lotpastendruckers ab. Die Vielzahl der Parameter und damit möglicher Parameterkombinationen, insbesondere hinsichtlich Ausprägung der jeweiligen Parameter als auch der Parametersätze, erschwert das korrekte Einstellen des Prozesses insbesondere dann, wenn das Prozessverhalten unbekannt ist und erst durch entsprechende Versuche untersucht / erlernt werden muss. Diese Unsicherheit entsteht insbesondere dann, wenn bisher ungetestete Bestückkomponenten oder neue Konstellationen von Bestückkomponenten auf Mehrfachnutzen montiert werden müssen.

Hier finden hier regelmäßig Methoden aus dem Bereich "Six Sigma" Verwendung. Hierzu wird der DMAIC-Zyklus durchlaufen, sodass ausgehend von einer Problemstellung (bspw. der unzureichenden Bedruckung von Mehrfachnutzen) Prozessparameter mittels Experten-/Domänenwissen in einem Ishikawa-Diagramm erfasst und relevante Prozessparameter für die Optimierungen ausgewählt werden. Darauf aufbauend erfolgt dann die Wahl geeigneter Versuchsfelder und die Durchführung von Versuchen.

Insbesondere bei der Auswertung der Versuchsergebnisse können herkömmliche Softwaretools aus dem Six Sigma Bereich (bspw. Minitab) nur bedingt im vorstehend genannten Anwendungsfall eines Lotpastendruckers angewendet werden. Dies ist insbesondere dadurch begründet, dass derartige Programme nur mit einem einzelnen Zielwert, im hier betrachteten Anwendungsfall einem Lotdepot, arbeiten können. Im Rahmen der Elektronikfertigung sind auf Mehrfachnutzen jedoch mehrere (> 400) dieser Lotdepots und damit Zielwerte vorhanden, welche in gegenseitiger Relation bewertet werden müssen. Die Auswertung mittels herkömmlicher Softwaretools ist zwar technisch möglich, jedoch aufgrund erforderlicher Auswertungszeiten nicht zielführend und damit nicht praktisch anwendbar.

Nachfolgend wird eine beispielhafte Ausgestaltung eines Verfahrens gemäß der vorliegenden Beschreibung zum verbesserten Einrichten eines solchen Systems dargestellt. Teil davon ist das Aufstellen eines virtuellen Versuchsplans, welcher ausgehend von dem Modell virtuell analysiert und untersucht wird. Sobald eine Parameterkonstellation gefunden wurde, welche den Prozess entsprechend der Zielstellung einstellt, wird die resultierende Parameterkonstellation ausgeleitet und kann an den Prozess übertragen werden. Solange noch keine Parameterkonstellation gefunden ist, wird der mögliche Suchraum systematisch - auf Basis eines stetig aktualisiert erlernten Prozessverhaltens - untersucht und eingegrenzt, bis eine mögliche Parameterkonstellation gefunden wurde.

Für einen entsprechenden beispielhaften Verfahrensablauf zur Optimierung hinsichtlich eines univariaten Optimums wird eine Self-Organizing Map (KOHONEN, Teuvo. Self-organized formation of topologically correct feature maps. Biological cybernetics, 1982, 43. Jg., Nr. 1, S.59-69), (kurz SOM) modifiziert (kurz mod-SOM), sodass in der letzten Schicht eines jeden Neurons die erwarteten Reaktionen des zu erlernenden Systems prognostiziert und abgespeichert werden. Dazu werden die Neuronen mit verschiedenen Prozessparameterkonstellationen initialisiert. Dabei kann die SOM bzw. mod-SOM beispielsweise gemäß der vorliegenden Beschreibung ausgebildet und eingerichtet sein.

Ausgehend von der Initialisierung wird die mod-SOM trainiert, indem die mod-SOM an die realen Prozessreaktionen angepasst wird. Dadurch erfolgt eine Prognose des Prozessverhaltens auf bisher unbekannte Parameterkonstellationen. Diese Reaktionen, die ein Beispiel für Messparameter im Rahmen der vorliegenden Beschreibung darstellen, werden in der obersten Ebene der mod-SOM abgespeichert.

Auf Basis der trainierten mod-SOM können dann diejenigen Parameterkonstellationen ausgewählt werden, welche in dem gewünschten Zielkorridor liegen.

Unter Berücksichtigung der Zielstellung wird in jeder weiteren Iteration genau eine neu in der Realität zu testende Parameterkonstellation ausgewählt. Die mod-SOM interagiert somit kontinuierlich mit dem realen Prozess und ermöglicht ein schnelleres Finden optimaler Prozessparameter und verhindert das Durchführen eines vollständigen Prüfens des theoretisch möglichen Parameterraumes.

Die mod-SOM kann im Rahmen der SMT-Fertigung Zulieferunabhängig sowohl on-premise sowie cloudbasiert betrieben / genutzt werden. In dem angedachten Anwendungsfall kann sie beispielsweise on-premise auf einem Industrie-PC oder einem Edge-Device verwendet werden.

Durch die Verwendung der mod-SOM ergeben sich folgende wesentliche Vorteile im Vergleich mit dem bisherigen Ablauf:
- Reduzieren / Vermeiden von manuellem Aufwand bei der Versuchsdurchführung. Dadurch wird die zeitliche Verfügbarkeit von Prozessexperten erhöht;
- Verkürzte Testphase. Dadurch folgen geringer Ausschussraten in Produktneuanläufen sowie eine höhere Verfügbarkeit der Produktionslinien;
- Höheres First Pass Yield (FPY) über die SMT-Linien im Produktionsbetrieb, da Fehlerraten sowie Ausschuss gesenkt werden.

Weitere vorteilhafte Ausgestaltungen finden sich in den Unteransprüchen.

Im Folgenden wird die Erfindung beispielhaft mit Bezug auf die beigefügte Zeichnung näher erläutert.
Figur 1 zeigt ein Beispiel-System Zur Anwendung eines Verfahrens gemäß der vorliegenden Beschreibung am Beispiel eines Lotpasten Drucks im Rahmen einer Elektronikproduktion;
Figur 2 zeigt einen beispielhaften Verfahrensablauf für ein Einrichten des in Figur 1 gezeigten Beispielsystems;
Figur 3 zeigt eine beispielhafte Darstellung der Ermittlung eines Einstellparametersatzes auf Basis des in Figur 1 dargestellten Beispielsystems und des in Figur 2 dargestellten beispielhaften Verfahrensablaufs.

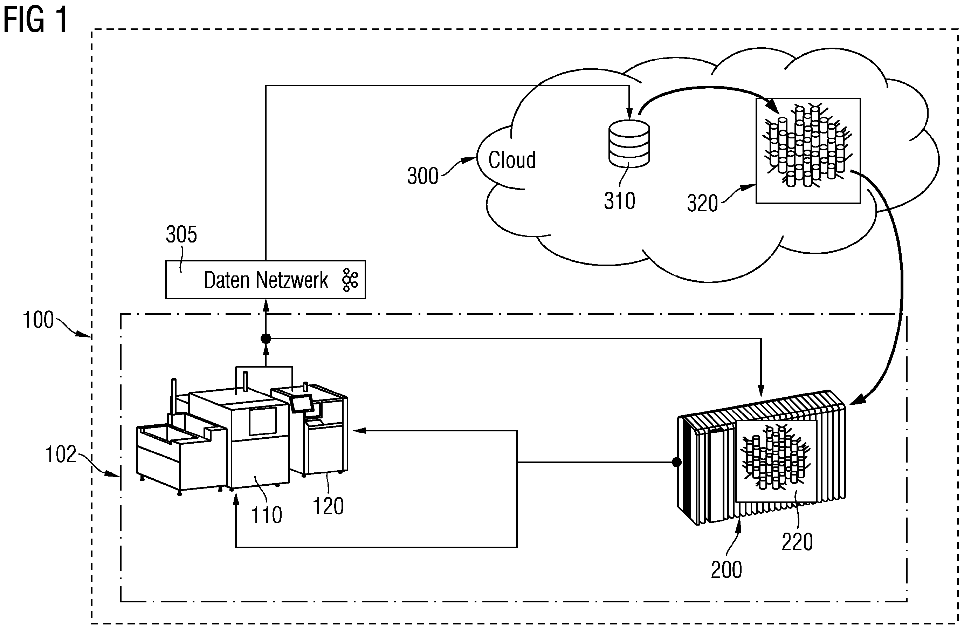

Figur 1 zeigt eine beispielhafte Ausgestaltung eines Produktionssystems 100, 102 gemäß der vorliegenden Beschreibung.

Dabei ist in Figur 1 eine erste, dezentrale Variante eines Produktionssystems 100 gemäß der vorliegenden Beschreibung dargestellt, sowie eine lokale Variante 102 eines Produktionssystems 102 gemäß der vorliegenden Beschreibung.

Dabei zeigt Figur 1 einen Lotpastendrucker 110 zum Bedrucken von Schaltungsplatinen mit Lotpaste. Dabei wird der Lotpasten-Drucker 110 verwendet, um Lotpasten-Depots auf Schaltungsplatinen zu drucken. Auf diese Schaltungsplatinen werden nachfolgend elektronische Bauelemente bestückt, welche dann mittels Verlötens unter Verwendung der Lotpasten-Depots elektrisch mit der Platine verbunden werden.

Teil des Lotpastendruckers 110, und/oder nach diesem Lotpastendrucker 110 angeordnet, ist ein Lotpasten-Inspektionssystem 120 (SPI: solder paste inspection) in Figur 1 dargestellt, welches zur Prozesskontrolle des Lotpastendruckers 110 ausgebildet und eingerichtet ist. Das Lotpasten-Inspektionssystem 120 umfasst eine oder mehrere Kameras zur Aufnahme von Bildern einer bedruckten Schaltungsplatine (Einzel- sowie Mehrfachnutzen) und ist weiterhin zur Auswertung derartiger Bilder ausgebildet und eingerichtet. Im Rahmen der Auswertung können beispielsweise die einzelnen gedruckten Lotpasten-Depots ausgewertet werden, sodass beispielsweise eine bedruckte Fläche sowie ein Lotvolumen einzelner, oder auch aller, gedruckter Lotpasten-Depots vom Inspektionssystem 120 ermittelt und ausgegeben wird bzw. werden kann.

Es ist ein Ziel des Einrichtens des Lotpastendruckers 110, dass die gedruckten Lotpasten-Depots ein jeweils vorgegebenes oder vorgebbares Volumen aufweisen und/oder dass das Volumen der einzelnen Lotpasten-Depots in einem jeweils vorgegebenen oder vorgebbaren Volumenbereich liegt. Dabei kann ein entsprechendes Ziel-Volumen, bzw. ein entsprechender Ziel-Volumenbereich, beispielsweise so gewählt werden, dass es/er groß genug ist, um eine sichere Kontaktierung darauf angebrachter Bauelemente zu erreichen, und gleichzeitig nicht so groß ist, dass unabsichtlich mehrere Kontaktpunkte eines Bauelements durch ein Lotpasten-Depot gleichzeitig kontaktiert werden.

Zum Einrichten des Lotpastendruckers 110 können beispielsweise die Einstellparameter Trenngeschwindigkeit, Trennabstand sowie Rakelgeschwindigkeit variiert und eingestellt werden. Diese Beispielparameter, die zumindest unter anderem bei der Einrichtung eines solchen Druckers 110 eingestellt werden können bzw. müssen, werden nachfolgend näher erläutert:
- Rakelgeschwindigkeit: Dies bezieht sich auf die Geschwindigkeit, mit der die Rakel über eine Schablone bewegt werden, um die Lotpaste auf die Leiterplatte zu drucken. Eine höhere Rakelgeschwindigkeit führt zu einem schnelleren Druckprozess, während eine niedrigere Geschwindigkeit eine präzisere Dosierung der Lotpaste ermöglicht.
- Trennabstand: Der Trennabstand beschreibt die räumliche Distanz die der Mehrfachnutzen nach Abschluss des Bedruckens mit einer verminderten Geschwindigkeit, der Trenngeschwindigkeit, nach unten verfahren wird, um den bedruckten Mehrfachnutzen sicher von der Druckschablone zu trennen. Ein hoher Trennabstand führt zu einer hohen Verfahrdistanz mit geringerer Geschwindigkeit und damit zu einer höheren Prozesszeit, wohingegen er zu einer qualitativen höheren Ablösung der bedruckten Lotpaste von der Druckschablone führt, sodass mehr Lotpaste (bspw. höheres Volumen, mehr bedruckte Fläche) auf den Lotdepots erhalten bleibt. Damit kann der Druck eine höhere Qualität aufweisen. Ein kleinerer Trennabstand ermöglicht somit eine genauere Dosierung der Lotpaste, während ein größerer Abstand eine schnellere Druckgeschwindigkeit ermöglicht.
- Trenngeschwindigkeit: Dies bezieht sich auf die Geschwindigkeit, mit der der bedruckte Mehrfachnutzen von der Schablone entfernt wird, nachdem die Lotpaste aufgedruckt wurde. Eine höhere Trenngeschwindigkeit kann dazu führen, dass beim Absenken der Mehrfachnutzen von der Schablone die Lotpaste an der Schablonenwandung haften bleibt, sodass eine gerigere Menge an Lotpaste auf den Lotdepots verbleibt, während eine niedrigere Geschwindigkeit zu geringeren Anhaftungseffekten der Lotpaste an der Druckschablone und damit höherem Auftrag (bspw. höhere flächige Bedeckung, höheres aufgebrachtes Lotvolumen)von Lotpaste auf den Lotdepotsführen kann.

Eine Änderung dieser Parameter kann verschiedene Auswirkungen auf den Druckprozess des Lotpastendruckers 110 und die hergestellten Schaltungsplatinen haben:
- Eine höhere Rakelgeschwindigkeit kann zu einer schnelleren Produktion führen, aber möglicherweise auch zu einer geringeren Menge aufgetragener Lotpaste.
- Ein kleinerer Trennabstand ermöglicht eine kürzere Druckzeit, kann jedoch zu einer verminderten Menge aufgetragener Lotpaste führen.
- Eine höhere Trenngeschwindigkeit kann zu einer geringeren Menge an transferierter Lotpaste, allerdings auch zu einer verkürzten Prozesszeit pro Druckvorgang führen.

Es ist wichtig, die global optimalen Einstellungen für diese Parameter zu finden, um eine gute Qualität der gedruckten Lotdepots auf den Schaltungsplatinen pro Mehrfachnutzen zu gewährleisten. Dies kann durch Experimentieren und Testen verschiedener Einstellungen erreicht werden.

Dabei sind die Parameter Rakelgeschwindigkeit, Trennabstand und Trenngeschwindigkeit Beispiele für Einstellparameter gemäß der vorliegenden Beschreibung. Die Gesamtheit dieser Parameter ist ein Beispiel für einen Einstellparametersatz gemäß der vorliegenden Beschreibung.

Das in Bezug auf die Figuren im folgenden dargestellte Verfahren, beispielsweise zum Einstellen des Parameters "Rakelgeschwindigkeit", ist ein Beispiel für ein Verfahren zum Einrichten einer Produktionseinrichtung im Rahmen der vorliegenden Beschreibung - oder umfasst ein solches Beispiel.

Figur 1 offenbart weiterhin eine Cloud 300, welche einen Prozessdatenspeicher 310 und eine als mod-SOM 320 gemäß der vorliegenden Beschreibung ausgebildetes ML-Modell 320 umfasst.

Weiterhin offenbart Figur 1 ein EDGE Device 200 gemäß der vorliegenden Beschreibung, welche ebenfalls ein als mod-SOM 220 gemäß der vorliegenden Beschreibung ausgebildetes ML-Modell 220 umfasst.

Zudem offenbart Figur 1 ein Datennetzwerk 305, welches den Lotpastendrucker 110 sowie das Lotpasten-Inspektionssystem 120 mit der Cloud 300, insbesondere mit dem Prozessdatenspeicher 310 in der Cloud 300, verbindet. Weiterhin ist über das Datennetzwerk 305 auch die Cloud 300 mit dem EDGE Device 200 verbunden (nicht in Figur 1 dargestellt).

In einer ersten vorteilhaften Ausgestaltung ist in Figur 1 ein dezentraleres Produktionssystem 100 dargestellt, welches von einer gestrichelten Linie in Figur 1 begrenzt wird.

In diesem dezentralen Produktionssystem 100 erfolgt ein Ermitteln der Einstellparameter, zum beispielsweise ein erstmaliges Einrichten des Lotpastendruckers 110 durch ein Training der mod-SOM 320, in der Cloud 300. Dazu werden in einem ersten Schritt Trainingsdaten für die mod-SOM 320 ermittelt, indem ein entsprechendes Versuchsfeld von Einstellparametern für den Lotpastendrucker 110 ausgewählt wird, umfassend Werte für die Rakelgeschwindigkeit, den Trennabstand sowie die Trenngeschwindigkeit. Mit diesen Test-Einstellparametern werden jeweils Leiterplatten durch den Lotpastendrucker 110 bedruckt und die bedruckten Leiterplatten jeweils über das Lotpasten-Inspektionssystem 120 begutachtet und ein ausgewähltes Lotpasten-Depot auf der Leiterplatte analysiert, welches zum Einrichten des Lotpastendrucker sein 110 ausgewählt wurde.

Dabei ermittelt das Lotpasten-Inspektionssystem 120 jeweils ein Volumen dieses Lotpasten-Depots. Die entsprechenden Einstellparameter der Lotpastendrucker 110 sowie das Volumen des mit der entsprechend bedruckten Leiterplatte ausgewertete Lotpasten-Depots werden dann jeweils in den Prozessdatenspeicher 310 in der Cloud 300 übertragen.

Nachdem Platinen mit sämtlichen Test-Einstellparametern gedruckt und entsprechend ausgewertet wurden, und die entsprechenden Einstellwerte sowie Lotpasten-Depot-Volumina in den Prozessdatenspeicher 110 übertragen wurden, findet ein Training der Mod-SOM 320 in der Cloud mit diesen Werten statt. Dabei kann beispielsweise gemäß den Darstellungen für ein Training einer Mod-SOM gemäß der vorliegenden Beschreibung vorgegangen werden. Damit werden jeweils die "Best Matching Units" der Mod-SOM 220, 320 unter Verwendung des Einstellparametersatzes ermittelt und dann eine Anpassung der Mod-SOM 220, 320 sowohl mit den Einstellparametern als auch den Lotpasten-Volumina durchgeführt.

Dann erfolgt eine Ermittlung eines weiteren Einstellparametersatzes gemäß der vorliegenden Beschreibung für eine nächste Testmessung unter Verwendung der in der Cloud 300 gespeicherten mod-SOM 320.

Die Ermittlung des weiteren Einstellparametersatzes wird genauer im Zusammenhang mit Figur 3 erläutert. Im Prinzip wird durch die Einstellparameter als Variablen und die zugehörigen Lotpasten-Depot-Volumina als Funktionswert eine Funktion definiert. Es werden dann, beispielsweise durch eine lineare Interpolation, Funktionswerte für einen gegebenen Variablenwert-Bereich für die verschiedenen Variablen der für einzelne der Variablenwerte gemessenen Lotpasten-Depot-Volumina ermittelbar.

Weiterhin ist für das Lotpasten-Depot, welches zum Einstellen des Lotpastendruckers 110 herangezogen wird, ein Soll-Volumenbereich vorgegeben. Durch Vergleich der Lotpasten-Depot-Volumina der vorstehend genannten erzeugten Funktion und diesem Soll-Volumenbereich werden nun Vorschläge für mögliche Einstellparameter abgeleitet, für welche erwartet wird, dass das Bedrucken einer entsprechenden Leiterplatte ein Lotpasten-Depot-Volumen des ausgewählten Lotpasten-Depots im gewünschten Größenbereich erzeugt.

Durch einen Benutzer kann nun beispielsweise einer der möglichen Parametersätze ausgewählt werden. Weiterhin kann auch in einem automatisierten Verfahren beispielsweise der Parametersatz ausgewählt werden, welcher die kürzeste Druckzeit bei bester Druckqualität ermöglicht. Auf diese Weise wird beispielsweise ein Druckprozess des Lotpastendruckers 110 derart ausgewählt, dass eine möglichst große Rakelgeschwindigkeit, und damit eine möglichst hohe Druckgeschwindigkeit, verwendet wird. Dies führt zu einer geringst-möglichen Produktionszeit für das Bedrucken einer entsprechenden Leiterplatte bei Einhaltung der geforderten Druckqualität.

Dieser weitere Einstellparametersatz wird nun wiederum über das Datennetzwerk 305 zurück von der Cloud zum Lotpastendrucker 110 übermittelt, und eine weitere Leiterplatte mit diesem weiteren Einstellparametersatz gedruckt. Es wird nun durch das Lotpasten-Inspektionssystem 120 wiederum die prozentuale Volumenfüllung des ausgewählten Lotpasten-Depots ermittelt.

Liegt die prozentuale Volumenfüllung des ausgewählten Lotpasten-Depots nun im gewünschten Größenbereich, so kann beispielsweise eine Produktion von Leiterplatten mit dem Lotpastendrucker 110 und den nunmehr ermittelten Einstellparametern gestartet werden. Dazu wird die trainierte mod-SOM 320 aus der Cloud zur mod-SOM 220 im EDGE Device 200 überführt. Dabei kann die Produktion von Leiterplatten mit den ermittelten Einstellparametern vorgenommen werden.

Eine weitere Anpassung der Einstellparameter kann beispielsweise wiederum durch Verwendung der im EDGE Device 200 gespeicherten trainierten mod-SOM 220 erfolgen. Dabei kann beispielsweise auf vergleichbare Weise vorgegangen werden, wie vorstehend zur Ermittlung der weiteren Einstellparameter erläutert. Auch auf dies wird im Zusammenhang mit den Erläuterungen zu Figur 3 näher eingegangen.

Weiterhin kann vorgesehen sein, dass in regelmäßigen Zeitabständen die Lotpasten-Depots, insbesondere das ausgewählte Lotpasten-Depot, vom Lotpasten-Inspektionssystem 120 überprüft werden, und sobald das ausgewählte Lotpasten-Depot-Volumen nicht mehr im gewünschten Größenbereich liegt, ein Nachtraining des mod-SOM 320 initiiert werden.

Zu einem solchen Nach-Training wird die in der Cloud 300 gespeicherte mod-SOM 320 gemäß den vorstehenden Erläuterungen zum Training einer mod-SOM 220, 320 mit den im Produktionszeitraum ermittelten Einstellparametern und Messparametern sowie den ursprünglich bereits verwendeten Einstellparametern und Messparametern weitertrainiert. Dann werden wiederum entsprechende Test-Platinen bedruckt und Volumina für das ausgewählte Lotpasten-Depot gemessen, so lange bis das ausgewählten Lotpasten-Depots Volumen wieder im gewünschten Größenordnungsbereich liegt. Dann erfolgt wiederum eine Übertragung der trainierten mod-SOM 320 aus der Cloud 300 in die mod-SOM 220 im EDGE Device 200, und dann Wiederaufnahme der Produktion von Leiterplatten mit dem Lotpastendrucker 110 gemäß der vorstehenden Beschreibung.

Nach Ermittlung eines Einstellparametersatzes, welcher ein Lotpasten-Depot-Volumen im gewünschten Größenordnungsbereich erzeugt, kann alternativ auch vorgesehen sein, dass nicht sofort eine Produktion unter Verwendung der gefundenen Einstellparameter aufgenommen wird, sondern trotzdem weitere Einstellparameter-Testwerte ermittelt werden. Dann kann weiterhin ein Trainieren der mod-SOM 320 in der Cloud erfolgen. Dies kann so lange ablaufen, bis beispielsweise verbesserte Einstellparameter, beispielsweise mit verbesserten Rakelgeschwindigkeiten und daher möglichst kleinen Produktionszeiten, ermittelt wurden. Erst dann würde in diesem Fall eine Übertragung der mod-SOM 320 aus der Cloud 300 in die mod-SOM 220 im EDGE Device 200 erfolgen, und dann die Produktion wieder aufgenommen werden.

Regelmäßig tritt allerdings der Fall auf, in welchem im Lotpastendrucker 110 an verschiedenen Stellen beim Drucken unterschiedliche Verhältnisse herrschen, und daher Volumina von Lotpasten-Depots in verschiedenen Bereichen einer Leiterplatte verschieden sind. In diesem Fall können in einer Fortentwicklung des vorstehend beschriebenen Verfahrens mehrere Lotpasten-Depots an verschiedenen Stellen einer Leiterplatte, sowie deren nach dem Druckvorgang gemessene Lotpasten-Volumina, zur Ermittlung der Einstellparameter für den Lotpastendrucker 110 herangezogen werden.

In diesem Fall werden anstatt einen einzelnen Volumenwert und einem entsprechenden gewünschten Größenbereich für das entsprechende Lotpasten-Depot mehrere verschiedene Lotpasten-Depots und entsprechende Volumina nach jedem Druckvorgang ermittelt. Anstatt eine einzelne mod-SOM 320 in der Cloud 300 zu verwenden, die mit den entsprechenden Werten gemäß der vorstehenden Beschreibung trainiert wird, wird für jedes Lotpasten-Depot bzw. den dafür gemessenen Volumenwert ein gesondertes mod-SOM 320 erzeugt und entsprechend der vorstehenden Beschreibung trainiert.

Zum Ermitteln weiterer Einstellparameter gemäß der vorliegenden Beschreibung wird dann jedes der mod-SOMs 320 derart ausgewertet, dass Einstellparameter ermittelt werden, für welche das jeweilige Volumen des jeweiligen Lotpasten-Depots in dem dafür vorgegebenen Größenbereich liegt. Die zu den verschiedenen mod-SOMs 320 dann gefundenen Einstellparameter werden dann nachfolgend derart abgeglichen, dass Einstellparameter gesucht werden, bei welchen sich für alle - oder möglichst viele - der Lotpasten-Depots zulässige Volumenwerte ergeben. Dieser Parametersatz ist dann derjenige, der für eine nächste Testmessung herangezogen wird - oder auch für eine Produktion entsprechender Leiterplatten, sollte er bereits für alle Lotpasten-Depots gültige Volumenwerte ergeben.

In einer zweiten vorteilhaften Ausgestaltung ist in Figur 1 eine Ausgestaltung eines Produktionssystems gemäß der vorliegenden Beschreibung als ein lokales Produktionssystem 102 dargestellt. Das lokale Produktionssystem 102 ist durch eine strichpunktierte Linie in Figur 1 begrenzt.

Das lokale Produktionssystem 102 unterscheidet sich vom dezentralen Produktionssystem 100 dadurch, dass sowohl das Training des als mod-SOM 220 ausgebildeten ML-Modells 220, als auch dessen spätere Nutzung, zum Ermitteln weiterer verbesserter Einstellparameter unter Verwendung der mod-SOM 220 im EDGE Device 200 erfolgt. Damit erfolgt beim Training eine Übertragung der Trainingsdaten vom Lotpastendrucker 110 bzw. Lotpasten-Inspektionssystem 120 nicht über das Datennetzwerk 305 in die Cloud 300 sondern unmittelbar an das EDGE Device 200.

Alle weiteren Schritte im Rahmen des Einrichtens des Lotpastendruckers 110, des Trainierens der mod-SOM 220, sowie der Ermittlung entsprechender Einstellparameter, entspricht der Vorgehensweise, wie sie vorstehend im Rahmen der Beschreibung des dezentralen Produktionssystems 100 beschrieben wurde.

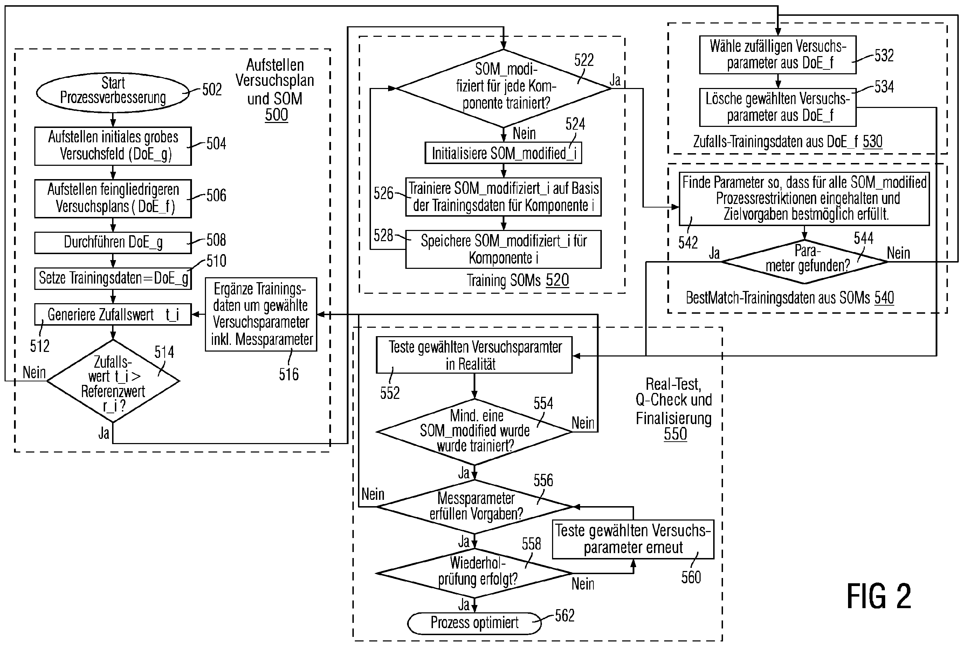

Figur 2 zeigt einen Prozess-Ablaufplan zum Einrichten eines Lotpastendruckers 110, wie er in Figur 1 dargestellt wurde.

Aus Gründen der Übersichtlichkeit wurde der Prozessablauf in mehrere logische Blöcke 500, 520, 530, 540, 550 unterteilt. Die Unterteilung in diese logischen Blöcke 500, 520, 530, 540, 550 hat keinerlei praktische Auswirkungen für den Verfahrensablauf. Es kann allerdings vorgesehen sein, dass im Rahmen der Realisierung des vorgestellten Verfahrens als Computerimplementierter Verfahrensablauf einzelne, mehrere oder alle Verfahrensschritte eines derartigen Blocks 500, 520, 530, 540, 550 als eine entsprechende Subroutine, eine gesonderte Applikation oder ein entsprechendes Teilprogramm realisiert sind.

Im Rahmen des vorgestellten Verfahrensablaufs werden zum Einrichten des Lotpastendruckers 110 die Lotpasten-Volumina an mehreren Lotpasten-Depot-Teststellen (Nummerierung der Teststellen = i) auf einer Test-Leiterplatte betrachtet und jeweils für jedes der Lotpasten-Depots eine separate mod-SOM 220, 320 (SOM_modified_i in Fig. 2 = mod-SOM für Lotpasten-Depot i) angelegt und verarbeitet.

Im ersten Teilblock 500 "Aufstellen Versuchsplan und SOM" wird nach einem Start des Verfahrens 502 in einem ersten Verfahrensschritt 504 ein initiales grobes Versuchsfeld DOE_g erstellt. Darin werden für die Einstellparameter des Lotpastendruckers, welche im Rahmen des Einrichtens optimiert werden sollen, grobe Testwerte festgelegt. In einem zweiten Verfahrensschritt 506 wird dann ein entsprechender feingliedriger Versuchsplan DOE_f erstellt, in welchem der durch die festgelegten groben Einstellwerte vorgegebene Bereich für die entsprechenden Einstellparameter feiner untergliedert wird.

In einem weiteren Verfahrensschritt 508 wird dann die Abarbeitung des groben Versuchsplans DOE_g gestartet, indem die Trainingsdaten des groben Versuchsplans DOE_g jeweils als Einstellparameter für den Lotpastendrucker 110 verwendet werden und dann eine entsprechende Test-Leiterplatte unter Verwendung dieser Prozessparameter gedruckt wird. Durch das Lotpasten-Inspektionssystem werden dann die Lotpasten-Volumina der Lotpasten-Depots an den Lotpasten-Depot-Teststellen auf der hergestellten Test-Leiterplatte ermittelt und gespeichert.

Nach Abarbeiten des groben Versuchsplans DOE_g werden dann in einem weiteren Verfahrensschritt 510 entsprechende Trainingsdaten erzeugt. Dazu werden die jeweiligen Einstellparametersätze und die zugehörigen Messparametersätze für jeden Datenpunkt im DOE_g zu einem entsprechenden Trainingsdaten-Vektor zusammengefasst.

Es wird dann ein Zufallswert t_i in einem nächsten Schritt 512 generiert. Liegt dieser Zufallswert t_i über einem Referenzwert r_i erfolgt ein Training der mod-SOM 220, 320 im Verfahrensblock 520. Liegt dieser Zufallswert t_i unter dem Referenzwert r_i erfolgt eine Auswahl von Zufalls-Trainingsdaten aus dem in Verfahrensschritt 506 erstellten feingliedrigen Versuchsplan DOE_f im Verfahrensblock 530, um den Detailgrad der Trainingsdaten zu erhöhen. Diese Entscheidung wird in einem Entscheidungs-Schritt 514 in Figur 2 dargestellt.

Zu Beginn des Verfahrensablaufs wird der Referenzwert r_i beispielsweise relativ hoch gewählt, so dass relativ selten ein Training der mod-SOM 220, 320 im Verfahrensblock 520 erfolgt. Dabei wird in einem ersten Schritt 522 geprüft, ob jede der angelegten mod-SOMs 220, 320 bereits trainiert wurde. Ist das nicht der Fall, werden die einzelnen mod-SOMs 220, 320 nacheinander in einer entsprechenden Verfahrens-Schleife innerhalb des Verfahrensblocks 520 trainiert. Dafür wird als erstes die nächste mod-SOM 220, 320 in einem Schritt 524 ausgewählt und mit Zufallswerten initialisiert. In einem weiteren Verfahrensschritt 526 wird diese mod-SOM 220, 320 dann gemäß der vorliegenden Beschreibung unter Verwendung der zugeordneten Trainingsdaten, bestehend aus den entsprechenden Einstellparametersätzen und der verwendeten mod-SOM 220, 320 zugeordneten Lotpasten-Depot-Volumenwert, trainiert, und dann in einem weiteren Verfahrensschritt 528 gespeichert.

Dann wird dieser Ablauf so lange fortgeführt, bis jede der mod-SOMs 220, 320 trainiert wurde.

Ist das Training der mod-SOMs 220, 320 abgeschlossen, wird das Verfahren mit dem Verfahrensblock 540 weitergeführt, indem in einem nächsten Verfahrensschritt 542 aus den trainierten mod-SOMs versucht wird, Einstellparameter abzuleiten, welche für alle betrachteten Lotpasten-Depots Volumenwerte ergeben, welche im jeweils gültigen Größenbereich liegen. Eine solche Auswahl ist im Zusammenhang mit den Erläuterungen zu Figur 3 beispielhaft näher erläutert.

In einem nächsten Verfahrensschritt 544 wird überprüft, ob dies gelungen ist.

Ist dies nicht gelungen, so wird aus dem feingliedrigen Versuchsplan DOE_F in einem Verfahrensschritt 532 ein weiterer Versuchsparametersatz gewählt, und dieser dann in einem Verfahrensschritt 534 aus diesem feingliedrigen Versuchsplan DOE_F gelöscht, um ihn im Rahmen des ausgeführten Verfahrens nicht doppelt zu bearbeiten.

Für diesen ausgewählten zufälligen Versuchsparametersatz wird nun im Verfahrensblock "Real-Test" 550 unter Verwendung der entsprechenden Einstellparameter wiederum vermittels des Lotpastendruckers 110 eine Versuchsplatine gedruckt und dann über das Lotpasten-Inspektionssystem 120 die entsprechenden Lotpasten-Volumina ermittelt.

Dann wird in einem nächsten Schritt 554 geprüft, ob mindestens eine mod-SOM trainiert wurde. Ist dies nicht der Fall, werden die nun ermittelten Parameter - die verwendeten Einstellparameter sowie die gemessenen Lotpasten-Volumina - in einem Verfahrensschritt 516 zu einem neuen Trainingsdatensatzes zusammengeführt, und das Verfahren wieder mit dem Verfahrensschritt 512 fortgeführt. Dies führt dazu, dass die mod-SOMs mit dem nun erweiterten Trainingsdatensatzes wieder neu trainiert werden.

Wurde beim Entscheidungsschritt 554 gefunden, dass mindestens eine mod-SOM trainiert wurde, wird im nächsten Verfahrensschritt 556 überprüft, ob alle ermittelten Lotpastenvolumina im geforderten Größenbereich liegen. Ist dies nicht der Fall, werden wiederum die neuen ermittelten Trainingsdaten im Verfahrensschritt 516 dem Trainingsdatensatzes hinzugefügt und das Verfahren wieder bei Verfahrensschritt 512 weitergeführt.

Erfüllen sämtliche der Messparameter die Vorgaben, wird nochmals eine Wiederholungsprüfung des jetzt gewählten Einstellparametersatzes unter Verwendung des Lotpastendruckers 110 und des Lotpasten-Inspektionssystems 120 durchgeführt. Dies geschieht in einem Entscheidungsschritt 558 und einem entsprechenden Testschritt 560. Ist die Wiederholungsprüfung erfolgt und bestätigt, dass sämtliche Messparameter die Vorgaben erfüllen, wird der Prozess in einem Verfahrensschritt 562 abgeschlossen und die gefundenen Einstellparameter werden als Einstellparameter für den Lotpastendrucker 110 für eine Leiterplattenproduktion verwendet.

Ergibt sich im Entscheidungsschritt 544, dass bereits nach dem Training der mod-SOM 220, 320 ein Einstellparametersatz ergeben hat, für welchen sämtliche der Messparameter die Vorgaben erfüllen, wird unmittelbar dieser Messparametersatz wiederum im Verfahrensschritt 522 in der Realität getestet und der weitere Verfahrensablauf erfolgt wie vorstehend beschrieben, gegebenenfalls bis zur erfolgreichen Beendigung des Einstellprozesses im Verfahrensschritt 562, oder einer Fortführung des Trainings mit den verwendeten Einstellparametern und ermittelten Messparametern im Verfahrensschritt 516.

Ergibt sich im Entscheidungsschritt 514, dass der generierte Zufallswert t_i unter dem Referenzwert r_i liegt, wird unmittelbar ein neuer zufälliger Versuchsparametersatz aus dem feingliedrigen Versuchsplan DOE_F ausgewählt und das Verfahren wie vorstehend beschrieben mit Verfahrensschritt 532 fortgeführt.

Im Laufe des Verfahrens kann vorgesehen sein, dass der Referenzwert r_i im Laufe des Verfahrensablauf erniedrigt wird, sodass immer seltener der feingliedrige Versuchsplan DOE_F abgearbeitet wird und so häufiger die Interpolationen der mod-SOMs verwendet werden.

Figur 3 zeigt anhand eines Diagramms 600 ein Beispiel für eine Ermittlung eines weiteren Einstellparametersatzes gemäß der vorliegenden Beschreibung unter Verwendung einer mod-SOM 220, 320 gemäß der vorliegenden Beschreibung.

Aus Einfachheitsgründen wird nur ein einziger Einstellparameter, nämlich eine Rakelgeschwindigkeit des Lotpastendruckers 110 verwendet, welche auf einer x-Achse 620 des in Figur 3 dargestellten Diagramms 600 aufgetragen ist. Als einziger Messparameter wird ein Lotvolumen eines Lotpasten-Depots einer Testleiterplatte herangezogen, welches auf einer Y-Achse 610 des in Figur 3 dargestellten Diagramms 600 aufgetragen ist. Entlang der x-Achse 620 sind Werte X₁ bis X₆ aufgetragen, welche Rakelgeschwindigkeiten darstellen, für welche durch den Lotpastendrucker 110 ein entsprechendes Lotvolumen Y, bis Y₆ ermittelt wurde. Diese Werte sind entlang der Y-Achse 610 aufgetragen. Würde der gesamte Versuchsraum zwischen der Technischen Untergrenze 622 und Technischen Obergrenze 624 in infinitesimalen Versuchspunkten untersucht, würde dies die die obere der in Figur 3 dargestellten Kurven ergeben. Diese Kurve ist jedoch a priori nicht bekannt.

Die Wertepaare (Z₁, C₁) bis (Z₁₀, C₁₀) entsprechen den Werten der verschiedenen Vektoren der verwendeten mod-SOM 220,320.

Dabei wurde die mod-SOM 220, 320 derart initialisiert, dass für die X-Werte, also die Rakelgeschwindigkeit 620, Zufallswerte bestimmt wurden, die in einem zulässigen Größenbereich liegt, der sich zwischen einer technischen Untergrenze, welche im Diagramm 600 in Figur 3 in einem linken gepunkteten Bereich 622 symbolisiert ist, und einer technischen Obergrenze, welche im Diagramm 600 in Figur 3 in einem rechten gepunkteten Bereich 624 symbolisiert ist, befindet.

Zum Training der mod-SOM wurde jeweils einer der Trainingsdatensätze (x_{1,} Y₁) bis (X₆, Ye) ausgewählt, und gemäß der vorliegenden Beschreibung unter Verwendung des jeweiligen Rakelgeschwindigkeits-Werts eine Best Matching Unit Z_{J}, C_{J} der mod-SOMs 220, 320 ermittelt. Danach wurde dann eine Anpassung der mod-SOM Wertepaare (Z₁, C₁) bis (Z₁₀, C₁₀) abhängig vom Abstand zur Best Matching Unit (nicht in Figur 3 dargestellt) angepasst, wie dies im Rahmen der vorstehenden Beschreibung bereits erläutert wurde.

Nach Abschluss des Trainingsprozesses unter Verwendung sämtlicher Trainingsdaten ergibt sich dann das in Figur 3 dargestellte Diagramm 600, wobei die Daten der mod-SOMs 220, 320 durch die untere Linie symbolisiert ist.

Weiterhin ist in Figur 3 ein Zielbereich 612 für das Lotvolumen des betrachteten Lotpasten-Depots angegeben. Dieser ist als horizontaler Balken 612 im Diagramm 600 in Figur 3 eingezeichnet.

Es wird nun anhand der Werte (Z₁, C₁) bis (Z₁₀, C₁₀) der mod-SOMs 220, 320 sowie einer (z.B. linearen) Interpolation zwischen diesen Punkten eine oder mehrere Rakelgeschwindigkeiten ermittelt, wobei für mögliche Rakelgeschwindigkeiten diejenigen Bereiche der Rakelgeschwindigkeit 620 infrage kommen, in welchen die im Diagramm 600 in Figur 3 dargestellte untere Linie innerhalb des Balkens 612 liegt, welcher den Zielbereich für das gewünschte Lotpastenvolumen darstellt.

Dabei kann beispielsweise eine Vorgabe für eine Auswahl einer Rakelgeschwindigkeit sein, dass eine möglichst hohe Rakelgeschwindigkeit gewünscht wird, um eine möglichst geringe Verarbeitungszeit bzw. Druck-Zeit zum Bedrucken der Leiterplatte zu bekommen. Dabei ist die Rakelgeschwindigkeit ein Beispiel für einen Optimierungsparameter im Rahmen der vorliegenden Beschreibung, während eine möglichst hohe Rakelgeschwindigkeit ein Beispiel für ein Optimierungsziel im Rahmen der vorliegenden Beschreibung ist.

Im vorliegenden Fall kann dann beispielsweise ein neuer Einstellparametersatz gewählt werden, welche eine Rakelgeschwindigkeit umfasst, welcher im Bereich des Wertes Z7 im in Figur 3 dargestellten Diagramm 600 liegt.

Ein weiteres Kriterium für eine Auswahl eines nächsten Einstellparametersatzes bzw. eine entsprechende Rakelgeschwindigkeit, kann sein, dass im Umfeld der gewählten neuen Rakelgeschwindigkeit die Lotvolumina möglichst lange im Zielbereich 612 für das Lotvolumen liegen. Dies könnte beispielsweise ein Lotvolumen im Bereich von Z5 im in Figur 3 dargestellten Diagramm 600 sein. Ein solches Kriterium führt zu einem möglichst stabilen Prozesswert, da bei geringeren Schwankungen der Rakelgeschwindigkeit das Lotpasten-Volumen immer noch im Zielbereich 612 liegt.

Weiterhin kann auch vorgesehen sein, dass mehrere mögliche Rakelgeschwindigkeiten ausgewählt werden und für sämtliche der ausgewählten Werte jeweils wieder Testmessungen durchgeführt werden und mit diesen Testmessungen die mod-SOM 220,320 weiter trainiert wird.

## Patentansprüche

1. Verfahren zum Einrichten einer Produktionseinrichtung (110, 120), wobei ein Einstellparametersatz (620) für die Herstellung eines Produkts durch die Produktionseinrichtung (110, 120) und ein Messparametersatz (610) bezüglich des durch die Produktionseinrichtung (110, 120) unter Verwendung des Einstellparametersatzes (620) hergestellten Produkts und/oder bezüglich der Herstellung dieses Produkts vorliegt,
**dadurch gekennzeichnet,**
**dass** das Verfahren die nachfolgenden Prozessschritte umfasst:
a.) Trainieren eines ML-Modells (220, 320) unter Verwendung von Trainingsdaten umfassend den Einstellparametersatz (620) und/oder den Messparametersatz (610),
b.) Automatisiertes oder teilautomatisiertes Ermitteln eines weiteren Einstellparametersatzes (620) für die Produktionseinrichtung (110, 120) unter Verwendung des ML-Modells (220, 320).

2. Verfahren gemäß Anspruch 1,
**dadurch gekennzeichnet,**
**dass** das Verfahren im Anschluss an die Verfahrensschritte a.) und b.) die nachfolgenden Verfahrensschritte umfasst:
c.) Herstellen eines weiteren Produkts mit der Produktionseinrichtung (110, 120) unter Verwendung des weiteren Einstellparametersatzes (620) und Erfassen eines weiteren Messparametersatzes (610) bezüglich des weiteren Produkts,
d.) im Falle, dass der weitere Messparametersatz (610) ein vorgegebenes oder vorgebbares Qualitätskriterium (612) nicht erfüllt: Hinzufügen des weiteren Einstellparametersatzes (620) und/oder des weiteren Messparametersatzes (610) zu den Trainingsdaten und Weiterführen des Verfahrens mit
Verfahrensschritt a.).

3. Verfahren gemäß Anspruch 1 oder 2,
**dadurch gekennzeichnet,**
**dass** jedem Einstellparametersatz (620) ein Optimierungsparameter (620) zugeordnet oder zuordenbar ist, und
**dass** das automatisierte oder teilautomatisierte Ermitteln des weiteren Einstellparametersatzes (620) derart ausgebildet und eingerichtet ist, dass bei mehreren geeigneten Einstellparametersätzen (620) derjenige als der weitere Einstellparametersatz (620) ausgewählt wird, bei welchem der zugeordnete Optimierungsparameter (620) einem vorgegebenen oder vorgebbaren Optimierungsziel am nächsten kommt.

4. Verfahren gemäß Anspruch 3,
**dadurch gekennzeichnet,**
**dass** der Optimierungsparameter (620) einen der Herstellung des Produkts zugeordnete Produktionszeitparameter (620) umfasst, und das Optimierungsziel eine vorgegebene oder vorgebbare Produktionszeit ist oder dieses Kriterium umfasst, insbesondere eine möglichst geringe Produktionszeit ist oder dieses Kriterium umfasst,
und/oder,
**dass** der Optimierungsparameter (620) einen der Herstellung des Produkts zugeordnete Energieverbrauchsparameter umfasst, und das Optimierungsziel ein vorgegebener oder vorgebbarer Energieverbrauch ist oder dieses Kriterium umfasst, insbesondere ein möglichst geringer Energieverbrauch ist oder dieses Kriterium umfasst.

5. Verfahren gemäß einem der vorstehenden Ansprüche,
**dadurch gekennzeichnet,**
**dass** dem Produkt ein zweiter Messparametersatz (610) zugeordnet ist,
**dass** in Verfahrensschritt a.) weiterhin ein zweites ML-Modell (220, 320) unter Verwendung von zweiten Trainingsdaten, umfassend den Einstellparametersatz (620) und/oder den zweiten Messparametersatz (610), trainiert wird,
**dass** in Verfahrensschritt b.) der weitere Einstellparametersatz (620) unter Verwendung des ML-Modells (220, 320) und des zweiten ML-Modells (220, 320) ermittelt wird,
**dass** in Verfahrensschritt c.) ein weiterer zweiten Messparametersatz (610) bezüglich des weiteren Produkts ermittelt wird, und
**dass** in Verfahrensschritt d.) das Verfahren dann mit Verfahrensschritt a.) weitergeführt wird, wenn der weitere Messparametersatz (610) das Qualitätskriterium (612) nicht erfüllt oder der weitere zweite Messparametersatz (610) das zweite Qualitätskriterium (612) nicht erfüllt.

6. Verfahren gemäß einem der vorstehenden Ansprüche,
**dadurch gekennzeichnet,**
**dass** ein Auswahlschritt vorgesehen ist oder erfolgt, ob anstatt Verfahrensschritt b.) der nachfolgend genannte Verfahrensschritt b1.) ausgeführt werden soll:
b1.) Randomisierte oder Teil-Randomisierte Auswahl eines weiteren Einstellparametersatzes (620).

7. Verfahren gemäß einem der Ansprüche 2 bis 6,
**dadurch gekennzeichnet,**
**dass**, insbesondere wenn der neue Messparametersatz (610) das Qualitätskriterium erfüllt, nach Verfahrensschritt d.) ein weiterer Auswahlschritt erfolgt, ob nach dem Auswahlschritt:
Verfahrensschritt e1.): eine Herstellung eines Produkts unter Verwendung des weiteren Einstellparametersatzes (620),
und/oder
Verfahrensschritt e2.): ein Hinzufügen des weiteren Einstellparametersatzes (620) und/oder des weiteren Messparametersatzes (610) zu den Trainingsdaten und Weiterführen des Verfahrens mit
Verfahrensschritt a.),
erfolgt.

8. Verfahren gemäß einem der vorstehenden Ansprüche,
**dadurch gekennzeichnet,**
**dass** das ML-Modell (220, 320) und/oder das zweite ML-Modell (220, 320) jeweils als eine "Self-Organizing Map" (SOM) (220, 320) oder eine "modifizierte Self-Organizing Map" (mod-SOM) (220, 320) ausgebildet und eingerichtet ist.

9. Verfahren gemäß Anspruch 8,
**dadurch gekennzeichnet,**
**dass** im Rahmen des Trainings in Verfahrensschritt a.) eine Auswahl einer "Best Matching Unit" des ML-Modells (220, 320) und/oder einer zweiten "Best Matching Unit" des zweiten ML-Modells (220, 320) erfolgt und bei dieser Auswahl (nur) der Einstellparametersatz (620) und/oder der weitere Einstellparametersatz (620) Anwendung findet.

10. Verfahren gemäß Anspruch 8 oder 9,
**dadurch gekennzeichnet,**
**dass** im Rahmen des Trainings in Verfahrensschritt a.) eine Anpassung von Parameterwerten des ML-Modells und/oder einer zweiten Parameterwerten des zweiten ML-Modells erfolgt, und bei dieser Anpassung (nur) der Messparametersatz (610), der weitere Messparametersatz (610), der zweite Messparametersatz (610) und/oder der weitere zweite Messparametersatz (610) Anwendung findet.

11. Produktionssystem (100, 102), umfassend
- eine Produktionseinrichtung (110, 120) gemäß einem der vorstehend genannten Ansprüche zur Herstellung eines Produkts,
- eine Recheneinrichtung (200, 300),
- sowie eine Trainings-Applikation,
**dadurch gekennzeichnet,**
**dass** das Produktionssystem (100, 102) zur Durchführung eines Verfahrens gemäß einem der vorstehend genannten Ansprüche ausgebildet und eingerichtet ist,
und **dass** die Trainings-Applikation zum Trainieren des ML-Modells (220, 320) gemäß einem der vorstehend genannten Ansprüche,
und die Recheneinrichtung (200, 300) zum automatisierten und/oder teilautomatisierten Ermitteln eines Einstellparametersatzes (620) gemäß einem der vorstehend genannten Ansprüche unter Verwendung des trainierten ML-Modells (220, 320),
ausgebildet und eingerichtet ist.

12. Computerprogrammprodukt, umfassend Befehle, die bei der Ausführung des Programms durch einen Computer diesen veranlassen, ein Verfahren gemäß einem der Ansprüche 1 bis 10 auszuführen.

13. Computerprogrammprodukt, umfassend Befehle, die bei der Ausführung des Programms durch einen Computer diesen veranlassen, ein Verfahren gemäß den Merkmalen a.) und b.) gemäß einem der Ansprüche 1 bis 10 auszuführen,
und/oder ein Verfahren gemäß den Merkmalen a.), b.) und d.) gemäß einem der Ansprüche 2 bis 10 auszuführen.

14. Computerprogrammprodukt, umfassend Befehle, die bei der Ausführung des Programms durch einen Computer diesen veranlassen, ein Verfahren gemäß Merkmal a.) gemäß einem der Ansprüche 1 bis 10 auszuführen,
und/oder ein Verfahren gemäß den Merkmalen a.) und d.) gemäß einem der Ansprüche 2 bis 10 auszuführen.
